# EUROPEAN PATENT APPLICATION

(11) **EP 4 567 779 A1**
(43) Date of publication of application: **11.06.2025**
(21) Application number: 24217603.0
(22) Date of filing: 04.12.2024
(51) Int. Cl.: G09G 3/3233

(54) **DISPLAY APPARATUS**

(30) Priority: 05.12.2023 KR 20230174836; 29.04.2024 KR 20240056768
(71) Applicant: Samsung Display Co., Ltd., Yongin-si, Gyeonggi-do 17113 (KR)
(72) Inventor: Byun, Minwoo, 17113 Yongin-si (KR); Kang, Chulkyu, 17113 Yongin-si (KR); Kim, Minjoo, 17113 Yongin-si (KR); Kim, Sujin, 17113 Yongin-si (KR); Eom, Kimyeong, 17113 Yongin-si (KR); Jeon, Donghwan, 17113 Yongin-si (KR); Jeong, Seoni, 17113 Yongin-si (KR)
(74) Representative: Taor, Simon Edward William

(57) **Abstract**

A display apparatus includes a pixel unit, a data driving unit, a data distribution unit including a first switch, a second switch, a third switch, and a fourth switch, where the first switch connects a first data output line to a first data line according to a first control signal, the second switch connects the first data output line to a second data line according to a second control signal, the third switch connects a second data output line to a third data line according to a third control signal, and the fourth switch connects the second data output line to a fourth data line according to a fourth control signal, and a control circuit, where the first control signal has a same phase as a phase of the third control signal, and the second control signal has a same phase as a phase of the fourth control signal.

## Description

This application claims priority to Korean Patent Application No. 10-2023-0174836, filed on December 5, 2023, and Korean Patent Application No. 10-2024-0056768, filed on April 29, 2024, and all the benefits accruing therefrom.

### BACKGROUND

### 1. Field

Embodiments relate to display apparatuses.

### 2. Description of the Related Art

In display apparatuses, a plurality of gate lines, a plurality of data lines, and a plurality of pixels positioned at intersections of the gate lines and the data lines are provided.

### SUMMARY

In order to apply a data signal to each of the plurality of data lines, a data driver is desired to be provided with a number of data output lines corresponding to the number of data lines, and as a plurality of integrated circuits is desired, there is a drawback in that the manufacturing costs increase.

Embodiments include a display apparatus with a reduced number of data output lines in a data driving unit. Embodiments include a display apparatus with an improved slew rate of control signals. However, these objectives are only examples, and the scope of embodiments is not limited thereby.

Additional features will be set forth in part in the description which follows and, in part, will be apparent from the description, or may be learned by practice of the presented embodiments of the disclosure.

According to an aspect, there is provided a display apparatus includes a pixel unit including a first data line, a second data line, a third data line, and a fourth data line, a data driving unit which outputs a data signal through data output lines, a data distribution unit including a first switch, a second switch, a third switch, and a fourth switch, wherein the first switch connects a first data output line from among the data output lines to the first data line according to a first control signal, the second switch connects the first data output line to the second data line according to a second control signal, the third switch connects a second data output line from among the data output lines to the third data line according to a third control signal, and the fourth switch connects the second data output line to the fourth data line according to a fourth control signal, and a control circuit including a first power circuit which outputs the first control signal, a second power circuit which outputs the second control signal, a third power circuit which outputs the third control signal, and a fourth power circuit which outputs the fourth control signal, where the first control signal has a same phase as a phase of the third control signal, and the second control signal has a same phase as a phase of the fourth control signal.

In an embodiment, the second data line and the first data line may be spaced apart from each other with two columns interposed therebetween, and the fourth data line and the third data line may be spaced apart from each other with two columns interposed therebetween.

In an embodiment, the display apparatus may further include a first control signal line connecting the first switch and the first power circuit to each other, a second control signal line connecting the second switch and the second power circuit to each other, a third control signal line connecting the third switch to the third power circuit, and a fourth control signal line connecting the fourth switch and the fourth power circuit to each other.

In an embodiment, the display apparatus may further include a first power output line connecting the first power circuit and the first control signal line to each other, a second power output line connecting the second power circuit and the second control signal line to each other, a third power output line connecting the third power circuit and the third control signal line to each other, and a fourth power output line connecting the fourth power circuit and the fourth control signal line to each other.

In an embodiment, the display apparatus may further include a first bridge line connecting the first power circuit and the first control signal line to each other, a second bridge line connecting the second power circuit and the second control signal line to each other, a third bridge line connecting the third power circuit and the third control signal line to each other, and a fourth bridge line connecting the fourth power circuit and the fourth control signal line to each other.

In an embodiment, the display apparatus may further include a first power output line connecting the first power circuit and the first bridge line to each other, a second power output line connecting the second power circuit and the second bridge line to each other, a third power output line connecting the third power circuit and the third bridge line to each other, and a fourth power output line connecting the fourth power circuit and the fourth bridge line to each other.

In an embodiment, the display apparatus may further include first bridge connection lines connecting the first bridge line and the first control signal line to each other, second bridge connection lines connecting the second bridge line and the second control signal line to each other, third bridge connection lines connecting the third bridge line and the third control signal line to each other, fourth bridge connection lines connecting the fourth bridge line and the fourth control signal line to each other.

In an embodiment, the number of each of the first to fourth bridge connection lines may be greater than the number of each of the first to fourth power output lines.

In an embodiment, each of the first to fourth control signal lines and the first to fourth bridge lines may extend in a first direction, and each of the first to fourth bridge connection lines may extend in a second direction crossing the first direction.

In an embodiment, the pixel unit may further include a first pixel, a second pixel, a third pixel, and a fourth pixel, which are arranged in a same row, the first data line may be connected to one of sub-pixels of the first pixel and the second data line may be connected to one of sub-pixels of the second pixel, and the third data line may be connected to one of sub-pixels of the third pixel and the fourth data line may be connected to one of sub-pixels of the fourth pixel.

In an embodiment, the one of the sub-pixels of the first pixel, connected to the first data line, and the one of the sub-pixels of the second pixel, connected to the second data line, may emit light of a same color, and the one of the sub-pixels of the third pixel, connected to the third data line, and the one of the sub-pixels of the fourth pixel, connected to the fourth data line, may emit light of a same color.

In an embodiment, the pixel unit may further include a fifth data line between the first data line and the second data line, a sixth data line between the second data line and the third data line, a seventh data line between the third data line and the fourth data line, and an eighth data line, and the data distribution unit may further include a fifth switch, a sixth switch, a seventh switch, and an eighth switch, where the fifth switch connects a third data output line from among the data output lines to the fifth data line according to the first control signal, the sixth switch connects the third data output line to the sixth data line according to the second control signal, the seventh switch connects a fourth data output line from among the data output lines to the seventh data line according to the third control signal, and the eighth switch connects the fourth data output line to the eighth data line according to the fourth control signal.

In an embodiment, the first switch and the fifth switch may be connected to the first power circuit through a first control signal line, the second switch and the sixth switch may be connected to the second power circuit through a second control signal line, the third switch and the seventh switch may be connected to the third power circuit through a third control signal line, and the fourth switch and the eighth switch may be connected to the fourth power circuit through a fourth control signal line.

According to an aspect, there is provided a display apparatus includes a first data line, a second data line, a third data line, and a fourth data line, which are respectively connected to sub-pixels, data output lines connected to a data driving unit which outputs a data signal, a first switch transistor, a second switch transistor, a third switch transistor, and a fourth switch transistor, which are respectively connected to the first to fourth data lines, and a first control signal line, a second control signal line, a third control signal line, and a fourth control signal line, which are, in a plan view, disposed between the data output lines and the first to fourth switch transistors and extend in a first direction, where each of the first to fourth switch transistors includes a semiconductor layer, a first gate line and a second gate line, which are disposed on the semiconductor layer and extend in a second direction crossing the first direction, a first electrode and a second electrode, which are disposed on the first gate line and the second gate line, extend in the second direction, and are respectively connected to opposite ends of the semiconductor layer, and a third electrode disposed between the first electrode and the second electrode.

In an embodiment, the first electrode and the second electrode of each of the first and second switch transistors may be connected to a first data output line from among the data output lines, and the first electrode and the second electrode of each of the third and fourth switch transistors may be connected to a second data output line from among the data output lines.

In an embodiment, the third electrode of the first switch transistor may be connected to the first data line, the third electrode of the second switch transistor may be connected to the second data line, the third electrode of the third switch transistor may be connected to the third data line, and the third electrode of the fourth switch transistor may be connected to the fourth data line.

In an embodiment, the first and second gate lines of the first switch transistor may be connected to the first control signal line, the first and second gate lines of the second switch transistor may be connected to the second control signal line, the first and second gate lines of the third switch transistor may be connected to the third control signal line, and the first and second gate lines of the fourth switch transistor may be connected to a fourth control signal line.

In an embodiment, the display apparatus may further include a first bridge line, a second bridge line, a third bridge line, and a fourth bridge line, which extend in the first direction and are, in the plan view, disposed between the first to fourth control signal lines and a control circuit, and first bridge connection lines connecting the first bridge line and the first control signal line to each other, second bridge connection lines connecting the second bridge line and the second control signal line to each other, third bridge connection lines connecting the third bridge line and the third control signal line to each other, and fourth bridge connection line connecting the fourth bridge line to the fourth control signal lines, the first bridge connection lines, the second bridge connection lines, the third bridge connection lines, and the fourth bridge connection lines extending in the second direction.

In an embodiment, the first control signal line may transfer a first control signal to the first switch transistor, the second control signal line may transfer a second control signal to the second switch transistor, the third control signal line may transfer a third control signal to the third switch transistor, and the fourth control signal line may transfer a fourth control signal to the fourth switch transistor, the first control signal may have a same phase as a phase of the third control signal, and the second control signal may have a same phase as a phase of the fourth control signal.

In an embodiment, the semiconductor layer may include an oxide-based semiconductor material.

According to an aspect, there is provided a display apparatus includes a pixel unit including a first data line, a second data line, a third data line, and a fourth data line, a data driving unit which outputs a data signal through data output lines, a data distribution unit which connects a first data output line among the data output lines to the second data line and a second data output line to the fourth data line among the data output lines, the data distribution unit including a first switch which connects the first data output line to the first data line according to a first control signal, and a second switch which connects the second data output line to the third data line according to a second control signal, and a control circuit including a first power circuit which outputs the first control signal and a second power circuit which outputs the second control signal, where the first control signal has a same phase as a phase of the second control signal.

In an embodiment, the second data line and the first data line may be disposed apart from each other with two columns interposed therebetween, and the fourth data line and the third data line may be disposed apart from each other with two columns interposed therebetween.

In an embodiment, the display apparatus may further include a first control signal line connecting the first switch and the first power circuit to each other, and a second control signal line connecting the second switch and the second power circuit to each other.

In an embodiment, the display apparatus may further include a first power output line connecting the first power circuit and the first control signal line to each other, and a second power output line connecting the second power circuit and the second control signal line to each other.

In an embodiment, the display apparatus may further include a first bridge line connecting the first power circuit and the first control signal line to each other, and a second bridge line connecting the second power circuit and the second control signal line to each other.

In an embodiment, the display apparatus may further include a first power output line connecting the first power circuit and the first bridge line to each other, and a second power output line connecting the second power circuit and the second bridge line to each other.

In an embodiment, the display apparatus may further include first bridge connection lines connecting the first bridge line and the first control signal line to each other, and second bridge connection lines connecting the second bridge line and the second control signal line to each other.

In an embodiment, the number of the first bridge connection lines may be greater than the number of the first power output line, and the number of the second bridge connection lines may be greater than the number of the second power output line.

In an embodiment, the first control signal line, the second control signal line, the first bridge line, and the second bridge line may extend in a first direction, and the first bridge connection lines and the second bridge connection lines may extend in a second direction crossing the first direction.

In an embodiment, the pixel unit may further include a first pixel, a second pixel, a third pixel, and a fourth pixel, which are arranged in a same row, the first data line may be connected to one of sub-pixels of the first pixel and the second data line may be connected to one of sub-pixels of the second pixel, and the third data line may be connected to one of sub-pixels of the third pixel and the fourth data line may be connected to one of sub-pixels of the fourth pixel.

In an embodiment, the one of the sub-pixels of the first pixel, connected to the first data line, and the one of the sub-pixels of the second pixel, connected to the second data line, may emit light of a same color, and the one of the sub-pixels of the third pixel, connected to the third data line, and the one of the sub-pixels of the fourth pixel, connected to the fourth data line, may emit light of a same color.

According to an aspect, there is provided a display apparatus includes a first data line, a second data line, a third data line, and a fourth data line, which are respectively connected to sub-pixels, a first data output line connecting a data driving unit, and the first data line and the second data line, a second data output line connecting the data driving unit, and the third data line and the fourth data line, a first switch transistor connected between the first data line and the first data output line, a second switch transistor connected between the third data line and the second data output line, and a first control signal line and a second control signal line, which are, in a plan view, disposed between the first data output line and the first switch transistor, and between the second data output line and the second switch transistor, and extend in a first direction, where each of the first switch transistor and the second switch transistor includes a semiconductor layer, a first gate line and a second gate line, which are disposed on the semiconductor layer and extend in a second direction crossing the first direction, a first electrode and a second electrode, which are disposed on the first gate line and the second gate line, and are respectively connected to opposite ends of the semiconductor layer, and a third electrode disposed between the first electrode and the second electrode.

In an embodiment, the first electrode and the second electrode of the first switch transistor may be connected to the first data output line, the first electrode and the second electrode of the second switch transistor may be connected to the second data output line, the second data line may be connected to the first data output line, and the fourth data line may be connected to the second data output line.

In an embodiment, the third electrode of the first switch transistor may be connected to the first data line and the third electrode of the second switch transistor may be connected to the third data line.

In an embodiment, the first gate line and the second gate line of the first switch transistor may be connected to the first control signal line and the first gate line and the second gate line of the second switch transistor may be connected to the second control signal line.

In an embodiment, the display apparatus may further include a first bridge line and a second bridge line, which extend in the first direction and are arranged, in the plan view, between a control circuit and the first control signal line and the second control signal line, and first bridge connection lines connecting the first bridge line and the first control signal line to each other, and second bridge connection lines connecting the second bridge line and the second control signal line to each other, the first bridge connection lines and the second bridge connection lines extending in the second direction.

The first control signal line may transfer a first control signal to the first switch transistor and the second control signal line may transfer a second control signal to the second switch transistor, and the first control signal and the second control signal may have a same phase.

In an embodiment, the semiconductor layer may include an oxide-based semiconductor material.

According to an aspect, there is provided a display apparatus includes a pixel unit including 2N (2≤N, where N is a natural number) data lines, a data driving unit which outputs a data signal through a first data output line and a second data output line, a data distribution unit which connects the first data output line to an N^{th} data line from among the 2N data lines, and connects the second data output line to a (2N)^{th} data line from among the 2N data lines, the data distribution unit including (N-1) switches connecting the first data output line to each of (Nn-1) data lines, and (N-1) switches connecting the second data output line to each of remaining (N-1) data lines, and a control circuit which outputs (2N-2) control signals for controlling each of the switches, where an i^{th} control signal (1 ≤ i ≤ N-1, where i is a natural number) has a same phase as a phase of an (N+i)^{th} control signal.

According to an aspect, there is provided a display apparatus as set out in claim 1. Additional features are set out in claims 2 to 8. According to an aspect, there is provided a display apparatus as set out in claim 9. Additional features are set out in claims 10 to 15.

Other features and advantages in addition to those described above would become apparent from the following drawings, claims, and detailed description of embodiments.

### BRIEF DESCRIPTION OF THE DRAWINGS

The above and other features and advantages of illustrative embodiments of the disclosure will be more apparent from the following description taken in conjunction with the accompanying drawings, in which:
FIG. 1 is a perspective view schematically illustrating an embodiment of a display apparatus;
FIG. 2 is a diagram schematically illustrating an embodiment of a display apparatus;
FIGS. 3A and 3B are equivalent circuit diagrams each schematically illustrating an embodiment of sub-pixel;
FIGS. 4A and 4B are cross-sectional views each schematically illustrating an embodiment of a region of a display apparatus;
FIG. 5 is a diagram for describing an embodiment of a sub-demultiplexer;
FIG. 6 is a diagram schematically illustrating an embodiment of a display apparatus;
FIG. 7 is a timing diagram for describing an operation of the display apparatus shown in FIG. 6;
FIG. 8 is a diagram schematically illustrating an embodiment of a display apparatus;
FIG. 9 is a layout diagram schematically illustrating an embodiment of a data distribution unit;
FIG. 10 is a cross-sectional view schematically illustrating a cross-section taken along taken along line A-A' of a display apparatus shown in FIG. 9;
FIG. 11 is a diagram schematically illustrating an embodiment of a display apparatus;
FIG. 12 is a layout diagram schematically illustrating an embodiment of a data distribution unit;
FIGS. 13A and 13B are graphs showing a control signal of a display apparatus according to a Comparative Example and a control signal of a display apparatus according to an Embodiment;
FIG. 14 is a diagram for describing an embodiment of a sub-demultiplexer;
FIG. 15 is a diagram schematically illustrating an embodiment of a display apparatus;
FIG. 16 is a timing diagram for describing an operation of the display apparatus shown in FIG. 15;
FIG. 17 is a diagram schematically illustrating an embodiment of a display apparatus;
FIG. 18 is a layout diagram schematically illustrating an embodiment of a data distribution unit;
FIG. 19 is a diagram schematically illustrating an embodiment of a display apparatus;
FIG. 20 is a layout diagram schematically illustrating an embodiment of a data distribution unit;
FIG. 21 is a diagram for describing an embodiment of a sub-demultiplexer; and
FIG. 22 is a diagram schematically illustrating an embodiment of a display apparatus.

### DETAILED DESCRIPTION

Reference will now be made in detail to embodiments, embodiments of which are illustrated in the accompanying drawings, where like reference numerals refer to like elements throughout. In this regard, the illustrated embodiments may have different forms and should not be construed as being limited to the descriptions set forth herein. Accordingly, the embodiments are merely described below, by referring to the drawing figures, to explain features of the description. As used herein, the term "and/or" includes any and all combinations of one or more of the associated listed items. Throughout the disclosure, the expression "at least one of a, b, or c" indicates only a, only b, only c, both a and b, both a and c, both b and c, all of a, b, and c, or variations thereof.

As the disclosure allows for various changes and numerous embodiments, illustrative embodiments will be illustrated in the drawings and described in detail in the written description. Hereinafter, effects and features of the disclosure and a method for accomplishing them will be described more fully with reference to the accompanying drawings, in which embodiments of the disclosure are shown. This disclosure may, however, be embodied in many different forms and should not be construed as limited to the embodiments set forth herein.

It will be understood that although terms such as "first" and "second" may be used herein to describe various elements, these elements should not be limited by these terms and these terms are only used to distinguish one element from another element.

In an embodiment below, an expression used in the singular encompasses the expression of the plural, unless it has a clearly different meaning in the context.

In embodiments below, terms such as comprise, include, or have mean the presence of features or elements described in the specification, and do not preclude the possibility of adding one or more other features or elements.

In the following embodiments, when a part of a film, area, element, or the like is disposed over or on another part, it refers not only to a case where the part is directly on top of the other part, but also a case where another film, area, element, or the like is located therebetween.

In the drawings, for convenience of description, the sizes of elements may be exaggerated or reduced. For example, the size and thickness of each element shown in the drawings are shown arbitrarily for convenience of description, and thus, embodiments are not necessarily limited to shown.

Herein, when a line extends in a first direction or second direction, it means not only extending in a straight line, but also extending in a zigzag or curved line in the first direction or the second direction.

Herein, "in a plan view" means when a target part is viewed from above, and "in a cross-sectional view" means when a cross-section of the target part is cut vertically and viewed from a side.

Herein, when a first element "overlaps" a second element, it means that the first element is disposed over or under the second element.

Herein, when X and Y are connected, it may include a case in which X and Y are electrically connected, a case in which X and Y are functionally connected, and a case in which X and Y are directly connected. Here, X and Y may be objects (e.g., devices, elements, circuits, wiring, electrodes, terminals, conductive films, layers, etc.). Accordingly, the above is not limited to a certain connection relationship, e.g., the connection relationship shown in the drawings or detailed description, and may also include connection relationships other than the those shown in the drawings or detailed description.

When X and Y are electrically connected, it may include a case in which one or more elements that enable electrical connection between X and Y (e.g., a switch, a transistor, a capacitive element, an inductor, a resistor element, a diode, etc.) is connected between X and Y.

In the following embodiments, "ON" used in connection with an element state may refer to an activated state of the element, and "OFF" may refer to a deactivated state of the element. "ON," as used in connection with a signal received by an element, may refer to a signal that activates the element, and "OFF" may refer to a signal that deactivates the element. The device may be activated by a high-level voltage or a low-level voltage. For example, a p-channel transistor is activated by the low-level voltage, and an n-channel transistor is activated by a high-level voltage. Accordingly, it should be understood that "on" voltages for the p-channel transistor (p-type transistor) and the n-channel transistor (n-type transistor) are opposite (low vs. high) voltage levels.

The term such as "unit" as used herein is intended to mean a hardware component that performs a predetermined function. The hardware component may include a circuitry such as a field-programmable gate array ("FPGA") or an application-specific integrated circuit ("ASIC"), for example.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

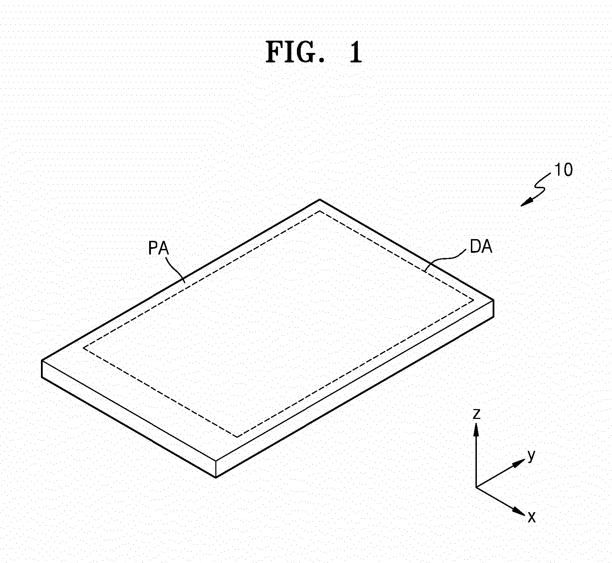

FIG. 1 is a perspective view schematically illustrating an embodiment of a display apparatus 10.

Referring to FIG. 1, the display apparatus 10 may include a display area DA in which an image is displayed and a peripheral area PA disposed around the display area DA. The display apparatus 10 may provide an image by light emitted from a plurality of pixels arranged in the display area DA. The peripheral area PA is an area disposed around the display area DA and may be a kind of non-display area in which no pixel is disposed. The display area DA may be surrounded by the peripheral area PA entirely. In the peripheral area PA, various lines for transmitting electrical signals to be applied to the display area DA and pads to which a printed circuit board or driver integrated circuit ("IC") chip is attached may be disposed.

The display apparatus 10 according to embodiments is a device which displays moving images or still images and may be used as display screens of various products such as televisions, laptops, monitors, billboards, or Internet of Things ("loT") devices as well as portable electronic devices such as a mobile phone, a smartphone, a tablet personal computer, a mobile communication terminal, an electronic notebook, an electronic book, a portable multimedia player ("PMP"), a navigation, a ultra mobile PC ("UMPC"). In addition, the display apparatus 10 in an embodiment may be used for wearable devices such as a smart watch, a watch phone, a glasses-type display, and a head-mounted display ("HMD"). In addition, the display apparatus 10 in an embodiment may be used as displays for an instrument panel of a vehicle, a center information display ("CID") disposed on a center fascia or dashboard of a vehicle, a room mirror display replacing side-view mirrors of a vehicle, or as displays arranged on the rear surfaces of the front seats for an entertainment for the backseat of a vehicle. In addition, the display apparatus 10 may be a flexible, rollable, foldable, or stretchable apparatus.

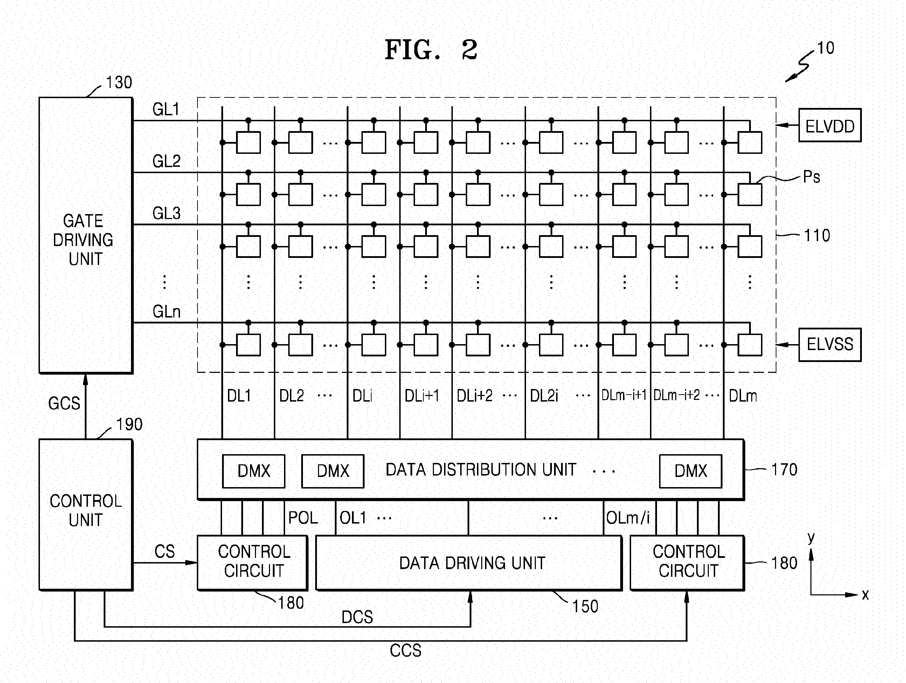

FIG. 2 is a diagram schematically illustrating an embodiment of the display apparatus 10.

Referring to FIG. 2, the display apparatus 10 may include a pixel unit 110, a gate driving unit 130, a data driving unit 150, a data distribution unit 170, control circuits 180, and a control unit 190.

The pixel unit 110 in which a plurality of sub-pixels Ps are arranged may be provided in the display area DA (refer to FIG. 1). The gate driving unit 130, the data driving unit 150, the data distribution unit 170, and the control circuits 180, and the control unit 190 may be provided in the peripheral area PA (refer to FIG. 1).

Each of the plurality of sub-pixels Ps may be connected to a corresponding gate line from among a plurality of gate lines GL1 to GLn and a corresponding data line from among a plurality of data lines DL1 to DLm. Here, n and m may be natural numbers greater than 0. The gate lines GL1 to GLn may each extend in a first direction (e.g., an x direction, which is a row direction) and may be connected to sub-pixels Ps in the same row. Each of the gate lines GL1 to GLn may transmit a gate signal to the sub-pixels Ps. The data lines DL1 to DLm may each extend in the second direction (e.g., a y direction, which is a column direction) and may be connected to sub-pixels Ps in the same column.

The gate driving unit 130 may be connected to the plurality of gate lines GL1 to GLn and may generate gate signals in response to a gate driving control signal GCS from the control unit 190 and sequentially supply the generated gate signals to the gate lines GL1 to GLn. When the gate signals are sequentially supplied to the gate lines GL1 to GLn, the sub-pixels Ps may be selected row by row. Each of the data lines DL1 to DLm may transmit a data signal to sub-pixels Ps of a selected row. The gate lines GL1 to GLn may be connected to gates of transistors included in the sub-pixel Ps. The gate signals may be gate control signals for controlling a turn-on and turn-off of the transistors connected to the gate lines. The gate signals may be square wave signals in which an on voltage at which a transistor may be turned on and an off voltage at which the transistor may be turned off are repeated.

The data driving unit 150 may be connected to a plurality of data output lines OL1 to OLm/i, and the plurality of data output lines OL1 to OLm/i may be connected to the plurality of data lines DL1 to DLm via the data distribution unit 170. The data driving unit 150 may convert an image signal into a data signal in the form of voltage or current in response to a data driving control signal DCS received from the control unit 190. The data driving unit 150 may supply the data signal to the data distribution unit 170 via the data output lines OL1 to OLm/i.

The control circuits 180 may be connected to a plurality of power output lines POL, and the plurality of power output lines POL may be connected to the data distribution unit 170. The control circuits 180 may supply control signals of a sub-demultiplexer DMX to the data distribution unit 170 via the power output lines POL in response to a distribution control signal CS received from the control unit 190.

The data distribution unit 170 may be connected between the plurality of data output lines OL1 to OLm/i and the plurality of data lines DL1 to DLm. The data distribution unit 170 may include m/i (where i is a natural number greater than 2) sub-demultiplexer DMX including a plurality of switches. In other words, the data distribution unit 170 may have the same number of sub-demultiplexers DMX as the number of data output lines OL1 to OLm/i. One end of the sub-demultiplexer DMX may be connected to a corresponding data output line from among the plurality of data output lines OL1 to OLm/i. In addition, an opposite end of the sub-demultiplexer DMX may be connected to i data lines. The sub-demultiplexer DMX may supply a data signal supplied from the corresponding data output line to the i data lines. By using the sub-demultiplexer DMX, fewer data output lines OL1 to OLm/i than the number of data lines DL1 to DLm are desired, and thus, the number of data output lines OL1 to OLm/i connected to the data driving unit 150 is reduced, thereby reducing manufacturing costs. The sub-demultiplexer DMX may include a plurality of switches each connected to the corresponding data output line and respectively connected to the i data lines. In an embodiment, i may be 2.

The control unit 190 may generate the data driving control signal DCS and the gate driving control signal GCS in response to synchronization signals supplied from the outside. The control unit 190 may output the data driving control signal DCS to the data driving unit 150 and the gate driving control signal GCS to the gate driving unit 130. The control unit 190 may output the distribution control signal CS to the control circuits 180, and the control circuits 180 may output control signals of the sub-demultiplexers DMX in response to the distribution control signal CS. The data distribution unit 170 may selectively connect the data output lines OL1 to OLm/i to the data lines DL1 to DLm in response to the control signals of the sub-demultiplexer DMX.

The gate driving unit 130, the data distribution unit 170, and the control unit 190 may be formed directly on a substrate. The data driving unit 150 and the control circuits 180 may be disposed on a flexible printed circuit board ("FPCB") electrically connected to a pad disposed at one side of the substrate. In another embodiment, the data driving unit 150 and the control circuits 180 may be disposed directly on the substrate in a chip on glass ("COG") or chip on plastic ("COP")) method.

When the display apparatus 10 is an organic light-emitting display apparatus, a first power voltage ELVDD and a second power voltage ELVSS may be supplied to the sub-pixels Ps of the display apparatus 10. The first power voltage ELVDD may be a high-level voltage provided to a first electrode (pixel electrode or anode electrode) of a display element (light-emitting element) included in each sub-pixel Ps. The second power voltage ELVSS may be a low-level voltage provided to a second electrode (opposite electrode or cathode electrode) of a display element included in each sub-pixel Ps. The first power voltage ELVDD and the second power voltage ELVSS may be driving voltages for causing the plurality of sub-pixels Ps to emit light.

Hereinbelow, an organic light-emitting display device is described in an embodiment of the display apparatus (also referred to as a display device) 10 in an embodiment, but a display device according to embodiments is not limited thereto. In another embodiment, the display device 10 of embodiments may be an inorganic light-emitting display (or inorganic electroluminescent ("EL") display device) or a quantum dot light-emitting display.

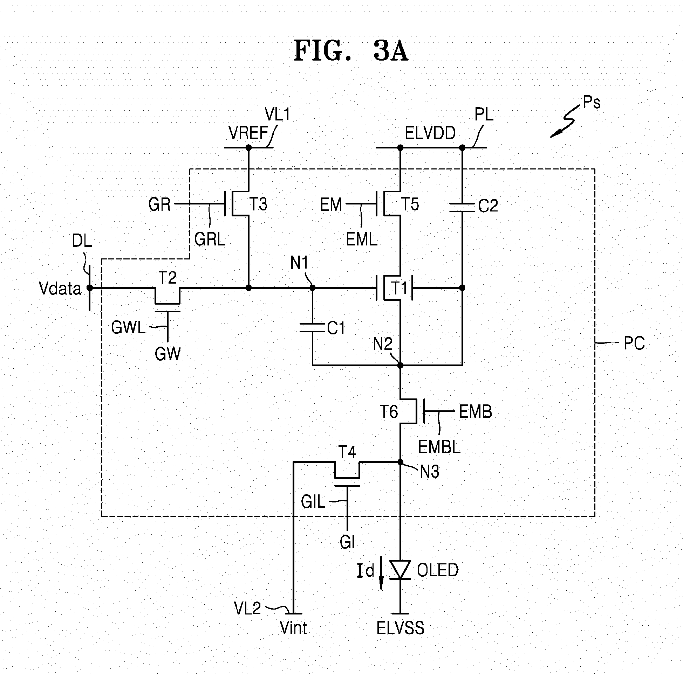

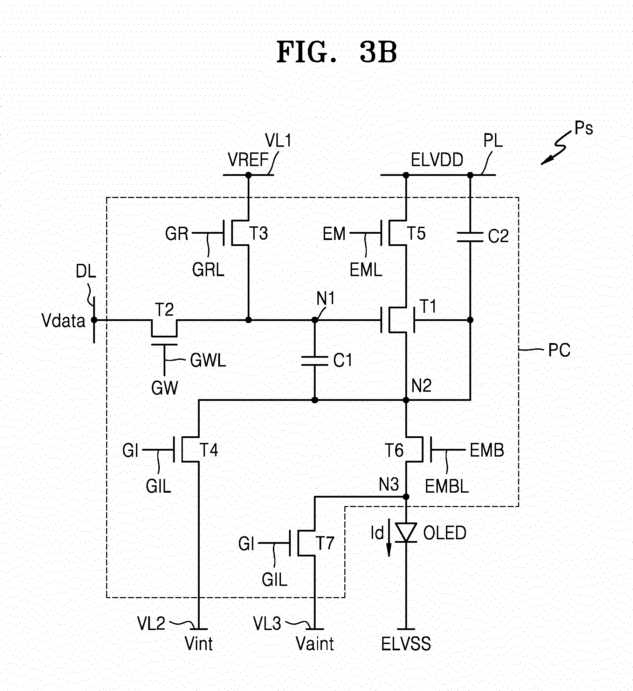

FIGS. 3A and 3B are equivalent circuit diagrams each schematically illustrating an embodiment of a sub-pixel Ps.

Referring to FIG. 3A, the sub-pixel Ps may include an organic light-emitting diode OLED and a sub-pixel circuit PC connected to the organic light-emitting diode OLED. The sub-pixel circuit PC may include first to sixth transistors T1 to T6, a first capacitor C1, and a second capacitor C2. The first transistor T1 may be a driving transistor which outputs a driving current Id corresponding to a data signal Vdata, and the second to sixth transistors T2 to T6 may be switching transistors turned on or off in response to a gate-source voltage or gate voltage.

The first transistor T1 to the sixth transistor T6 may be implemented as thin-film transistors. A first terminal and a second terminal of each of the first transistor T1 to the sixth transistor T6 may be a source or a drain, and the second terminal and the first terminal may not be the same terminal. In an embodiment, when the first terminal is the source, the second terminal may be the drain, for example.

The sub-pixel circuit PC may be connected to a first gate line GWL which transmits a first gate signal GW, a second gate line GIL which transmits a second gate signal GI, a third gate line GRL which transmits a third gate signal GR, a fourth gate line EML which transmits a fourth gate signal EM, a fifth gate line EMBL which transmits a fifth gate signal EMB, and a data line DL which transmits the data signal Vdata.

In addition, the sub-pixel circuit PC may be connected to a driving voltage line PL which transfers the first power voltage ELVDD, a reference voltage line VL1 which transfers a reference voltage VREF, and a first initialization voltage line VL2 which transfers a first initialization voltage Vint.

In an embodiment, the first to sixth transistors T1 to T6 may be provided as n-channel metal-oxide-semiconductor field-effect transistors ("n-type MOSFETs" or "NMOSs"). In another embodiment, some of the first to sixth transistors T1 to T6 may be provided as NMOSs, and the remaining ones may be provided as p-channel MOSFETs ("PMOSs"). In an embodiment, the fifth transistor T5 and the sixth transistor T6 may be provided as PMOSs, and the first to fourth transistors T1 to T4 may be provided as NMOSs. In another embodiment, the first to sixth transistors T1 to T6 may be provided as PMOSs, for example.

In an embodiment, the first to sixth transistors T1 to T6 may be oxide semiconductor transistors including an oxide-based semiconductor material. In an embodiment, the oxide-based semiconductor material may include an oxide of at least one material of indium (In), gallium (Ga), tin (Sn), zirconium (Zr), vanadium (V), hafnium (Hf), cadmium (Cd), germanium (Ge), chrome (Cr), titanium (Ti), aluminum (Al), cesium (Cs), cerium (Ce), and zinc (Zn), for example. The oxide-based semiconductor material may be In-Ga-Zn-O ("IGZO"), In-Sn-Zn-O ("ITZO"), or In-Ga-Sn-Zn-O ("IGTZO").

Because an oxide semiconductor has relatively high carrier mobility and relatively low leakage current, a voltage drop is not significant even when the display apparatus is driven for a long time. Thus, the oxide semiconductor transistor enables low-frequency driving. In addition, when the oxide semiconductor transistor is used, a crystallization process by excimer laser annealing ("ELA") is not desired to form a low-temperature polycrystalline silicon ("LTPS") semiconductor transistor, and thus, a manufacturing cost of the display apparatus may be reduced.

In another embodiment, some of the first to sixth transistors T1 to T6 may be oxide semiconductor transistors, and the remaining ones may be silicon semiconductor transistors including a silicon-based semiconductor material. In another embodiment, the first to sixth transistors T1 to T6 may be silicon semiconductor transistors. The silicon-based semiconductor material may be polysilicon or amorphous silicon.

The first transistor T1 may include a first terminal connected to the driving voltage line PL via the fifth transistor T5, a second terminal connected to a second node N2, a first gate connected to the first node N1, and a second gate connected to the second node N2. The first transistor T1 may receive the data signal Vdata in response to the switching operation of the second transistor T2 and supply a driving current Id to the organic light-emitting diode OLED.

The second transistor T2 (data write transistor) may include a gate connected to the first gate line GWL, a first terminal connected to the data line DL, and a second terminal connected to the first node N1. The second transistor T2 may be turned on in response to the first gate signal GW received via the first gate line GWL and may perform a switching operation for transmitting the data signal Vdata received via the data line DL to the first node N1.

The third transistor T3 (first initialization transistor) may include a gate connected to the third gate line GRL, a first terminal connected to the reference voltage line VL1, and a second terminal connected to the first node N1. The third transistor T3 may be turned on in response to the third gate signal GR received via the third gate line GRL and may transfer the reference voltage VREF received via the reference voltage line VL1 and initialize the first node N1.

The fourth transistor T4 (second initialization transistor) may include a gate connected to the second gate line GIL, a first terminal connected to the first initialization voltage line VL2, and a second terminal connected to a third node N3. The fourth transistor T4 may be turned on in response to the second gate signal GI received via the second gate line GIL and may transfer the first initialization voltage Vint received via the first initialization voltage line VL2 to the third node N3 and initialize a pixel electrode of the organic light-emitting diode OLED.

The fifth transistor T5 (first emission control transistor) may include a gate connected to the fourth gate line EML, a first terminal connected to the driving voltage line PL, and a second terminal connected to the first terminal of the first transistor T1. The sixth transistor T6 (second emission control transistor) may include a gate connected to the fifth gate line EMBL, a first terminal connected to the second node N2, and a second terminal connected to the third node N3. The fifth transistor T5 may be turned on in response to the fourth gate signal EM received via the fourth gate line EML, and the sixth transistor T6 may be turned on in response to the fifth gate signal EMB received via the fifth gate line EMBL so that the driving current Id may flow through the organic light-emitting diode OLED.

In another embodiment, the gate of the fifth transistor T5 and the gate of the sixth transistor T6 may be connected to the same gate line (emission control signal line). In this case, the fifth transistor T5 and the sixth transistor T6 may be simultaneously turned on by the same gate signal (emission control signal).

The first capacitor C1 may include a first electrode connected to the first node N1 and a second electrode connected to the second node N2. The first capacitor C1, which is a storage capacitor, may store a voltage corresponding to a threshold voltage of the first transistor T1 and the data signal Vdata.

The second capacitor C2 may include a first electrode connected to the driving voltage line PL and a second electrode connected to the second node N2. In an embodiment, a capacitance of the first capacitor C1 may be greater than a capacitance of the second capacitor C2. In FIG. 3A, the first electrode of the second capacitor C2 is connected to the driving voltage line PL. However, embodiments of the disclosure are not limited thereto. In an embodiment, the first electrode of the second capacitor C2 may be connected to the reference voltage line VL1 which transfers the reference voltage VREF or the first initialization voltage line VL2 which transfers the first initialization voltage Vint, for example.

The organic light-emitting diode OLED may include the pixel electrode connected to the third node N3 and an opposite electrode (e.g., a cathode) facing the pixel electrode, and the opposite electrode may receive the second power voltage ELVSS. The opposite electrode may be a common electrode common to the plurality of sub-pixels Ps.

Referring to FIG. 3B, the sub-pixel circuit PC may include first to seventh transistors T1 to T7, the first capacitor C1, and the second capacitor C2.

The sub-pixel circuit PC may be connected to the first gate line GWL which transmits the first gate signal GW, the second gate line GIL which transmits the second gate signal GI, the third gate line GRL which transmits the third gate signal GR, the fourth gate line EML which transmits the fourth gate signal EM, the fifth gate line EMBL which transmits the fifth gate signal EMB, and the data line DL which transmits the data signal Vdata.

In addition, the sub-pixel circuit PC may be connected to the driving voltage line PL which transfers the first power voltage ELVDD, the reference voltage line VL1 which applies the reference voltage VREF, the first initialization voltage line VL2 which transfers the first initialization voltage Vint, and a second initialization voltage line VL3 which transfers a second initialization voltage Vaint.

The first transistor T1 may include the first terminal connected to the driving voltage line PL via the fifth transistor T5, the second terminal connected to the second node N2, the first gate connected to the first node N1, and the second gate connected to the second node N2. The first transistor T1 may receive the data signal Vdata in response to the switching operation of the second transistor T2 and supply the driving current Id to the organic light-emitting diode OLED.

The second transistor T2 (data write transistor) may include the gate connected to the first gate line GWL, the first terminal connected to the data line DL, and the second terminal connected to the first node N1. The second transistor T2 may be turned on in response to the first gate signal GW received via the first gate line GWL and may perform a switching operation for transmitting the data signal Vdata received via the data line DL to the first node N1.

The third transistor T3 (first initialization transistor) may include the gate connected to the third gate line GRL, the first terminal connected to the reference voltage line VL1, and the second terminal connected to the first node N1. The third transistor T3 may be turned on in response to the third gate signal GR received via the third gate line GRL and may transfer the reference voltage VREF received via the reference voltage line VL1 and initialize the first node N1.

The fourth transistor T4 (second initialization transistor) may include the gate connected to the second gate line GIL, the first terminal connected to the first initialization voltage line VL2, and the second terminal connected to the second node N2. The fourth transistor T4 may be turned on in response to the second gate signal GI received via the second gate line GIL and may transfer the first initialization voltage Vint received via the first initialization voltage line VL2 to the second node N2 and initialize the second node N2.

The fifth transistor T5 (first emission control transistor) may include the gate connected to the fourth gate line EML, the first terminal connected to the driving voltage line PL, and the second terminal connected to the first terminal of the first transistor T1. The sixth transistor T6 (second emission control transistor) may include the gate connected to the fifth gate line EMBL, the first terminal connected to the second node N2, and the second terminal connected to the third node N3. The fifth transistor T5 may be turned on in response to the fourth gate signal EM received via the fourth gate line EML, and the sixth transistor T6 may be turned on in response to the fifth gate signal EMB received via the fifth gate line EMBL so that the driving current Id may flow through the organic light-emitting diode OLED.

In another embodiment, the gate of the fifth transistor T5 and the gate of the sixth transistor T6 may be connected to the same gate line (emission control signal line). In this case, the fifth transistor T5 and the sixth transistor T6 may be simultaneously turned on by the same gate signal (emission control signal).

The seventh transistor T7 (third initialization transistor) may include a gate connected to the second gate line GIL, a first terminal connected to the second initialization voltage line VL3, and a second terminal connected to the third node N3. The seventh transistor T7 may be turned on in response to the second gate signal GI received via the second gate line GIL and may transfer the second initialization voltage Vaint received via the second initialization voltage line VL3 to the third node N3 and initialize the pixel electrode of the organic light-emitting diode OLED.

In FIG. 3B, the first terminal of the fourth transistor T4 and the first terminal of the seventh transistor T7 are connected to different voltage lines, respectively. However, embodiments of the disclosure are not limited thereto. In an embodiment, the first terminal of the fourth transistor T4 and the first terminal of the seventh transistor T7 may be connected to the same voltage line and may transfer the same initialization voltage to the second node N2 and the third node N3.

The first capacitor C1 may include the first electrode connected to the first node N1 and the second electrode connected to the second node N2. The first capacitor C1, which is a storage capacitor, may store a voltage corresponding to a threshold voltage of the first transistor T1 and the data signal Vdata.

The second capacitor C2 may include the first electrode connected to the driving voltage line PL and the second electrode connected to the second node N2. In an embodiment, the capacitance of the first capacitor C1 may be greater than the capacitance of the second capacitor C2. In FIG. 3B, the first electrode of the second capacitor C2 is connected to the driving voltage line PL. However, embodiments of the disclosure are not limited thereto. In an embodiment, the first electrode of the second capacitor C2 may be connected to the reference voltage line VL1 which transfers the reference voltage VREF, the first initialization voltage line VL2 which transfers the first initialization voltage Vint, or the second initialization voltage line VL3 which transfers the second initialization voltage Vaint, for example.

The organic light-emitting diode OLED may include the pixel electrode connected to the third node N3 and the opposite electrode facing the pixel electrode, and the opposite electrode may receive the second power voltage ELVSS. The opposite electrode may be a common electrode common to the plurality of sub-pixels Ps.

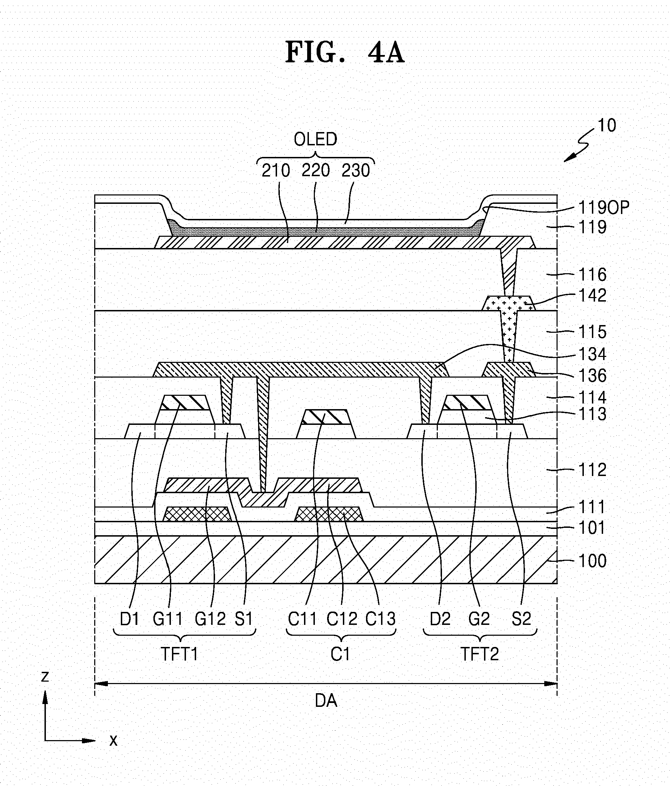

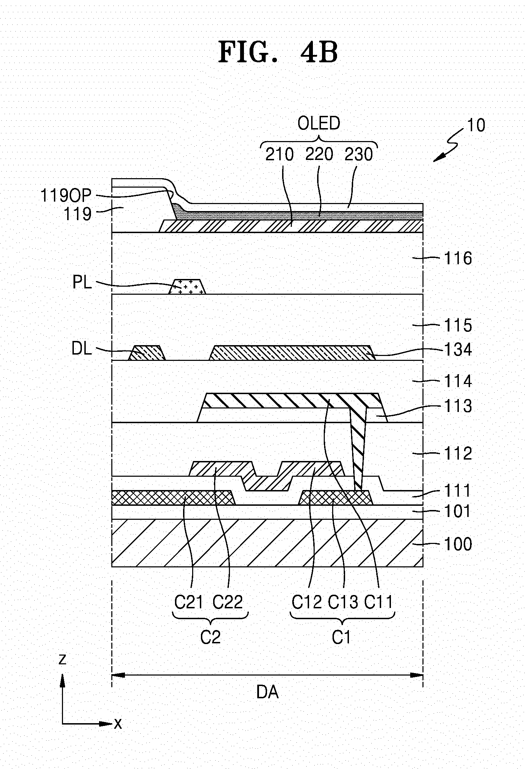

FIGS. 4A and 4B are cross-sectional views each schematically illustrating an embodiment of a region of the display apparatus 10.

Referring to FIGS. 4A and 4B, the display apparatus 10 may include a sub-pixel Ps (refer to FIG. 2) disposed in the display area DA. The sub-pixel Ps may include a sub-pixel circuit PC (refer to FIG. 3A) and the organic light-emitting diode OLED electrically connected to the sub-pixel circuit PC. The sub-pixel circuit PC may include thin-film transistors and capacitors. A first thin-film transistor TFT1 shown in FIGS. 4A and 4B may correspond to the first transistor T1 (refer to FIG. 3A), and a second thin-film transistor TFT2 may correspond to the sixth transistor T6 (refer to FIG. 3A).

The display apparatus 10 may include a substrate 100. The substrate 100 may include an area corresponding to the display area DA and an area corresponding to the peripheral area PA (refer to FIG. 1). Herein, when the substrate 100 includes the display area DA and the peripheral area PA, it means that the substrate 100 includes an area corresponding to the display area DA and an area corresponding to the peripheral area PA.

The substrate 100 may include a glass material, a ceramic material, a metal material, or a material having flexible or bendable properties. When the substrate 100 includes flexible or bendable properties, the substrate 100 may include polymer resin such as polyethersulfone, polyacrylate, polyetherimide, polyethylene naphthalate, polyethylene terephthalate, polyphenylene sulfide, polyarylate, polyimide, polycarbonate, or cellulose acetate propionate.

The substrate 100 may have a single-layer structure or a multi-layer structure. In an embodiment, the substrate 100 may have a multi-layer structure in which an inorganic layer is between base layers including the polymer resin described above.

A barrier layer 101 may be disposed on the substrate 100. The barrier layer 101 may prevent or minimize permeation of impurities into the sub-pixel circuit PC from the substrate 100 or the like. The barrier layer 101 may include an inorganic material such as an oxide or nitride, an organic material, or an organic and inorganic compound, and may have a single-layered or multi-layered structure of an inorganic material and/or an organic material.

A third electrode C13 of the first capacitor C1 and a first electrode C21 of the second capacitor C2 may be disposed on the barrier layer 101. In an embodiment, the first electrode C21 of the second capacitor C2 may be connected to the driving voltage line PL. The third electrode C13 of the first capacitor C1 and the first electrode C21 of the second capacitor C2 may include molybdenum (Mo), aluminum (Al), copper (Cu), titanium (Ti), or the like, and may include a layer or layers.

A first buffer layer 111 may be disposed on the third electrode C13 of the first capacitor C1 and the first electrode C21 of the second capacitor C2. The first buffer layer 111 may include an inorganic material such as an oxide or nitride, an organic material, or an organic and inorganic compound, and may have a single-layered or multi-layered structure of an inorganic material and/or an organic material.

A second electrode C12 of the first capacitor C1, a second electrode C22 of the second capacitor C2, and a first lower gate electrode G12 of the first thin-film transistor TFT1 may be disposed on the first buffer layer 111. In an embodiment, the second electrode C12 of the first capacitor C1, the second electrode C22 of the second capacitor C2, and the first lower gate electrode G12 of the first thin-film transistor TFT1 may be integrally provided as a single body.

The second electrode C12 of the first capacitor C1, the second electrode C22 of the second capacitor C2, and the first lower gate electrode G12 of the first thin-film transistor TFT1 may include Mo, Al, Cu, Ti, or the like, and may include a layer or layers.

In a plan view, the second electrode C22 of the second capacitor C2 may overlap the first electrode C21 of the second capacitor C2 to form the second capacitor C2.

A second buffer layer 112 may be disposed on the second electrode C12 of the first capacitor C1, the second electrode C22 of the second capacitor C2, and the first lower gate electrode G12 of the first thin-film transistor TFT1. The second buffer layer 112 may include an inorganic material such as an oxide or nitride, an organic material, or an organic and inorganic compound, and may have a single-layered or multi-layered structure of an inorganic material and/or an organic material.

A first semiconductor layer of the first thin-film transistor TFT1 and a second semiconductor layer of the second thin-film transistor TFT2 may be disposed on the second buffer layer 112. In an embodiment, the first semiconductor layer and the second semiconductor layer may include an oxide semiconductor material. In an embodiment, the oxide semiconductor material may include an oxide of at least one material of indium (In), gallium (Ga), tin (Sn), zirconium (Zr), vanadium (V), hafnium (Hf), cadmium (Cd), germanium (Ge), chrome (Cr), titanium (Ti), Al, cesium (Cs), cerium (Ce), and zinc (Zn), for example. The oxide semiconductor material may be IGZO, ITZO, or IGTZO.

Each of the first semiconductor layer and the second semiconductor layer may include a channel region and a source region and a drain region respectively disposed at opposite sides of the channel region. In an embodiment, the first semiconductor layer may include a first source region S1 and a first drain region D1 of the first thin-film transistor TFT1, and the second semiconductor layer may include a second source region S2 and a second drain region D2 of the second thin-film transistor TFT2, for example.

A first upper gate electrode G11 and the first lower gate electrode G12 of the first thin-film transistor TFT1 may overlap the channel region of the first semiconductor layer. A second gate electrode G2 of the second thin-film transistor TFT2 may overlap the channel region of the second semiconductor layer.

A gate insulating layer 113 may be disposed on the first semiconductor layer and the second semiconductor layer. The gate insulating layer 113 may include an inorganic insulating layer such as silicon oxide, silicon nitride, silicon oxynitride, or aluminum oxide. In an embodiment, as shown in FIGS. 4A and 4B, the gate insulating layer 113 may be patterned to have a shape corresponding to a conductive layer disposed on the gate insulating layer 113.

The first upper gate electrode G11 of the first thin-film transistor TFT1, the second gate electrode G2 of the second thin-film transistor TFT2, and a first electrode C11 of the first capacitor C1 may be disposed on the gate insulating layer 113. Each of the first upper gate electrode G11 of the first thin-film transistor TFT1, the second gate electrode G2 of the second thin-film transistor TFT2, and the first electrode C11 of the first capacitor C1 may include Mo, Al, Cu, Ti, or the like, and may include a layer or layers.

In a plan view, the first electrode C11 of the first capacitor C1 may overlap the second electrode C12 and the third electrode C13 of the first capacitor C1 to form the first capacitor C1. In an embodiment, the first electrode C11 of the first capacitor C1 may be connected in contact with the third electrode C13 of the first capacitor C1 through a contact hole passing through the first buffer layer 111, the second buffer layer 112, and the gate insulating layer 113.

An inter-insulating layer 114 may be disposed on the first upper gate electrode G11 of the first thin-film transistor TFT1, the second gate electrode G2 of the second thin-film transistor TFT2, and a first electrode C11 of the first capacitor C1. The inter-insulating layer 114 may include an inorganic material such as an oxide or nitride, an organic material, or an organic and inorganic compound, and may have a single-layered or multi-layered structure of an inorganic material and/or an organic material.

A first connection electrode 134, a second connection electrode 136, and the data line DL may be disposed on the inter-insulating layer 114. The first connection electrode 134 may be connected via contact holes to the first source region S1 of the first thin-film transistor TFT1, the second drain region D2 of the second thin-film transistor TFT2, the second electrode C12 of the first capacitor C1, the second electrode C22 of the second capacitor C2, and the first lower gate electrode G12 of the first thin-film transistor TFT1. The second connection electrode 136 may be connected to the second source region S2 of the second thin-film transistor TFT2 through a contact hole passing through the inter-insulating layer 114.

The first connection electrode 134, the second connection electrode 136, and the data line DL may include a conductive material, including Mo, Al, Cu, Ti, or the like, and may include a layer or layers including the materials described above. In an embodiment, the first connection electrode 134, the second connection electrode 136, and the data line DL may have a multi-layer of Ti/AI/Ti, for example.

A first organic insulating layer 115 may be disposed on the first connection electrode 134, the second connection electrode 136, and the data line DL. In an embodiment, the first organic insulating layer 115 may include an organic insulating material such as general-purpose polymers such as poly(methyl methacrylate) ("PMMA"), polystyrene ("PS"), polymer derivatives having a phenol-based group, acryl-based polymers, imide-based polymers, aryl ether-based polymers, amide-based polymers, fluorine-based polymers, p-xylene-based polymers, vinyl alcohol-based polymers, and any combinations thereof.

A third connection electrode 142 and the driving voltage line PL may be disposed on the first organic insulating layer 115. The third connection electrode 142 may be connected to the second connection electrode 136 through a contact hole passing through the first organic insulating layer 115. The third connection electrode 142 and the driving voltage line PL may include a conductive material, including Mo, Al, Cu, Ti, or the like, and may include or consist of a layer or layers including the materials described above. In an embodiment, the third connection electrode 142 and the driving voltage line PL may have a multi-layer of Ti/Al/Ti, for example.

In FIGS. 4A and 4B, the data line DL and the driving voltage line PL are disposed in different layers. However, in another embodiment, the data line DL and the driving voltage line PL may be arranged in the same layer. In an embodiment, the data line DL may be disposed between the first organic insulating layer 115 and a second organic insulating layer 116, for example.

The second organic insulating layer 116 may be disposed on the third connection electrode 142 and the driving voltage line PL. The second organic insulating layer 116 may include an organic material. In an embodiment, the second organic insulating layer 116 may include an organic insulating material such as general-purpose polymers such as PMMA, PS, polymer derivatives having a phenol-based group, acryl-based polymers, imide-based polymers, aryl ether-based polymers, amide-based polymers, fluorine-based polymers, p-xylene-based polymers, vinyl alcohol-based polymers, and any combinations thereof, for example.

The organic light-emitting diode OLED may be disposed on the second organic insulating layer 116. The organic light-emitting diode OLED may include a pixel electrode 210, an emission layer 220, and an opposite electrode 230.

The pixel electrode 210 may be disposed on the second organic insulating layer 116. The pixel electrode 210 may be connected to the third connection electrode 142 through a contact hole passing through the second organic insulating layer 116. The pixel electrode 210 may be connected to the second source region S2 of the second thin-film transistor TFT2 through the third connection electrode 142 and the second connection electrode 136.

The pixel electrode 210 may include a reflective film including silver (Ag), magnesium (Mg), Al, platinum (Pt), palladium (Pd), gold (Au), nickel (Ni), neodymium (Nd), iridium (Ir), chrome (Cr), or any combinations thereof. In an alternative embodiment, the pixel electrode 210 may further include a conductive oxide layer over and/or under the reflective film described above. The conductive oxide layer may include indium tin oxide, indium zinc oxide, zinc oxide, indium oxide, indium gallium oxide, and/or aluminum zinc oxide. In an embodiment, the pixel electrode 210 may have a three-layer structure of ITO/Ag/ITO.

A bank layer 119 may be disposed on the pixel electrode 210. An opening 119OP may be defined in the bank layer 119 to expose at least part of the pixel electrode 210. A central portion of the pixel electrode 210 may be exposed through the opening 119OP defined in the bank layer 119. The bank layer 119 may prevent an arc or the like from occurring at an edge of the pixel electrode 210 by increasing a distance between an edge of the pixel electrode 210 and the opposite electrode 230 over the pixel electrode 210. The opening 119OP may define an emission area of the organic light-emitting diode OLED.

The bank layer 119 may include an organic insulating material such as polyimide, polyamide, acrylic resin, benzocyclobutene, hexamethyldisiloxane ("HMDSO"), or phenolic resin. The bank layer 119 may be formed by spin coating or the like.

In an embodiment, the bank layer 119 may include a light-blocking material and may be provided in black. The light-blocking material may include carbon black, carbon nanotubes, resin or paste including black dye, metal particles, such as Ni, Al, Mo, and any alloys thereof, metal oxide particles (e.g., chrome oxide), metal nitride particles (e.g., chrome nitride), or the like. When the bank layer 119 includes the light-blocking material, reflection by metal elements disposed under the bank layer 119 may be reduced.

A spacer (not shown) may be formed on the bank layer 119. The spacer may be formed together with the bank layer 119 in the same process or may be individually formed in separate processes.

The emission layer 220 may include or consist of an organic material including or consisting of a fluorescent or phosphorous material that emits red, green, blue, or white light. The emission layer 220 may be a low-molecular weight organic material or a polymer organic material, and under and over the emission layer 220, a functional layer such as a hole transport layer, a hole injection layer, an electron transport layer, and an electron injection layer may be further selectively disposed.

The emission layer 220 may have a patterned shape corresponding to the pixel electrode 210. The functional layer such as the hole transport layer may be integrally provided across a plurality of pixel electrodes 210.

The opposite electrode 230 may be disposed on the emission layer 220. The opposite electrode 230 may include a conductive material with a relatively low work function. In an embodiment, the opposite electrode 230 may include a (semi-)transparent layer including Ag, Mg, Al, Pt, Pd, Au, Ni, Nd, Ir, Cr, lithium (Li), calcium (Ca), or any alloys thereof, for example. In an alternative embodiment, the opposite electrode 230 may further include a layer including indium tin oxide ("ITO"), indium zinc oxide ("IZO"), ZnO, or indium oxide (In₂O₃), over the (semi-)transparent layer including the materials described above. In an embodiment, the opposite electrode 230 may be integrally provided as a single body across the plurality of pixel electrodes 210 to cover an entirety of the display area DA.

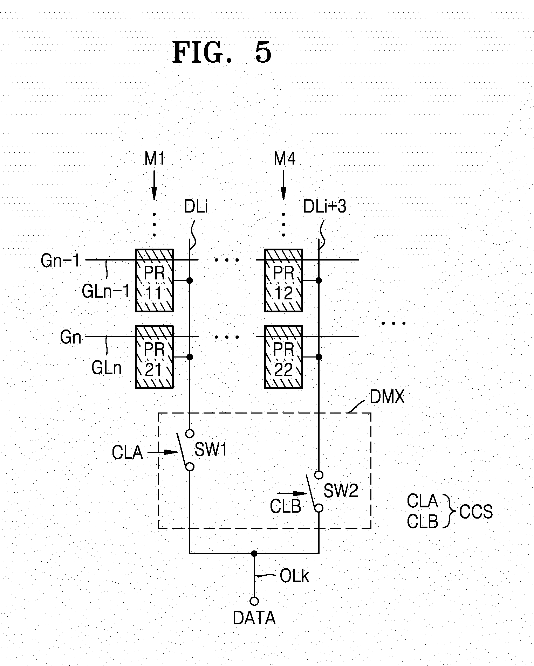

FIG. 5 is a diagram for describing an embodiment of a sub-demultiplexer DMX.

Referring to FIG. 5, the sub-demultiplexer DMX may selectively connect a k^{th} data output line OLk to a pair of i^{th} data line DLi and (i+3)^{th} data line DLi+3. The sub-demultiplexer DMX may include a first switch SW1 and a second switch SW2.

The i^{th} data line DLi and the (i+3)^{th} data line DLi+3 may be data lines arranged to be spaced apart from each other with two columns interposed therebetween. In an embodiment, an (i+1)^{th} data line and an (i+2)^{th} data line may be arranged between the i^{th} data line DLi and the (i+3)^{th} data line DLi+3, for example. The i^{th} data line DLi may be connected to sub-pixels in an i^{th} column (annotated by M1, for example), and the (i+3)^{th} data line DLi+3 may be connected to sub-pixels in an (i+3)^{th} column (annotated by M4, for example).

The first switch SW1 may be provided between the k^{th} data output line OLk and the i^{th} data line DLi. The first switch SW1 may connect the k^{th} data output line OLk to the i^{th} data line DLi by a first control signal CLA and may apply a data signal DATA applied via the k^{th} data output line OLk to the i^{th} data line DLi.

The second switch SW2 may be provided between the k^{th} data output line OLk and the (i+3)^{th} data line DLi+3. The second switch SW2 may connect the k^{th} data output line OLk to the (i+3)^{th} data line DLi+3 by a second control signal CLB and may apply the data signal DATA applied via the k^{th} data output line OLk to the (i+3)^{th} data line DLi+3.

Control signals CCS of the sub-demultiplexer DMX output from the control signal 180 (refer to FIG. 2) may include the first control signal CLA and the second control signal CLB. The first control signal CLA and the second control signal CLB may be applied alternately at different timings without overlapping.

In an embodiment, the sub-pixels connected to i^{th} data line DLi and the (i+3)^{th} data line DLi+3 may emit light of the same color. Regarding this, FIG. 5 shows that the sub-pixels connected to the i^{th} data line DLi and the (i+3)^{th} data line DLi+3 are red sub-pixels PR emitting red light. However, embodiments of the disclosure are not limited thereto. Connections between data lines and sub-pixels may be modified in various ways. In another embodiment, the sub-pixels connected to the i^{th} data line DLi may include sub-pixels emitting light of a first color and sub-pixels emitting light of a second color, which is different from the first color, the sub-pixels connected to the (i+3)^{th} data line DLi+3 may include sub-pixels emitting light of a first color and sub-pixels emitting light of a second color, and sub-pixels connected to an (i+1)^{th} data line and an (i+4)^{th} data line may be sub-pixels emitting light of a third color which is different from the first color and the second color.

In FIG. 5, the red sub-pixels PR connected to an (n-1)^{th} gate line GLn-1 disposed in an (n-1)^{th} row and an n^{th} gate line GLn disposed in an n^{th} row are shown. The gate lines GLn-1 and GLn shown in FIG. 5 may be a gate line (e.g., GL1, GL2...GLn) shown in FIG. 2 or the first gate line GWL shown in FIGS. 3A and 3B.

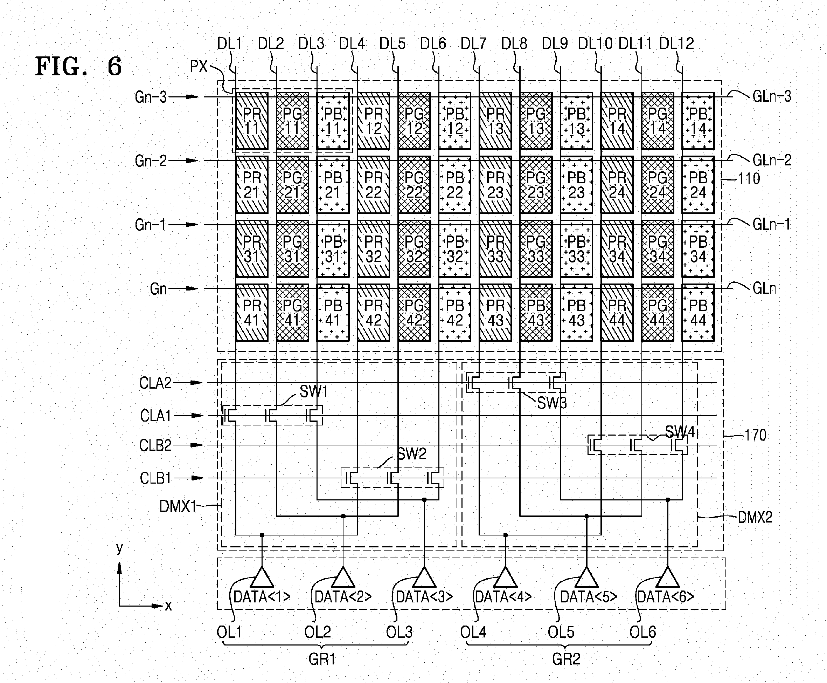

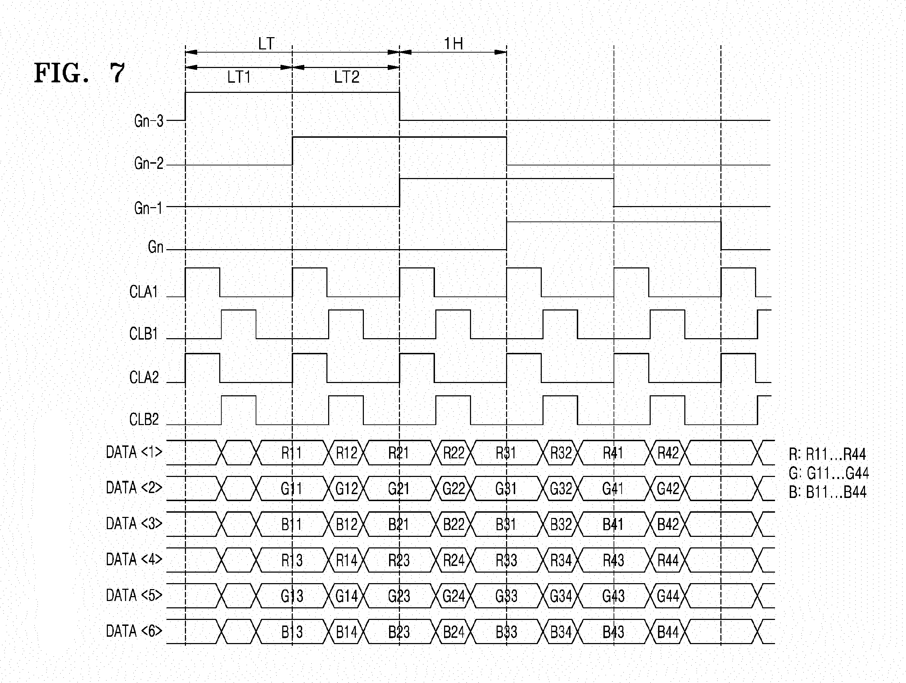

FIG. 6 is a diagram schematically illustrating an embodiment of a display apparatus. FIG. 7 is a timing diagram for describing an operation of the display apparatus shown in FIG. 6.

Referring to FIG. 6, the data distribution unit 170 may include a first demultiplexer DMX1 and a second demultiplexer DMX2, and the pixel unit 110 may include a plurality of pixels PX. A pixel PX may include a red sub-pixel PR, a green sub-pixel PG, and a blue sub-pixel PB. The above description of the sub-pixel Ps may be applied to any of the red sub-pixel PR, the green sub-pixel PG, and the blue sub-pixel PB.

In the pixel unit 110, a column in which the red sub-pixels PR are arranged in a second direction (e.g., a y-axis direction), a column in which the green sub-pixels PG are arranged in the second direction (e.g., the y-axis direction), and a column in which the blue sub-pixels PB are arranged in the second direction (e.g., the y-axis direction) may be alternately repeated in a first direction (e.g., an x-axis direction).

In an embodiment, in a first row, a first pixel, a second pixel, a third pixel, and a fourth pixel may be sequentially arranged in the first direction (e.g., the x-axis direction), the first pixel may include three sub-pixels PR11, PG11, and PB11 in first to third columns, the second pixel may include three sub-pixels PR12, PG12, and PB12 in fourth to sixth columns, the three pixels may include three sub-pixels PR13, PG13, and PB13 in seventh to ninth columns, and the fourth pixel may include three sub-pixels PR14, PG14, and PB14 in tenth to twelfth columns, for example.

A plurality of data lines DL1, DL2, ..., DL12 and a plurality of gate lines GLn-3, GLn-2, GLn-1, and GLn may be arranged in the pixel unit 110. The plurality of gate lines GLn-3, GLn-2, GLn-1, and GLn may be the gate line (e.g., GL1, GL2...GLn) shown in FIG. 2 or the first gate line GWL shown in FIGS. 3A and 3B.

One gate line may be connected to sub-pixels arranged in the same row. One data line may be connected to sub-pixels arranged in the same column. The sub-pixels connected to the i^{th} data line DLi and the sub-pixels connected to the (i+3)^{th} data line DLi+3 may be sub-pixels emitting light of the same color. For convenience of description, FIG. 6 shows only twelve data lines DL1, DL2, ..., and DL12, four gate lines GLn-3, GLn-2, GLn-1, and GLn, and six data output lines OL1, OL2, ..., and OL6. However, the number of data lines, the number of gate lines, and the number of data output lines may be greater.

The first demultiplexer DMX1 may selectively connect the data output lines OL1, OL2, and OL3 belonging to a first group GR1 to first to sixth data lines DL1, DL2, ..., and DL6, and the second demultiplexer DMX2 may selectively connect data output lines OL4, OL5, and OL6 belonging to a second group GR2 to seventh to twelfth data lines DL7, DL8, ..., and DL12.

Each of the first demultiplexer DMX1 and the second demultiplexer DMX2 may include the plurality of sub-demultiplexers DMX (refer to FIG. 5). One sub-demultiplexer DMX may selectively connect one data output line to a pair of data lines. A pair of data lines connected to one sub-demultiplexer DMX may be arranged to be spaced apart from each other with two columns interposed therebetween.

In an embodiment, a pair of data lines connected to the first data output line OL1 belonging to the first group GR1 may be the first data line DL1 and the fourth data line DL4, for example. The first data line DL1 may be connected to the red sub-pixel PR11 of the first pixel, and the fourth data line DL4 may be connected to the red sub-pixel PR12 of the second pixel.

A pair of data lines connected to the fourth data output lines OL4 belonging to the second group GR2 may be the seventh data line DL7 and the tenth data line DL10. The seventh data line DL7 may be connected to the red sub-pixel PR13 of the third pixel, and the tenth data line DL10 may be connected to the red sub-pixel PR14 of the fourth pixel.

The first demultiplexer DMX1 may include first switches SW1 and second switches SW2. Each of the first switches SW1 may be provided between the first data output line OL1 and the first data line DL1, between the second data output line OL2 and the second data line DL2, and between the third data output line OL3 and the third data line DL3. The first switches SW1 may be turned on by a first control signal CLA1 and may connect the first data output line OL1 to the first data line DL1, the second data output line OL2 to the second data line DL2, and the third data output line OL3 to the third data line DL3.

Each of the second switches SW2 may be provided between the first data output line OL1 and the fourth data line DL4, between the second data output line OL2 and a fifth data line DL5, and between the third data output line OL3 and a sixth data line DL6. The second switches SW2 may be turned on by a second control signal CLB1 and may connect the first data output line OL1 to the fourth data line DL4, the second data output line OL2 to the fifth data line DL5, and the third data output line OL3 to the sixth data line DL6.

A first data signal DATA<1 > applied to the first data output line OL1 may include first subdata signals R applied to the red sub-pixel PR, a second data signal DATA<2> applied to the second data output line OL2 may include second subdata signals G applied to the green sub-pixels PG, and a third data signal DATA<3> applied to the third data output line OL3 may include third subdata signals B applied to the blue sub-pixels PB.

The second demultiplexer DMX2 may include third switches SW3 and fourth switches SW4. Each of the third switches SW3 may be provided between the fourth data output lines OL4 and the seventh data line DL7, between the fifth data output line OL5 and the eighth data line DL8, and between the sixth data output line OL6 and the ninth data line DL9. The third switches SW3 may be turned on by a third control signal CLA2 and may connect the fourth data output lines OL4 to the seventh data line DL7, the fifth data output line OL5 to the eighth data line DL8, and the sixth data output line OL6 to the ninth data line DL9.

Each of the fourth switches SW4 may be provided between the fourth data output lines OL4 and the tenth data line DL10, between the fifth data output line OL5 and the eleventh data line DL11, and between the sixth data output line OL6 and the twelfth data line DL12. The fourth switches SW4 may be turned on according to a fourth control signal CLB2 and may connect the fourth data output lines OL4 to the tenth data line DL10, the fifth data output line OL5 to the eleventh data line DL11, and the sixth data output line OL6 to the twelfth data line DL12.

A fourth data signal DATA<4> applied to the fourth data output lines OL4 may include the first subdata signals R applied to the red sub-pixel PR, a fifth data signal DATA<5> applied to the fifth data output line OL5 may include the second subdata signals G applied to the green sub-pixels PG, and a sixth data signal DATA<6> applied to the sixth data output line OL6 may include the third subdata signals B applied to the blue sub-pixels PB.

FIG. 7 shows an order of data signals applied by a data driving unit 150 (refer to FIG. 2) to sub-pixels through data output lines. Hereinbelow, when it is described without separate mention that an arbitrary signal is supplied or output, it may mean that an on voltage of the signal is supplied.

Referring to FIG. 7, the first control signal CLA1, the second control signal CLB1, the third control signal CLA2, and the fourth control signal CLB2 may be supplied from the control circuit 180 (refer to FIG. 2) to the first demultiplexer DMX1 (refer to FIG. 6) and the second demultiplexer DMX2 (refer to FIG. 6) through the power output line POL (refer to FIG. 2).

The first control signal CLA1, the second control signal CLB1, the third control signal CLA2, and the fourth control signal CLB2 may be a square wave signal in which an on-voltage at which the first to fourth switches SW1, SW2, SW3, and SW4 may be turned on and an off-voltage at which the first to fourth switches SW1, SW2, SW3, and SW4 may be turned off are repeated. In an embodiment, the on-voltage of the first control signal CLA1, the second control signal CLB1, the third control signal CLA2, and the fourth control signal CLB2 may be a high-level voltage (first-level voltage), and the off-voltage of the first control signal CLA1, the second control signal CLB1, the third control signal CLA2, and the fourth control signal CLB2 may be a low-level voltage (second-level voltage).

The first control signal CLA1 and the second control signal CLB1 may have the same waveform but may be signals with shifted phases. The third control signal CLA2 and the fourth control signal CLB2 may have the same waveform but may be signals with shifted phases. In an embodiment, a timing at which voltage levels of the first control signal CLA1 and the second control signal CLB1 are inverted may be the same, for example. A period during which the on-voltage of the first control signal CLA1 is maintained (hereinafter, also referred to as "on-voltage period") may overlap a period during which the off-voltage of the second control signal CLB1 is maintained (hereinafter, also referred to as "off-voltage period"), and an off-voltage period of the first control signal CLA1 may overlap an on-voltage period of the second control signal CLB1.

The first control signal CLA1 and the third control signal CLA2 may have the same phase, and the second control signal CLB1 and the fourth control signal CLB2 may have the same phase. In an embodiment, the on-voltage period of the first control signal CLA1 may overlap an on-voltage period of the third control signal CLA2, and the off-voltage period of the first control signal CLA1 may overlap an off-voltage period of the third control signal CLA2, for example. The on-voltage period of the second control signal CLB1 may overlap an on-voltage period of the fourth control signal CLB2, and an off-voltage period of the second control signal CLB1 may overlap an off-voltage period of the fourth control signal CLB2.

In other words, the first switches SW1 and the third switches SW3 may be simultaneously turned on or off by the first control signal CLA1 and the third control signal CLA2, and the second switches SW2 and the fourth switches SW4 may be simultaneously turned on or off by the second control signal CLB1 and the fourth control signal CLB2.

During one frame, gate signals Gn-3, Gn-2, Gn-1, and Gn may be sequentially supplied with an on-voltage from the gate driving unit 130 (refer to FIG. 2) through the gate lines GLn-3, GLn-2, GLn-1 , and GLn. The gate signals Gn-3, Gn-2, Gn-1, and Gn may be gate control signals for controlling turn-on and turn-off of a data write transistor (e.g., the second transistor T2). The gate signals Gn-3, Gn-2, Gn-1, and Gn may be supplied with an on-voltage for turning on the data write transistor and an off-voltage for turning off the data write transistor. In an embodiment, the on-voltage of the gate signals Gn-3, Gn-2, Gn-1, and Gn may be a high-level voltage (first-level voltage), and the off-voltage of the gate signals Gn-3, Gn-2, Gn-1, and Gn may be a low-level voltage (second-level voltage).

An on-voltage period of the gate signals Gn-3, Gn-2, Gn-1, and Gn may be also referred to as a line time period LT. The line time period LT may be a time desired for the display apparatus 10 (refer to FIG. 1) to write the data signal DATA on the sub-pixels Ps (refer to FIG. 2) of one row (one line). In an embodiment, the line time period LT may be about 2 H. The line time period LT may include a first sub-line time period LT1 and a second sub-line time period LT2 that follows the first sub-line time period LT1. Each of the first and second sub-line time periods LT1 and LT2 may be about 1 H. For each of the sub-line time periods LT1 and LT2, the on-voltage of the first control signal CLA1 and the on-voltage of the second control signal CLB1 may be alternately supplied to the first demultiplexer DMX1, and the on-voltage of the third control signal CLA2 and the on-voltage of the fourth control signal CLB2 may be alternately supplied to the second demultiplexer DMX2.

During the first sub-line time period LT1 of a line time period of a row to which a gate signal is supplied (hereinafter referred to as "current line time period"), the first control signal CLA1 and the third control signal CLA2 may be supplied with an on-voltage, then the first control signal CLA1 and the third control signal CLA2 may transition to an off-voltage, and the second control signal CLB1 and the fourth control signal CLB2 may be supplied with an on-voltage. Similarly, during the second sub-line time period LT2, the first control signal CLA1 and the third control signal CLA2 may be supplied with an on-voltage, then the first control signal CLA1 and the third control signal CLA2 may transition to an off-voltage, and the second control signal CLB1 and the fourth control signal CLB2 may be supplied with an on-voltage. During the second sub-line time period LT2 of a current line time period, the data signal DATA corresponding to the sub-pixels Ps of a row where the gate signal is supplied with an on-voltage may be written.

The data driving unit 150 (refer to FIG. 2) may be synchronized with the control signals CLA1, CLB1, CLA2, and CLB2 and may supply the data signal DATA to each data output line.

In an embodiment, when the (n-3)^{th} gate signal Gn-3 is supplied to the (n-3)^{th} gate line GLn-3 during the line time period LT, the sub-pixels PR11, PG11, PB11, PR12, ..., PB14 connected to the (n-3)^{th} gate line GLn-3 may be selected, and the data driving unit 150 may output the data signals DATA<1>, DATA<2>, ..., DATA<6> to the data output lines OL1, OL2, ..., OL6, for example.

At each of the sub-line time periods LT1 and LT2, the first control signal CLA1 and the third control signal CLA2 may be supplied with an on-voltage, and then the second control signal CLB1 and the fourth control signal CLB2 may be supplied with an on-voltage. Sub-data signals supplied during the first sub-line time period LT1 may be sub-data signals of a previous line time period corresponding to a row to which a previous gate signal is supplied (previous line).

During the second sub-line time period LT2, the first control signal CLA1 may be supplied with an on-voltage to the first switches SW1 of the first demultiplexer DMX1, and the third control signal CLA2 may be supplied with an on-voltage to the third switches SW3 of the second demultiplexer DMX2. Accordingly, sub-data signals R11, G11, B11, R13, G13, and B13 of a current line time period may be supplied to the sub-pixels PR11, PG11, and PB11 connected to the data lines DL1, DL2, and DL3 to which the first switches SW1 are connected and the sub-pixels PR13, PG13, and PB13 connected to the data lines DL7, DL8, and DL9 to which the third switches SW3 are connected from among the sub-pixels PR11, PG11, PB11, PR12, ..., PB14 connected to the (n-3)^{th} gate line GLn-3.

Thereafter, second control signal CLB1 may be supplied with an on-voltage to the second switches SW2 of the first demultiplexer DMX1, and the fourth control signal CLB2 may be supplied with an on-voltage to the fourth switches SW4 of the second demultiplexer DMX2. Accordingly, sub-data signals R12, G12, B12, R14, G14, and B14 may be supplied to the sub-pixels PR12, PG12, and PB12 connected to the data lines DL4, DL5, and DL6 to which the second switches SW2 are connected and the sub-pixels PR14, PG14, and PB14 connected to the data lines DL10, DL11, and DL12 to which the fourth switches SW4 are connected from among the sub-pixels PR11, PG11, PB11, PR12, ..., PB14 connected to the (n-3)^{th} gate line GLn-3.

Sub-data signals of a previous line time period written on the sub-pixels Ps during the first sub-line time period LT1 may be overwritten by sub-data signals of a current line time period written on the sub-pixels Ps during the second sub-line time period LT2.

Similarly, when the (n-2)^{th} gate signal Gn-2 is supplied to the (n-2)^{th} gate line GLn-2 during the line time period LT, the sub-pixels PR21, PG21, PB21, PR22, ..., PB24 connected to the (n-2)^{th} gate line GLn-2 may be selected, and the data driving unit 150 may output the data signals DATA<1>, DATA<2>, ..., DATA<6> to the data output lines OL1, OL2, ..., OL6.

The first sub-line time period LT1 of the (n-2)^{th} gate signal Gn-2 may overlap the second sub-line time period LT2 of the (n-3)^{th} gate signal Gn-3. During the first sub-line time period LT1 of the (n-2)^{th} gate signal Gn-2, the first control signal CLA1 may be supplied with an on-voltage to the first switches SW1 of the first demultiplexer DMX1, and the third control signal CLA2 may be supplied with an on-voltage to the third switches SW3 of the second demultiplexer DMX2. Accordingly, sub-data signals R11, G11, B11, R13, G13, and B13 of a previous line time period may be supplied to the sub-pixels PR21, PG21, and PB21 connected to the data lines DL1, DL2, and DL3 to which the first switches SW1 are connected and the sub-pixels PR23, PG23, and PB23 connected to the data lines DL7, DL8, and DL9 to which the third switches SW3 are connected from among the sub-pixels PR21, PG21, PB21, PR22, ..., PB24 connected to the (n-2)^{th} gate line GLn-2 from among the sub-pixels PR21, PG21, PB21, PR22, ..., PB24 connected to the (n-2)th gate line GLn-2.

Thereafter, the second control signal CLB1 may be supplied to the second switches SW2 of the first demultiplexer DMX1, and the fourth control signal CLB2 may be supplied to the fourth switches SW4 of the second demultiplexer DMX2. Accordingly, the sub-data signals R12, G12, B12, R14, G14, and B14 of the previous line time period may be supplied to the sub-pixels PR22, PG22, and PB22 connected to the data lines DL4, DL5, and DL6 to which the second switches SW2 are connected and the sub-pixels PR24, PG24, and PB24 connected to the data lines DL10, DL11, and DL12 to which the fourth switches SW4 are connected.

During the second sub-line time period LT2 of the (n-2)^{th} gate signal Gn-2, the first control signal CLA1 may be supplied to the first switches SW1 of the first demultiplexer DMX1, and the third control signal CLA2 may be supplied to the third switches SW3 of the second demultiplexer DMX2. Accordingly, sub-data signals R21, G21, B21, R23, G23, and B23 of the current line time period may be supplied to the sub-pixels PR21, PG21, and PB21 connected to the data lines DL1, DL2, and DL3 to which the first switches SW1 are connected and the sub-pixels PR23, PG23, and PB23 connected to the data lines DL7, DL8, and DL9 to which the third switches SW3 are connected from among the sub-pixels PR21, PG21, PB21, PR22, ..., PB24 connected to the (n-2)^{th} gate line GLn-2.

Thereafter, the second control signal CLB1 may be supplied to the second switches SW2 of the first demultiplexer DMX1, and the fourth control signal CLB2 may be supplied to the fourth switches SW4 of the second demultiplexer DMX2. Accordingly, sub-data signals R22, G22, B22, R24, G24, and B24 of the current line time period may be supplied to the sub-pixels PR22, PG22, and PB22 connected to the data lines DL4, DL5, and DL6 to which the second switches SW2 are connected and the sub-pixels PR24, PG24, and PB24 connected to the data lines DL10, DL11, and DL12 to which the fourth switches SW4 are connected from among the sub-pixels PR21, PG21, PB21, PR22, ..., PB24 connected to the (n-2)^{th} gate line GLn-2.

In this manner, the data driving unit 150 may write data on all pixels PX during a single line time period LT.

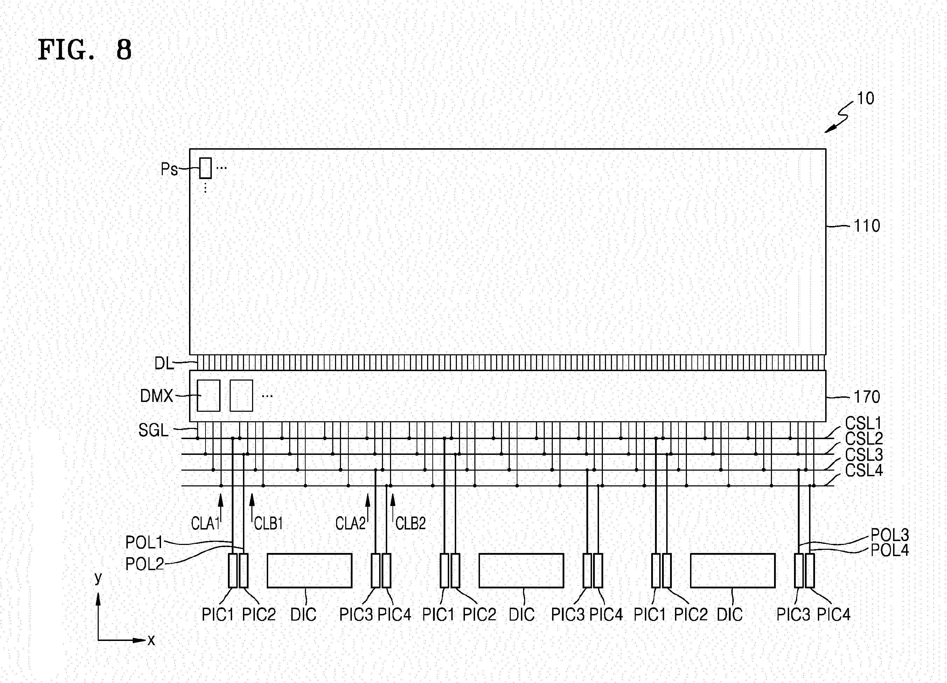

FIG. 8 is a diagram schematically illustrating an embodiment of a display apparatus 10.

Referring to FIG. 8, the display apparatus 10 may include the pixel unit 110, the data distribution unit 170, data driving circuits DIC, and power circuits PIC1, PIC2, PIC3, and PIC4. The data driving circuit DIC may be included in the data driving unit 150 shown in FIG. 2, and the power circuits PIC1, PIC2, PIC3, and PIC4 may be included in the control circuit 180 shown in FIG. 2.

The pixel unit 110 may include the plurality of sub-pixels Ps and the data line DL. Each of the plurality of sub-pixels Ps may be connected to a corresponding data line from among the plurality of data lines DL. The data lines DL may extend in the second direction (e.g., the y-axis direction) from the pixel unit 110 and may be connected to the data distribution unit 170.

The data distribution unit 170 may be connected between a plurality of data output lines and the plurality of data lines DL. For convenience of description, data output lines are omitted in FIG. 8. The data distribution unit 170 may include a plurality of sub-demultiplexers DMX each including two switches. As described with reference to FIG. 5, the sub-demultiplexers DMX may selectively connect one data output line to a pair of data lines according to the control signals CLA1, CLB1, CLA2, and CLB2.

The data distribution unit 170 may be connected to the data driving circuits DIC through the plurality of data output lines. As the display apparatus 10 has become larger, one display apparatus 10 may have a plurality of data driving circuits DIC. The data driving circuits DIC may be arranged spaced apart from each other in the first direction (e.g., the x-axis direction). The plurality of power circuits PIC1, PIC2, PIC3, and PIC4 may be arranged between the data driving circuits DIC.

The power circuits PIC1, PIC2, PIC3, and PIC4 may include first power circuits PIC1 which supply the first control signal CLA1, second power circuits PIC2 which supply the second control signal CLB1, third power circuits PIC3 which supply the third control signal CLA2, and fourth power circuits PIC4 which supply the fourth control signal CLB2. In an embodiment, the power circuits PIC1, PIC2, PIC3, and PIC4 may be power management ICs.

Control signal lines CSL1, CSL2, CSL3, and CSL4 extending in the first direction (e.g., the x-axis direction) may be arranged between the power circuits PIC1, PIC2, PIC3, and PIC4 and the data distribution unit 170. The first control signal line CSL1 may connect the first switches SW1 (refer to FIG. 6) to the first power circuits PIC1, the second control signal line CSL2 may connect the second switches SW2 (refer to FIG. 6) to the second power circuits PIC2, the third control signal line CSL3 may connect the third switch SW3 (refer to FIG. 6) to the third power circuits PIC3, and the fourth control signal line CSL4 may connect the fourth switches SW4 (refer to FIG. 6) to the fourth power circuits PIC4.

In an embodiment, the display apparatus 10 may include first power output lines POL1, second power output lines POL2, third power output lines POL3, and fourth power output lines POL4, for example. The first control signal line CSL1 may be connected to the first power circuits PIC1 through the first power output lines POL1, the second control signal line CSL2 may be connected to the second power circuits PIC2 through the second power output lines POL2, the third control signal line CSL3 may be connected to the third power circuits PIC3 through the third power output lines POL3, and the fourth control signal line CSL4 may be connected to the fourth power circuits PIC4 through the fourth power output lines POL4.

The first control signal CLA1 supplied from the first power circuits PIC1 and the third control signal CLA2 supplied from the third power circuits PIC3 may have the same waveform and the same phase, and the second control signal CLB1 supplied from the second power circuits PIC2 and the fourth control signal CLB2 supplied from the fourth power circuits PIC4 may have the same waveform and the same phase. Each of the control signal lines CSL1, CSL2, CSL3, and CSL4 may be connected to the data distribution unit 170 through control gate lines SGL.

By dividing control signals having the same waveform and the same phase into two control signal lines and applying the control signals, the capacitance of each line may be reduced by half. Thus, the load of each of the power circuits PIC1, PIC2, PIC3, and PIC4 may be reduced, and the slew rate of the control signals CLA1, CLB1, CLA2, and CLB2 may be improved.

In particular, when switches included in the sub-demultiplexers DMX are oxide thin-film transistors, the thin-film transistors have a relatively large channel capacitance, and thus, when the display apparatus has only two control signals as in the related art, an allowable current range of the power circuits may be exceeded. In embodiments, four control signal lines CSL1, CSL2, CSL3, and CSL4 are provided so that the data distribution unit 170 may be driven within the allowable current range of the power circuits PIC1, PIC2, PIC3, and PIC4.

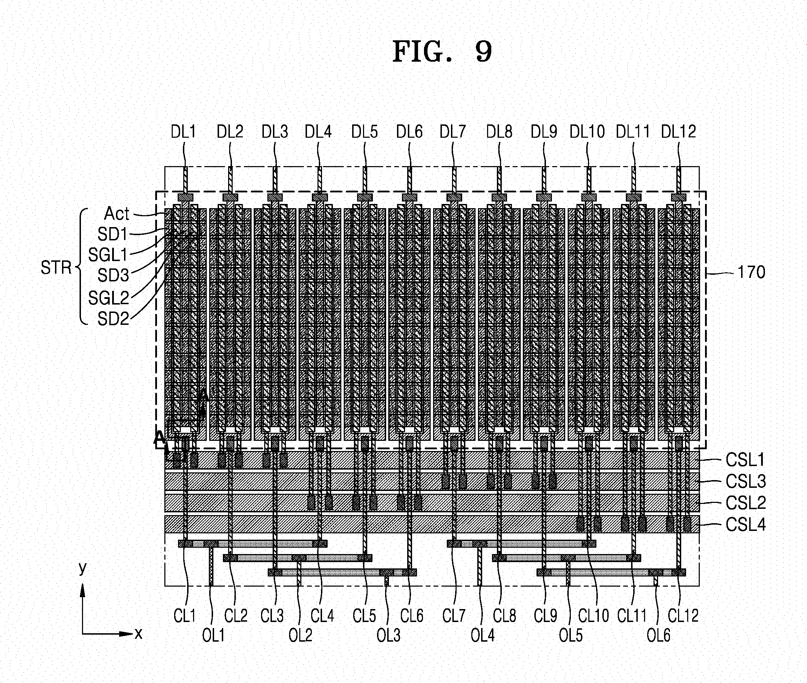

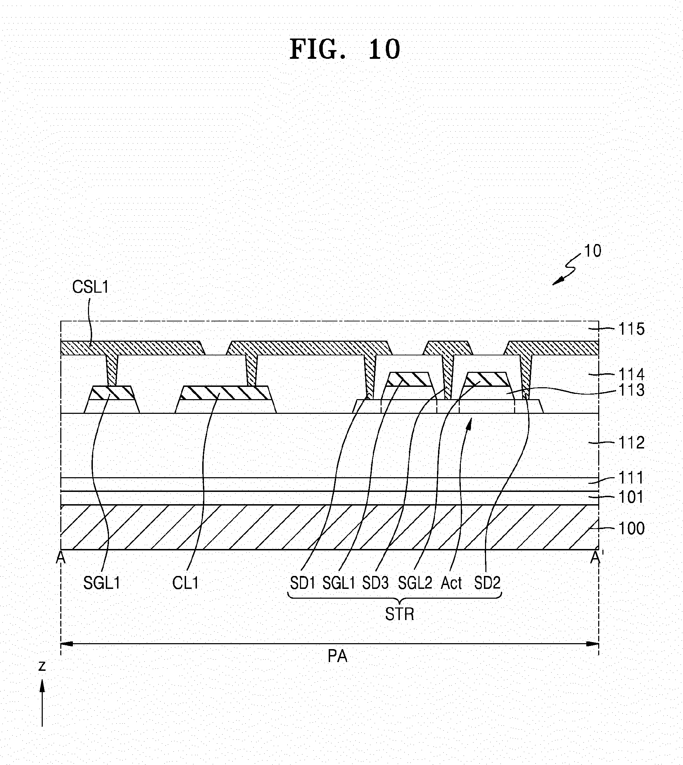

FIG. 9 is a layout diagram schematically illustrating an embodiment of the data distribution unit 170. FIG. 10 is a cross-sectional view schematically illustrating the display apparatus shown in FIG. 9, taken along line A-A'.

Referring to FIG. 9, the data distribution unit 170 may include a plurality of switch transistors STR. Each of the switch transistors STR may be any one of the first switch SW1, the second switch SW2, a third switch SW3, and a fourth switch SW4.

The control signal lines CSL1, CSL2, CSL3, and CSL4 extending in the first direction (e.g., the x-axis direction) may be arranged between the data distribution unit 170 and the data output lines OL1, OL2, ..., OL6. In other words, the control signal lines CSL1, CSL2, CSL3, and CSL4 extending in the first direction (e.g., the x-axis direction) may be arranged between the data output lines OL1, OL2, ..., OL6 and the first switch SW1, the second switch SW2, the third switch SW3, and the fourth switch SW4.

The first control signal line CSL1 may be connected to the first power circuits PIC1 (refer to FIG. 8), the second control signal line CSL2 may be connected to the second power circuits PIC2 (refer to FIG. 8), the third control signal line CSL3 may be connected to the third power circuits PIC3 (refer to FIG. 8), and the fourth control signal line CSL4 may be connected to the fourth power circuits PIC4 (refer to FIG. 8).

Each of the switch transistors STR may include a first terminal connected to a corresponding data line from among the data lines DL1, DL2, ..., DL12, a second terminal connected to a corresponding connection line from among the connection lines CL1, CL2, ..., CL12, and a gate connected to a corresponding control signal line from among the control signal lines CSL1, CSL2, CSL3, and CSL4. In an embodiment, each of the switch transistors STR may include a semiconductor layer Act, a first electrode SD1, a second electrode SD2, a first control gate line SGL1, a second control gate line SGL2, and a third electrode SD3.

The semiconductor layer Act may include an oxide-based semiconductor material. The oxide-based semiconductor material may include an oxide of at least one material of In, Ga, Sn, Zr, V, Hf, Cd, Ge, Cr, Ti, Al, Cs, Ce, and Zn. The oxide-based semiconductor material may be IGZO, ITZO, or IGTZO.

The first electrode SD1 and the second electrode SD2 may be disposed at opposite ends of the semiconductor layer Act, respectively. The first electrode SD1 and the second electrode SD2 may extend in the second direction (e.g., the y-axis direction) and may be arranged to be substantially parallel and spaced apart in the first direction (e.g., the x-axis direction). In an embodiment, the first electrode SD1 and the second electrode SD2 may be connected to each other at one end of the switch transistor STR and may be integrally provided as a single body. The first electrode SD1 and the second electrode SD2 may be connected to a corresponding connection line from among the connection lines CL1, CL2, ..., CL12 at one end of the switch transistor STR.

The third electrode SD3 may be disposed between the first electrode SD1 and the second electrode SD2. The third electrode SD3 may pass through a center of the semiconductor layer Act and extend in the second direction (e.g., the y-axis direction). The third electrode SD3 may be connected to a corresponding data line from among the data lines DL1, DL2, ..., DL12 at an opposite end of the switch transistor STR.

The first control gate line SGL1 may be disposed between the first electrode SD1 and the third electrode SD3, and the second control gate line SGL2 may be disposed between the third electrode SD3 and the second electrode SD2. Each of the first control gate line SGL1 and the second control gate line SGL2 may be one of the control gate lines SGL shown in FIG. 8. Each of the first control gate line SGL1 and the second control gate line SGL2 may extend in the second direction (e.g., the y-axis direction) and may be connected to a corresponding control signal line from among the control signal lines CSL1, CSL2, CSL3, and CSL4.

Each of the data output lines OL1, OL2, ..., OL6 may be connected to a pair of connection lines. A pair of connection lines connected to one data output line may be arranged to be spaced apart from each other with two columns interposed therebetween. In an embodiment, the first data output line OL1 may be connected to the first connection line CL1 and the fourth connection line CL4, the second data output line OL2 may be connected to the second connection line CL2 and the fifth connection line CL5, the third data output line OL3 may be connected to the third connection line CL3 and the sixth connection line CL6, the fourth data output lines OL4 may be connected to the seventh connection line CL7 and the tenth connection line CL10, the fifth data output line OL5 may be connected to the eighth connection line CL8 and the eleventh connection line CL11, and the sixth data output line OL6 may be connected to the ninth connection line CL9 and the twelfth connection line CL12, for example.

The connection lines CL1, CL2, ..., CL12 may correspond one-to-one with the data lines DL1, DL2, ..., DL12. One switch transistor STR may be disposed between each of the connection lines CL1, CL2, ..., CL12 and a corresponding data line.

The first control gate line SGL1 and the second control gate line SGL2 of each of the switch transistor STR between the first connection line CL1 and the first data line DL1 and the switch transistor STR between the second connection line CL2 and the second data line DL2, and the switch transistor STR between the third connection line CL3 and the third data line DL3 may be connected to the first control signal line CSL1. The first control gate line SGL1 and the second control gate line SGL2 of each of the switch transistor STR between the fourth connection line CL4 and the fourth data line DL4 and the switch transistor STR between the fifth connection line CL5 and the fifth data line DL5 and the switch transistor STR between the sixth connection line CL6 and the sixth data line DL6 may be connected to the second control signal line CSL2.

The first control gate line SGL1 and the second control gate line SGL2 of each of the switch transistor STR between the seventh connection line CL7 and the seventh data line DL7, the switch transistor STR between the eighth connection line CL8 and the eighth data line DL8 and the switch transistor STR between the ninth connection line CL9 and the ninth data line DL9 may be connected to the third control signal line CSL3. The first control gate line SGL1 and the second control gate line SGL2 of each of the switch transistor STR between the tenth connection line CL10 and the tenth data line DL10, the switch transistor STR between the eleventh connection line CL11 and the eleventh data line DL11, and the switch transistor STR between the twelfth connection line CL12 and the twelfth data line DL12 may be connected to the fourth control signal line CSL4.

In other words, the first control signal line CSL1 may transfer the first control signal CLA1 to the switch transistor STR between the first connection line CL1 and the first data line DL1, the switch transistor STR between the second connection line CL2 and the second data line DL2, and the switch transistor STR between the third connection line CL3 and the third data line DL3, and the second control signal line CSL2 may transfer the second control signal CLB1 to the switch transistor STR between the fourth connection line CL4 and the fourth data line DL4, the switch transistor STR between the fifth connection line CL5 and the fifth data line DL5, and the switch transistor STR between the sixth connection line CL6 and the sixth data line DL6.

The third control signal line CSL3 may transfer the third control signal CLA2 to the switch transistor STR between the seventh connection line CL7 and the seventh data line DL7, the switch transistor STR between the eighth connection line CL8 and the eighth data line DL8, and the switch transistor STR between the ninth connection line CL9 and the ninth data line DL9, and the fourth control signal line CSL4 may transfer the fourth control signal CLB2 to the switch transistor STR between the tenth connection line CL10 and the tenth data line DL10, the switch transistor STR between the eleventh connection line CL11 and the eleventh data line DL11, and the switch transistor STR between the twelfth connection line CL12 and the twelfth data line DL12.

As described above, by dividing control signals having the same waveform and the same phase into two different control signal lines and applying the control signals, the capacitance of each line may be reduced by half.

Referring to FIG. 10, the display apparatus 10 may include the substrate 100.

The switch transistor STR, the first control signal line CSL1, and the first connection line CL1 may be disposed in the peripheral area PA. The switch transistor STR shown in FIG. 10 may be the switch transistor STR between the first connection line CL1 and the first data line DL1. This may be applied to other switch transistors STR having the same or similar structure.

The barrier layer 101, the first buffer layer 111, and the second buffer layer 112 may be sequentially stacked on the substrate 100. The semiconductor layer Act of the switch transistor STR may be disposed on the second buffer layer 112.

The gate insulating layer 113 may be disposed on the second buffer layer 112 and the semiconductor layer Act. The first connection line CL1, the first control gate line SGL1, and the second control gate line SGL2 may be disposed on the gate insulating layer 113 to be spaced apart from one another. The first control gate line SGL1 and the second control gate line SGL2 may be disposed on the semiconductor layer Act, and the gate insulating layer 113 may be disposed between the semiconductor layer Act and the first control gate line SGL1 and the second control gate line SGL2. The gate insulating layer 113 may be patterned to have a shape corresponding to a conductive layer disposed on the gate insulating layer 113.

In a plan view, the semiconductor layer Act overlapping the first control gate line SGL1 and the second control gate line SGL2 may function as a channel region. Impurity areas may be arranged with the channel region of the semiconductor layer Act therebetween. Each of the impurity areas may be a source region or a drain region. In an embodiment, each of the first connection line CL1, the first control gate line SGL1, and the second control gate line SGL2 may include Mo, Al, Cu, Ti, or the like, and may have a layer or layers. The first connection line CL1, the first control gate line SGL1, and the second control gate line SGL2 may be disposed in the same layer as the first upper gate electrode G11 of the first thin-film transistor TFT1 shown in FIG. 4A is disposed.

The inter-insulating layer 114 may be disposed on the first connection line CL1, the first control gate line SGL1, and the second control gate line SGL2. The first control signal line CSL1, the first electrode SD1, the second electrode SD2, and the third electrode SD3 may be disposed on the inter-insulating layer 114. The first electrode SD1 and the second electrode SD2 may be disposed on the first control gate line SGL1 and the second control gate line SGL2 with the inter-insulating layer 114 therebetween.

The first control signal line CSL1, the first electrode SD1, the second electrode SD2, and the third electrode SD3 may include a conductive material, including Mo, Al, Cu, Ti, or the like, and may include or consist of a layer or layers including the materials described above. In an embodiment, the first control signal line CSL1, the first electrode SD1, the second electrode SD2, and the third electrode SD3 may be arranged in the same layer as the first connection electrode 134 shown in FIGS. 4A and 4B is disposed.

The first control signal line CSL1 may be connected to the first control gate line SGL1 through a contact hole passing through the inter-insulating layer 114. Although not shown in FIG. 10, the first control signal line CSL1 may be connected to the second control gate line SGL2 through a contact hole passing through the inter-insulating layer 114.

The first electrode SD1 and the second electrode SD2 may be connected to opposite ends of the semiconductor layer Act, respectively. The first electrode SD1 may be connected to the first connection line CL1 and one end of the semiconductor layer Act through a contact hole passing through the inter-insulating layer 114. The second electrode SD2 may be connected to the first connection line CL1 and an opposite end of the semiconductor layer Act through a contact hole passing through the inter-insulating layer 114. The first electrode SD1 and the second electrode SD2 may be integrally provided as a single body.

The third electrode SD3 may be disposed between the first electrode SD1 and the second electrode SD2. As shown in FIG. 9, the third electrode SD3 may be connected to the first data line DL1.

The switch transistor STR may be turned on or off depending on the first control signal CLA1 transferred from the first control signal line CSL1 to the first control gate line SGL1 and the second control gate line SGL2. When the switch transistor STR is turned on, a data signal output to the first data output line OL1 may be transferred from the first connection line CL1 to the first data line DL1 through the switch transistor STR.

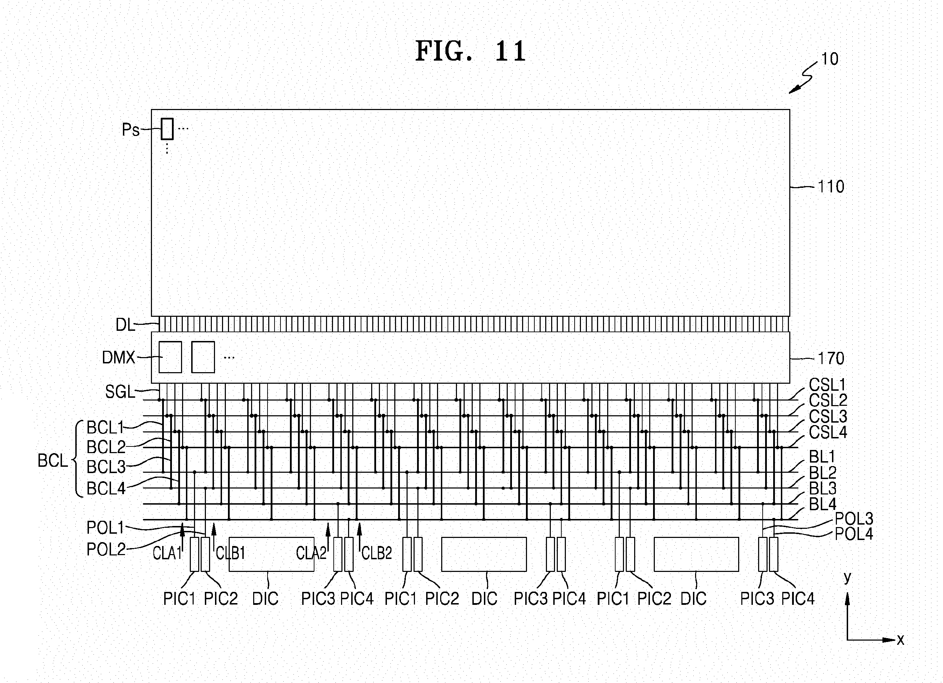

FIG. 11 is a diagram schematically illustrating an embodiment of the display apparatus 10. Although FIG. 11 is similar to FIG. 8, there is a difference in that, in the former, the display apparatus 10 further includes bridge lines BL1, BL2, BL3, and BL4 between the control signal lines CSL1, CSL2, CSL3, and CSL4 and the power circuits (or, control circuits) PIC1, PIC2, PIC3, and PIC4. Hereinbelow, descriptions of the same or similar configurations are omitted and differences are mainly described.

Referring to FIG. 11, the display apparatus 10 may include the pixel unit 110, the data distribution unit 170, the data driving circuits DIC, and the power circuits PIC1, PIC2, PIC3, and PIC4, the pixel unit 110 including the sub-pixels Ps and the data lines DL, and the data distribution unit 170 including the sub-demultiplexers DMX. The data driving circuit DIC may be included in the data drivinig unit 150 shown in FIG. 2, and the power circuits PIC1, PIC2, PIC3, and PIC4 may be included in the control circuit 180 shown in FIG. 2.

The data lines DL may extend in the second direction (e.g., the y-axis direction) from the pixel unit 110 and may be connected to the data distribution unit 170. The data distribution unit 170 may be connected between data output lines (not shown) and the data lines DL. The data distribution unit 170 may be connected to the data driving circuits DIC through the data output lines.

The data driving circuits DIC may be arranged spaced apart from each other in the first direction (e.g., the x-axis direction). The plurality of power circuits PIC1, PIC2, PIC3, and PIC4 may be arranged between the data driving circuits DIC.

The power circuits PIC1, PIC2, PIC3, and PIC4 may include the first power circuits PIC1 which supply the first control signal CLA1, the second power circuits PIC2 which supply the second control signal CLB1, the third power circuits PIC3 which supply the third control signal CLA2, and the fourth power circuits PIC4 which supply the fourth control signal CLB2.

The control signal lines CSL1, CSL2, CSL3, and CSL4 extending in the first direction (e.g., the x-axis direction) may be arranged between the power circuits PIC1, PIC2, PIC3, and PIC4 and the data distribution unit 170. The bridge lines BL1, BL2, BL3, and BL4 extending in the first direction (e.g., the x-axis direction) may be arranged between the control signal lines CSL1, CSL2, CSL3, and CSL4 and the power circuits PIC1, PIC2, PIC3, and PIC4.

Each of the bridge lines BL1, BL2, BL3, and BL4 may connect the power circuits PIC1, PIC2, PIC3, and PIC4 to a corresponding control signal line from among the control signal lines CSL1, CSL2, CSL3, and CSL4. In an embodiment, the first bridge line BL1 may connect the first power circuits PIC1 to the first control signal line CSL1, the second bridge line BL2 may connect the second power circuits PIC2 to the second control signal line CSL2, the third bridge line BL3 may connect the third power circuits PIC3 to the third control signal line CSL3, and the fourth bridge line BL4 may connect the fourth power circuits PIC4 to the fourth control signal line CSL4, for example.

In an embodiment, the display apparatus 10 may include the first power output line POL1, the second power output line POL2, the third power output lines POL3, and the fourth power output line POL4 extending in the second direction (e.g., the y-axis direction), for example. The first power output lines POL1 may connect the first bridge line BL1 to the first power circuits PIC1, the second power output lines POL2 may connect the second bridge line BL2 to the second power circuits PIC2, the third power output lines POL3 may connect the third bridge line BL3 to the third power circuits PIC3, and the fourth power output lines POL4 may connect the fourth bridge line BL4 to the fourth power circuits PIC4.

The display apparatus 10 may include a first bridge connection line BCL1, a second bridge connection line BCL2, a third bridge connection line BCL3, and a fourth bridge connection line BCL4, which extend in the second direction (e.g., the y-axis direction). Each of the bridge lines BL1, BL2, BL3, and BL4 may be connected to a corresponding control signal line through a corresponding bridge connection line from among the first to fourth bridge connection lines BCL1, BCL2, BCL3 and BCL4. The first bridge connection line BCL1 may connect the first bridge line BL1 to the first control signal line CSL1, the second bridge connection line BCL2 may connect the second bridge line BL2 to the second control signal line CSL2, the third bridge connection line BCL3 may connect the third bridge line BL3 to the third control signal line CSL3, and the fourth bridge connection line BCL4 may connect the fourth bridge line BL4 to the fourth control signal line CSL4.

The number of first bridge connection lines BCL1 may be greater than the number of first power output lines POL1, the number of second bridge connection lines BCL2 may be greater than the number of second power output lines POL2, the number of third bridge connection lines BCL3 may be greater than the number of third power output lines POL3, and the number of fourth bridge connection lines BCL4 may be greater than the number of fourth power output lines POL4.

Each of the control signal lines CSL1, CSL2, CSL3, and CSL4 may be connected to the data distribution unit 170 through control gate lines SGL.

The first control signal CLA1 supplied from the first power circuits PIC1 and the third control signal CLA2 supplied from the third power circuits PIC3 may have the same waveform and the same phase, and the second control signal CLB1 supplied from the second power circuits PIC2 and the fourth control signal CLB2 supplied from the fourth power circuits PIC4 may have the same waveform and the same phase.

In a comparative example, when power circuits are directly connected to control signal lines, control signals in an area (hereinafter, "edge area") adjacent to an input point to which power output lines are connected have a relatively high slew rate, whereas control signals in an area (hereinafter, "center area") far from the input point to which the power output lines are connected may have a relatively low slew rate.

As shown in FIG. 11, when the control signal lines CSL1, CSL2, CSL3, and CSL4 are connected to the power circuits PIC1, PIC2, PIC3, and PIC4 through the bridge lines BL1, BL2, BL3, and BL4, the capacitance of the bridge lines BL1, BL2, BL3, and BL4 is relatively low, and thus, the slew rate of the control signals in the center area may be improved. In addition, because the number of bridge connection lines BCL is greater than the number of power output lines POL, input points of each of the control signals increase, thereby reducing a slew deviation between the control signal in the center area and the control signal in the edge area.

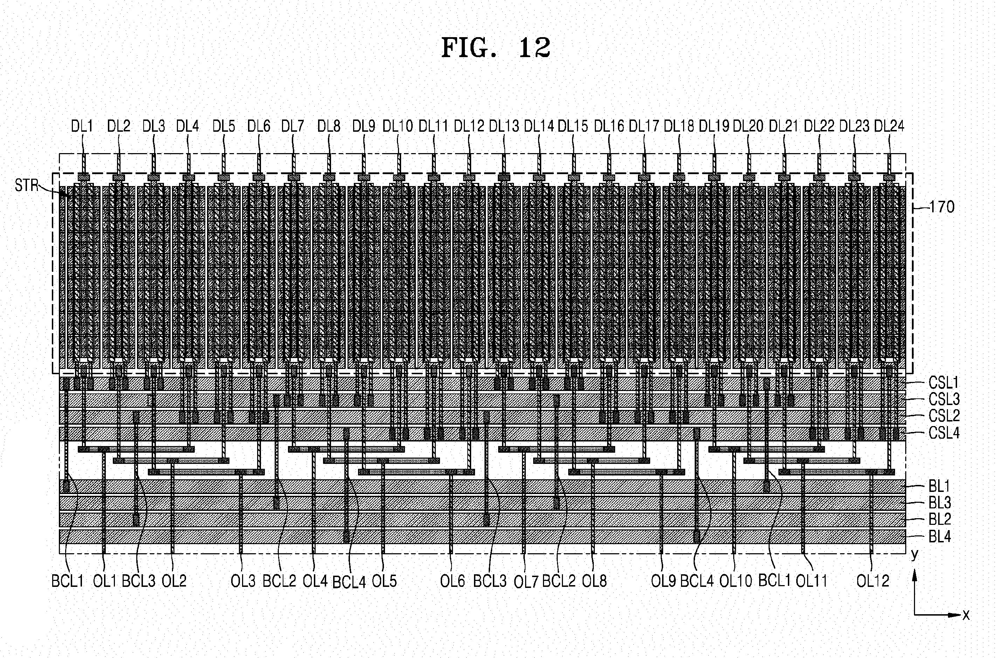

FIG. 12 is a layout diagram schematically illustrating an embodiment of a data distribution unit 170. Although FIG. 12 is similar to FIG. 9, there is a difference in that, in the former, the display apparatus 10 further includes the bridge lines BL1, BL2, BL3, and BL4 between the control signal lines CSL1, CSL2, CSL3, and CSL4 and the data output lines OL1, OL2, ..., OL12. Hereinbelow, descriptions of the same or similar configurations are omitted and differences are mainly described.

Referring to FIG. 12, the data distribution unit 170 may include a plurality of switch transistors STR. Each of the switch transistors STR may be any one of the first switch SW1, the second switch SW2, the third switch SW3, and the fourth switch SW4.

The control signal lines CSL1, CSL2, CSL3, and CSL4 extending in the first direction (e.g., the x-axis direction) may be arranged between the data distribution unit 170 and the data output lines OL1, OL2, ..., OL12. The bridge lines BL1, BL2, BL3, and BL4 extending in the first direction (e.g., the x-axis direction) may be arranged between the control signal lines CSL1, CSL2, CSL3, and CSL4 and the data output lines OL1, OL2, ..., OL12.

The first bridge line BL1 may be connected to the first power circuits PIC1 (refer to FIG. 11), the second bridge line BL2 may be connected to the second power circuits PIC2 (refer to FIG. 11), the third bridge line BL3 may be connected to the third power circuits PIC3 (refer to FIG. 11), and the fourth bridge line BL4 may be connected to the fourth power circuits PIC4 (refer to FIG. 11). Because the bridge lines BL1, BL2, BL3, and BL4 are spaced apart from the switch transistors STR, a less load than the control signal lines CSL1, CSL2, CSL3, and CSL4 may be applied thereto.

The first bridge line BL1 may be connected to the first control signal line CSL1 through the first bridge connection lines BCL1, the second bridge line BL2 may be connected to the second control signal line CSL2 through the second bridge connection lines BCL2, the third bridge line BL3 may be connected to the third control signal line CSL3 through the third bridge connection lines BCL3, and the fourth bridge line BL4 may be connected to the fourth control signal line CSL4 through the fourth bridge connection lines BCL4.

In FIG. 12, the first bridge connection lines BCL1, the second bridge connection lines BCL2, the third bridge connection electrodes BCL3, and the fourth bridge connection lines BCL4 each include two bridge connection lines. However, embodiments of the disclosure are not limited thereto. The number and arrangement of the first bridge connection line BCL1, the second bridge connection line BCL2, the third bridge connection line BCL3, and the fourth bridge connection line BCL4 may be designed in various ways.

As the first bridge connection lines BCL1, the second bridge connection lines BCL2, the third bridge connection lines BCL3, and the fourth bridge connection lines BCL4 are each provided in plural, input points of control signals in the control signal lines CSL1, CSL2, CSL3, and CSL4 increases, thereby improving a slew deviation between the control signal in the center area and the control signal in the edge area in each of the control signal lines CSL1, CSL2, CSL3, and CSL4.

Each of the data output lines OL1, OL2, ..., OL12 may be connected to a pair of connection lines. A pair of connection lines connected to one data output line may be arranged to be spaced apart from each other with two columns interposed therebetween. The connection lines may correspond one-to-one with the data lines DL1, DL2, ..., DL24. One switch transistor STR may be disposed between each of the connection lines and a corresponding data line.

Each of the switch transistors STR may include a third electrode connected to data lines DL1, DL2, ..., DL24, a first electrode and a second electrode, which are connected to the connection lines, and a first control gate line and a second control gate line, which are connected to the control signal lines CSL1, CSL2, CSL3, and CSL4.

The first bridge line BL1 may transfer the first control signal CLA1 to the first control signal line CSL1 through the first bridge connection lines BCL1, the second bridge line BL2 may transfer the second control signal CLB1 to the second control signal line CSL2 through the second bridge connection lines BCL2, the third bridge line BL3 may transfer the third control signal CLA2 to the third control signal line CSL3 through the third bridge connection lines BCL3, and the fourth bridge line BL4 may transfer the fourth control signal CLB2 to the fourth control signal line CSL4 through the fourth bridge connection lines BCL4.

The switch transistors STR connected to the first control signal line CSL1 may connect the data lines DL1, DL2, DL3, DL13, DL14, and DL15 to the corresponding data output lines OL1, OL2, OL3, OL7, OL8, and OL9 in response to the first control signal CLA1. The switch transistors STR connected to the second control signal line CSL2 may connect the data lines DL4, DL5, DL6, DL16, DL17, and DL18 to the data output lines OL1, OL2, OL3, OL7, OL8, and OL9 in response to the second control signal CLB1. The switch transistors STR connected to the third control signal line CSL3 may connect the data lines DL7, DL8, DL9, DL19, DL20, and DL21 to the data output lines OL4, OL5, OL6, OL10, OL11, and OL12 in response to the third control signal CLA2. The switch transistors STR connected to the fourth control signal line CSL4 may connect the data lines DL10, DL11, DL12, DL22, DL23, and DL24 to the data output lines OL4, OL5, OL6, OL10, OL11, and OL12 in response to the fourth control signal CLB2.

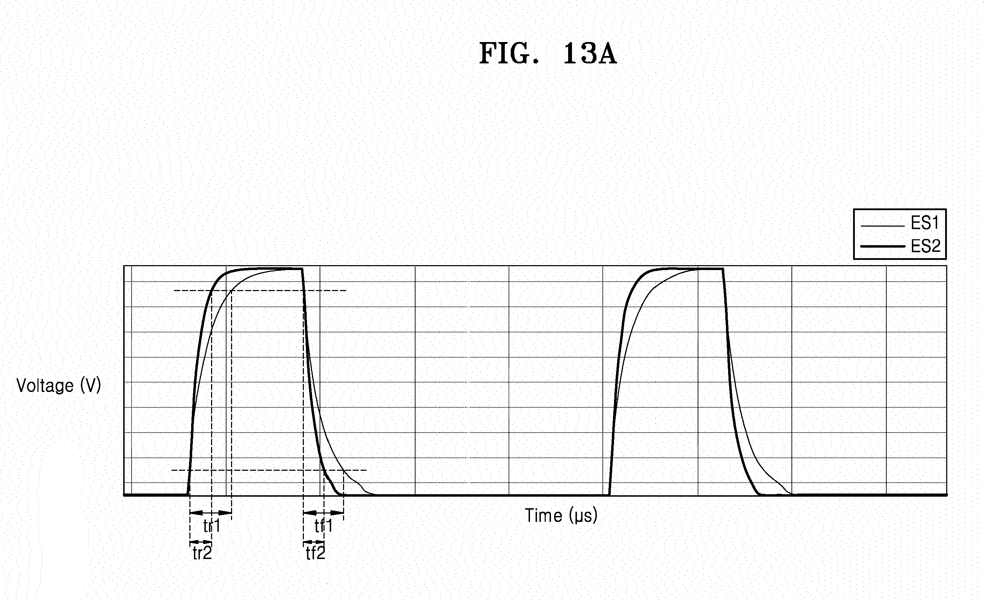

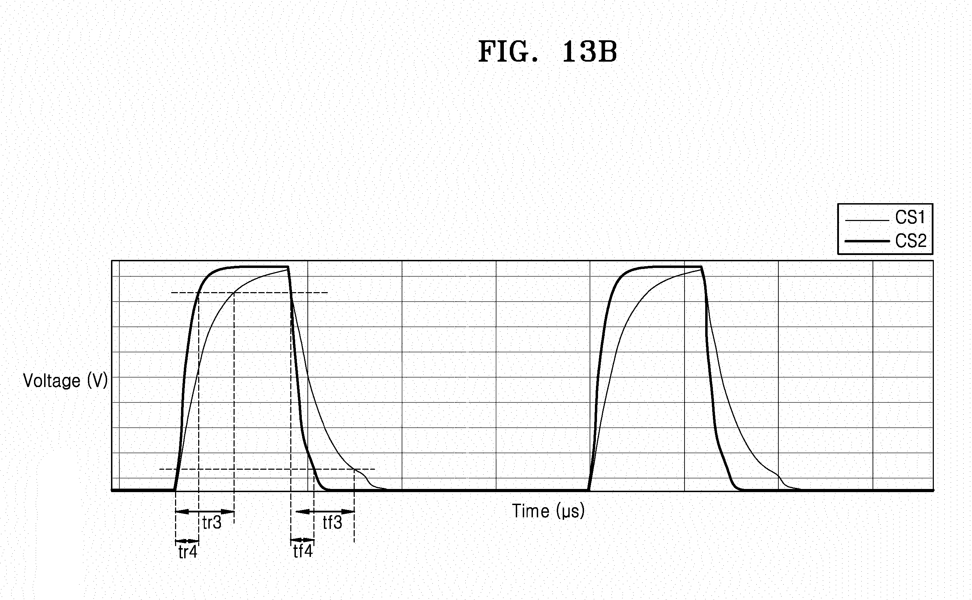

FIGS. 13A and 13B are graphs showing a control signal of a display apparatus according to the Comparative Example and a control signal of a display apparatus according to an Embodiment.

In FIG. 13A, a first signal ES1 is a control signal measured in an edge area of a control signal line of the display apparatus according to the Comparative Example, and a second signal ES2 is a control signal measured in an edge area of a first control signal line of the display apparatus according to the Embodiment. In FIG. 13B, a third signal CS1 is a control signal measured in a center area of a control signal line of the display apparatus according to the Comparative Example, and a fourth signal CS2 is a control signal measured in a center area of a first control signal line of the display apparatus according to the Embodiment.

The display apparatus according to the Comparative Example includes only two control signal lines, and the data distribution unit may include only first switches and second switches, which are respectively connected to the first control signal line and the second control signal line.

As shown in FIG. 11, the display apparatus in an embodiment includes four control signal lines CSL1, CSL2, CSL3, and CSL4 and four bridge lines BL1, BL2, BL3, and BL4, and the data distribution unit 170 includes first switches connected to the first control signal line CSL1, second switches connected to the second control signal line CSL2, third switches connected to the third control signal line CSL3, and fourth switches connected to the fourth control signal line CSL4.

Referring to FIGS. 13A and 13B, a rising time tr1 of the first signal ES1 is longer than a rising time tr2 of the second signal ES2, and a falling time tf1 of the first signal ES1 is longer than a falling time tf2 of the second signal ES2. Similarly, a rising time tr3 of the third signal CS1 is longer than a rising time tr4 of the fourth signal CS2, and a falling time tf3 of the third signal CS1 is longer than a falling time tf4 of the fourth signal CS2.

In addition, a difference between the rising time tr2 of the second signal ES2 and the rising time tr4 of the fourth signal CS2 is reduced compared to a difference between the rising time tr1 of the first signal ES1 and the rising time tr3 of the third signal CS1, and a difference between the falling time tf2 of the second signal ES2 and the falling time tf4 of the fourth signal CS2 is reduced compared to a difference between the falling time tf1 of the first signal ES1 and the falling time tf3 of the third signal CS1.

In other words, it was confirmed that, in the display apparatus in an embodiment, a slew rate of control signals is improved, and that a slew deviation between the control signal in an edge area of a control signal line and a control signal in a center area of the control signal line is reduced.

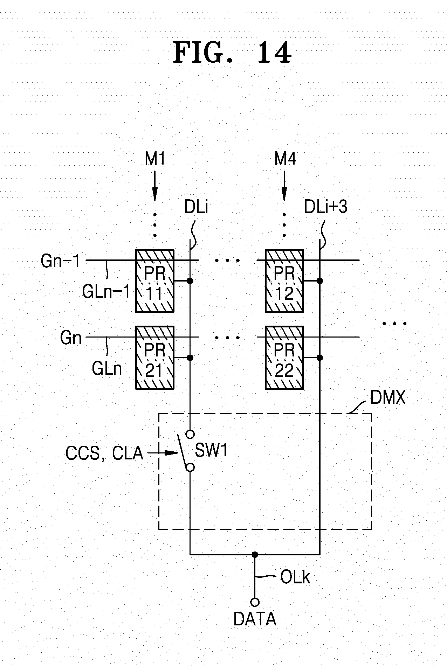

FIG. 14 is a diagram for describing an embodiment of the sub-demultiplexer DMX. FIG. 14 is similar to FIG. 5, but differs in that the sub-demultiplexer DMX includes only one switch.

Referring to FIG. 14, the sub-demultiplexer DMX may selectively connect the k^{th} data output line OLk to the pair of i^{th} data line DLi and (i+3)^{th} data line DLi+3. The sub-demultiplexer DMX may include only the first switch SW1.

The i^{th} data line DLi and the (i+3)^{th} data line DLi+3 may be data lines arranged to be spaced apart from each other with two columns interposed therebetween. In an embodiment, an (i+1)th data line and an (i+2)th data line may be arranged between the ith data line DLi and the (i+3)th data line DLi+3, for example. The i^{th} data line DLi may be connected to sub-pixels in the i^{th} column (annotated by M1, for example), and the (i+3)^{th} data line DLi+3 may be connected to sub-pixels in an (i+3)^{th} column (annotated by M4, for example).

The first switch SW1 may be provided between the k^{th} data output line OLk and the i^{th} data line DLi. The first switch SW1 may connect the k^{th} data output line OLk to the i^{th} data line DLi by a first control signal CLA and may apply the data signal DATA applied via the k^{th} data output line OLk to the i^{th} data line DLi.

The sub-demultiplexer DMX may connect the k^{th} data output line OLk to the (i+3)^{th} data line DLi+3. In other words, no switch is provided between the k^{th} data output line OLk and the (i+3)^{th} data line DLi+3, and the data signal DATA applied to the k^{th} data output line OLk may be applied to the (i+3)^{th} data line DLi+3, regardless of the control signal CCS.

In an embodiment, the sub-pixels connected to i^{th} data line DLi and the (i+3)^{th} data line DLi+3 may emit light of the same color. Regarding this, FIG. 14 shows that the sub-pixels connected to the i^{th} data line DLi and the (i+3)^{th} data line DLi+3 are red sub-pixels PR emitting red light. However, embodiments of the disclosure are not limited thereto. Connections between data lines and sub-pixels may be modified in various ways.

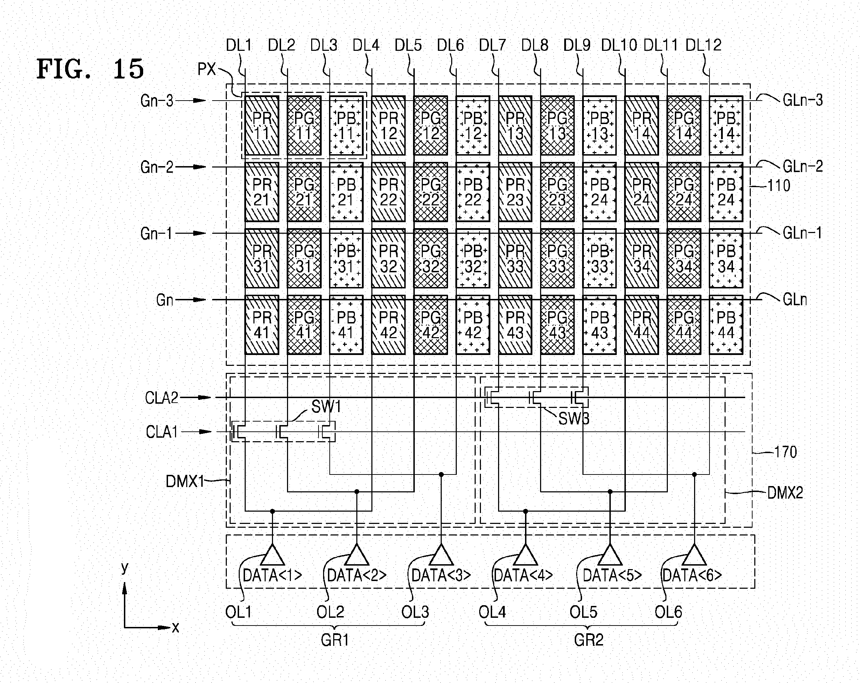

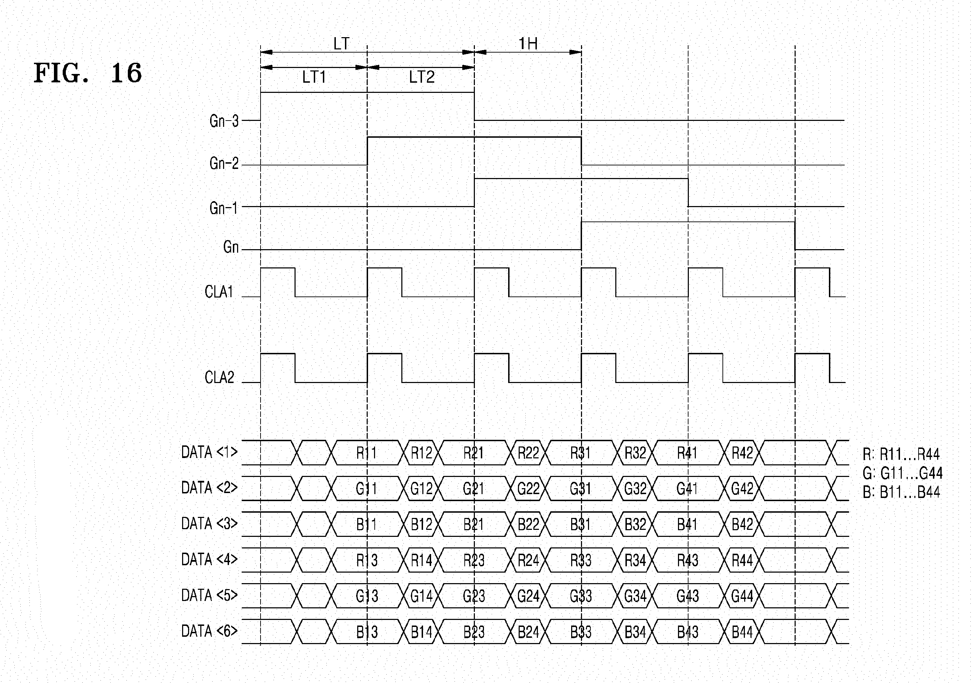

FIG. 15 is a diagram schematically illustrating an embodiment of a display apparatus. FIG. 16 is a timing diagram for describing an operation of the display apparatus shown in FIG. 15.

Referring to FIG. 15, the data distribution unit 170 may include the first demultiplexer DMX1 and the second demultiplexer DMX2, and the pixel unit 110 may include the plurality of pixels PX. The pixel PX may include the red sub-pixel PR, the green sub-pixel PG, and the blue sub-pixel PB.

In the pixel unit 110, a column in which the red sub-pixels PR are arranged in a second direction (e.g., a y-axis direction), a column in which the green sub-pixels PG are arranged in the second direction (e.g., the y-axis direction), and a column in which the blue sub-pixels PB are arranged in the second direction (e.g., the y-axis direction) may be alternately repeated in a first direction (e.g., an x-axis direction).

In an embodiment, in the first row, a first pixel, a second pixel, a third pixel, and a fourth pixel may be sequentially arranged in the first direction (e.g., the x-axis direction), the first pixel may include three sub-pixels PR11, PG11, and PB11 in first to third columns, the second pixel may include three sub-pixels PR12, PG12, and PB12 in fourth to sixth columns, the third pixel may include three sub-pixels PR13, PG13, and PB13 in seventh to ninth columns, and the fourth pixel may include three sub-pixels PR14, PG14, and PB14 in tenth to twelfth columns, for example.

The plurality of data lines DL1, DL2, ..., DL12 and the plurality of gate lines GLn-3, GLn-2, GLn-1, and GLn may be arranged in the pixel unit 110. The plurality of gate lines GLn-3, GLn-2, GLn-1, and GLn may be the gate line (e.g., GL1, GL2, ..., GLn) shown in FIG. 2 or the first gate line GWL shown in FIGS. 3A and 3B.

One gate line may be connected to sub-pixels arranged in the same row (line). One data line may be connected to sub-pixels arranged in the same column. The sub-pixels connected to the ith data line DLi and the sub-pixels connected to the (i+3)^{th} data line DLi+3 may be sub-pixels emitting light of the same color. For convenience of description, FIG. 15 shows only twelve data lines DL1, DL2, ..., DL12, four gate lines GLn-3, GLn-2, GLn-1, and GLn, and six data output lines OL1, OL2, ..., OL6. However, the number of data lines, the number of gate lines, and the number of data output lines may be greater.

The first demultiplexer DMX1 may selectively connect the data output lines OL1, OL2, and OL3 belonging to a first group GR1 to first to sixth data lines DL1, DL2, ..., and DL6, and the second demultiplexer DMX2 may selectively connect data output lines OL4, OL5, and OL6 belonging to a second group GR2 to seventh to twelfth data lines DL7, DL8, ..., and DL12.

Each of the first demultiplexer DMX1 and the second demultiplexer DMX2 may include the plurality of sub-demultiplexers DMX (refer to FIG. 14). One sub-demultiplexer DMX may selectively connect one data output line to a pair of data lines. A pair of data lines connected to one sub-demultiplexer DMX may be spaced apart from each other with two columns interposed therebetween.

In an embodiment, a pair of data lines connected to the first data output line OL1 belonging to the first group GR1 may be the first data line DL1 and the fourth data line DL4, for example. The first data line DL1 may be connected to the red sub-pixel PR11 of the first pixel, and the fourth data line DL4 may be connected to the red sub-pixel PR12 of the second pixel.

A pair of data lines connected to the fourth data output lines OL4 belonging to the second group GR2 may be the seventh data line DL7 and the tenth data line DL10. The seventh data line DL7 may be connected to the red sub-pixel PR13 of the third pixel, and the tenth data line DL10 may be connected to the red sub-pixel PR14 of the fourth pixel.

The first demultiplexer DMX1 may include the first switches SW1. Each of the first switches SW1 may be provided between the first data output line OL1 and the first data line DL1, between the second data output line OL2 and the second data line DL2, and between the third data output line OL3 and the third data line DL3. The first switches SW1 may be turned on by a first control signal CLA1 and may connect the first data output line OL1 to the first data line DL1, the second data output line OL2 to the second data line DL2, and the third data output line OL3 to the third data line DL3.

The first demultiplexer DMX1 may connect the first data output line OL1 to the fourth data line DL4, the second data output line OL2 to the fifth data line DL5, and the third data output line OL3 to the sixth data line DL6, regardless of the first and third control signals CLA1 and CLA2.

The first data signal DATA<1> applied to the first data output line OL1 may include first subdata signals R applied to the red sub-pixel PR, the second data signal DATA<2> applied to the second data output line OL2 may include second subdata signals G applied to the green sub-pixels PG, and the third data signal DATA<3> applied to the third data output line OL3 may include third subdata signals B applied to the blue sub-pixels PB.

The second demultiplexer DMX2 may include the third switches SW3. Each of the third switches SW3 may be provided between the fourth data output lines OL4 and the seventh data line DL7, between the fifth data output line OL5 and the eighth data line DL8, and between the sixth data output line OL6 and the ninth data line DL9. The third switches SW3 may be turned on by a third control signal CLA2 and may connect the fourth data output lines OL4 to the seventh data line DL7, the fifth data output line OL5 to the eighth data line DL8, and the sixth data output line OL6 to the ninth data line DL9.

The second demultiplexer DMX2 may connect the fourth data output lines OL4 to the tenth data line DL10, the fifth data output line OL5 to the eleventh data line DL11, and the sixth data output line OL6 to the twelfth data line DL12, regardless of the first and third control signals CLA1 and CLA2.

The fourth data signal DATA<4> applied to the fourth data output lines OL4 may include the first subdata signals R applied to the red sub-pixel PR, the fifth data signal DATA<5> applied to the fifth data output line OL5 may include the second subdata signals G applied to the green sub-pixels PG, and the sixth data signal DATA<6> applied to the sixth data output line OL6 may include the third subdata signals B applied to the blue sub-pixels PB.

FIG. 16 shows an order of data signals applied by a data driving unit 150 (refer to FIG. 2) to sub-pixels through data output lines. Hereinbelow, when it is described that an arbitrary signal is supplied or output, it may mean that an on voltage of the signal is supplied.

Referring to FIGS. 15 and 16 together, the first control signal CLA1 and the third control signal CLA2 may be supplied from the control circuit 180 (refer to FIG. 2) to the first demultiplexer DMX1 and the second demultiplexer DMX2 through the power output line POL (refer to FIG. 2).

Each of the first control signal CLA1 and the third control signal CLA2 may be a square wave signal in which an on-voltage at which the first switches SW1 and the second switches SW2 may be turned on and an off-voltage at which the first switches SW1 and the second switches SW2 may be turned off are repeated. In an embodiment, the on-voltage of the first control signal CLA1 and the third control signal CLA2 may be a high-level voltage (first-level voltage), and the off-voltage of the first control signal CLA1 and the third control signal CLA2 may be a low-level voltage (second-level voltage).

The first control signal CLA1 and the third control signal CLA2 may have the same phase. In an embodiment, the on-voltage period of the first control signal CLA1 may overlap an on-voltage period of the third control signal CLA2, and the off-voltage period of the first control signal CLA1 may overlap an off-voltage period of the third control signal CLA2, for example. In other words, the first switches SW1 and the third switches SW3 may be simultaneously turned on or off according to the first control signal CLA1 and the third control signal CLA2.

During one frame, the gate signals Gn-3, Gn-2, Gn-1, and Gn may be sequentially supplied from the gate driving unit 130 (refer to FIG. 2) through the gate lines GLn-3, GLn-2, GLn-1, and GLn. The gate signals Gn-3, Gn-2, Gn-1, and Gn may be gate control signals for controlling turn-on and turn-off of the data write transistor (e.g., the second transistor). The gate signals Gn-3, Gn-2, Gn-1, and Gn may be supplied with an on-voltage for turning on the data write transistor and an off-voltage for turning off the data write transistor. In an embodiment, the on-voltage of the gate signals Gn-3, Gn-2, Gn-1, and Gn may be a high-level voltage (first-level voltage), and the off-voltage of the gate signals Gn-3, Gn-2, Gn-1, and Gn may be a low-level voltage (second-level voltage).

The on-voltage period of the gate signals Gn-3, Gn-2, Gn-1, and Gn may be also referred to as the line time period LT. The line time period LT may be a time desired for the display apparatus 10 (refer to FIG. 1) to write the data signal DATA on the sub-pixels Ps (refer to FIG. 2) of one row (one line). In an embodiment, the line time period LT may be about 2 H. The line time period LT may include the first sub-line time period LT1 and the second sub-line time period LT2 that follows the first sub-line time period LT1. Each of the first and second sub-line time periods LT1 and LT2 may be about 1 H. For each of the sub-line time periods LT1 and LT2, the on-voltage of the first control signal CLA1 may be supplied to the first demultiplexer DMX1, and the on-voltage of the third control signal CLA2 may be supplied to the second demultiplexer DMX2.

During the first sub-line time period LT1 of the line time period (hereinafter, also referred to as "current line time period") of a row to which a gate signal is applied, the first control signal CLA1 and the third control signal CLA2 may be supplied. Similarly, the first control signal CLA1 and the third control signal CLA2 may be supplied during the second sub-line time period LT2. During the second sub-line time period LT2, the data signal DATA corresponding to the sub-pixels Ps of a row where the gate signal is supplied may be written.

The data driving unit 150 (refer to FIG. 2) may be synchronized with the control signals CLA1 and CLA2 and may supply the data signal DATA to each data output line.

In an embodiment, when the (n-3)^{th} gate signal Gn-3 is supplied to the (n-3)^{th} gate line GLn-3 may be selected during the line time period LT, the sub-pixels PR11, PG11, PB11, PR12, ..., PB14 connected to the (n-3)^{th} gate line GLn-3, and the data driving unit 150 may output the data signals DATA<1>, DATA<2>, ..., DATA<6> to the data output lines OL1, OL2, ..., OL6, for example.

Similarly, the first control signal CLA1 and the third control signal CLA2 may be supplied for each of the sub-line time periods LT1 and LT2. The sub-data signals supplied during the first sub-line time period LT1 may be sub-data signals of the previous line time period corresponding to the row to which the previous gate signal is supplied (previous line).

During the second sub-line time period LT2, the first control signal CLA1 may be supplied to the first switches SW1 of the first demultiplexer DMX1, and the third control signal CLA2 may be supplied to the third switches SW3 of the second demultiplexer DMX2. Accordingly, the corresponding sub-data signals R11, G11, B11, R13, G13, and B13 of a current line time period may be supplied to the sub-pixels PR11, PG11, and PB11 connected to the data lines DL1, DL2, and DL3 to which the first switches SW1 are connected and the sub-pixels PR13, PG13, and PB13 connected to the data lines DL7, DL8, and DL9 to which the third switches SW3 are connected from among the sub-pixels PR11, PG11, PB11, PR12, ..., PB14 connected to the (n-3)^{th} gate line GLn-3.

In this case, without going through a switch, the sub-data signals R11, G11, B11, R13, G13, and B13 of the current line may also be supplied to the sub-pixels PR12, PG12, PB12, PR14, PG14, and PB14 connected to the data lines DL4, DL5, DL6, DL10, DL11, and DL12 connected to the data output lines OL1, OL2, ..., OL6.

Thereafter, the first control signal CLA1 is supplied with an off-voltage so that the first switch SW1 of the first demultiplexer DMX1 may be turned off, and the third control signal CLA2 is supplied with an off-voltage so that the third switch SW3 of the second demultiplexer DMX2 may be turned off. In this case, without going through a switch, the corresponding sub-data signals R12, G12, B12, R14, G14, and B14 may also be supplied to the sub-pixels PR12, PG12, PB12, PR14, PG14, and PB14 connected to the data lines DL4, DL5, DL6, DL10, DL11, and DL12 connected to the data output lines OL1, OL2, ..., OL6. The sub-pixels PR12, PG12, PB12, PR14, PG14, and PB14 connected to the data lines DL4, DL5, DL6, DL10, DL11, and DL12 may newly write the corresponding sub-data signals R12, G12, B12, R14, G14, and B14.

Sub-data signals of the previous line time period written on the sub-pixels Ps during the first sub-line time period LT1 may be overwritten by sub-data signals of the current line time period written on the sub-pixels Ps during the second sub-line time period LT2.

Similarly, when the (n-2)^{th} gate signal Gn-2 is supplied to the (n-2)^{th} gate line GLn-2 during the line time period LT, the sub-pixels PR21, PG21, PB21, PR22, ..., PB24 connected to the (n-2)^{th} gate line GLn-2 may be selected, and the data driving unit 150 may output the data signals DATA<1>, DATA<2>, ..., DATA<6> to the data output lines OL1, OL2, ..., OL6.

The first sub-line time period LT1 of the (n-2)^{th} gate signal Gn-2 may overlap the second sub-line time period LT2 of the (n-3)^{th} gate signal Gn-3. During the first sub-line time period LT1 of the (n-2)^{th} gate signal Gn-2, the first control signal CLA1 may be supplied with an on-voltage to the first switches SW1 of the first demultiplexer DMX1, and the third control signal CLA2 may be supplied with an on-voltage to the third switches SW3 of the second demultiplexer DMX2. Accordingly, sub-data signals R11, G11, B11, R13, G13, and B13 of a previous line time period may be supplied to the sub-pixels PR21, PG21, and PB21 connected to the data lines DL1, DL2, and DL3 to which the first switches SW1 are connected and the sub-pixels PR23, PG23, and PB23 connected to the data lines DL7, DL8, and DL9 to which the third switches SW3 are connected from among the sub-pixels PR21, PG21, PB21, PR22, ..., PB24 connected to the (n-2)^{th} gate line GLn-2.

In this case, without going through a switch, the sub-data signals R11, G11, B11, R13, G13, and B13 of the previous line time period may also be supplied to the sub-pixels PR22, PG22, PB22, PR24, PG24, and PB24 connected to the data lines DL4, DL5, DL6, DL10, DL11, and DL12 connected to the data output lines OL1, OL2, OL3, OL4, OL5, and OL6.

Thereafter, the first control signal CLA1 is supplied with an off-voltage so that the first switch SW1 of the first demultiplexer DMX1 may be turned off, and the third control signal CLA2 supplied with an off-voltage so that the third switch SW3 of the second demultiplexer DMX2 may be turned off. In this case, without going through a switch, the sub-data signals R12, G12, B12, R14, G14, and B14 of the previous line time period may be supplied to the sub-pixels PR22, PG22, PB22, PR24, PG24, and PB24 connected to the data lines DL4, DL5, DL6, DL10, DL11, and DL12 connected to the data output lines OL1, OL2, OL3, OL4, OL5, and OL6.

During the second sub-line time period LT2 of the (n-2)th gate signal Gn-2, the first control signal CLA1 may be supplied to the first switches SW1 of the first demultiplexer DMX1, and the third control signal CLA2 may be supplied to the third switches SW3 of the second demultiplexer DMX2. Accordingly, sub-data signals R21, G21, B21, R23, G23, and B23 of the current line time period may be supplied to the sub-pixels PR21, PG21, and PB21 connected to the data lines DL1, DL2, and DL3 to which the first switches SW1 are connected and the sub-pixels PR23, PG23, and PB23 connected to the data lines DL7, DL8, and DL9 to which the third switches SW3 are connected from among the sub-pixels PR21, PG21, PB21, PR22, ..., PB24 connected to the (n-2)^{th} gate line GLn-2.

In this case, without going through a switch, the sub-data signals R21, G21, B21, R23, G23, and B23 of the current line time period may also be supplied to the sub-pixels PR22, PG22, PB22, PR24, PG24, and PB24 connected to the data lines DL4, DL5, DL6, DL10, DL11, and DL12 connected to the data output lines OL1, OL2, ..., OL6.

Thereafter, the first control signal CLA1 is supplied with an off-voltage so that the first switch SW1 of the first demultiplexer DMX1 may be turned off, and the third control signal CLA2 is supplied with an off-voltage so that the third switch SW3 of the second demultiplexer DMX2 may be turned off. In this case, without going through a switch, the corresponding sub-data signals R22, G22, B22, R24, G24, and B24 of the current line time period may also be supplied to the sub-pixels PR22, PG22, PB22, PR24, PG24, and PB24 connected to the data lines DL4, DL5, DL6, DL10, DL11, and DL12 connected to the data output lines OL1, OL2, ..., OL6. The sub-pixels PR22, PG22, PB22, PR24, PG24, and PB24 connected to the data lines DL4, DL5, DL6, DL10, DL11, and DL12 may newly write the corresponding sub-data signals R22, G22, B22, R24, G24, and B24 of the current line time period.

In this manner, the data driving unit 150 may write data on all pixels PX during a single line time period LT.

When the control signal CCS is applied, a voltage value at the second node N2 (refer to FIG. 3A) of sub-pixels arranged in the same row may change through the reference voltage line VL1 (refer to FIG. 3A). This may cause line crosstalk, which causes line-shaped spots in the image of the display apparatus. In the illustrated embodiment, some data lines are connected to a data output line without going through a switch, and thus, some (e.g., the second control signal and the fourth control signal) of control signals may be omitted. Accordingly, line crosstalk may be reduced, and thus, the display apparatus 10 (refer to FIG. 1) on which a high-quality image is displayed may be implemented. In addition, because some of the control signals are omitted, power consumption of the display apparatus 10 may be reduced.

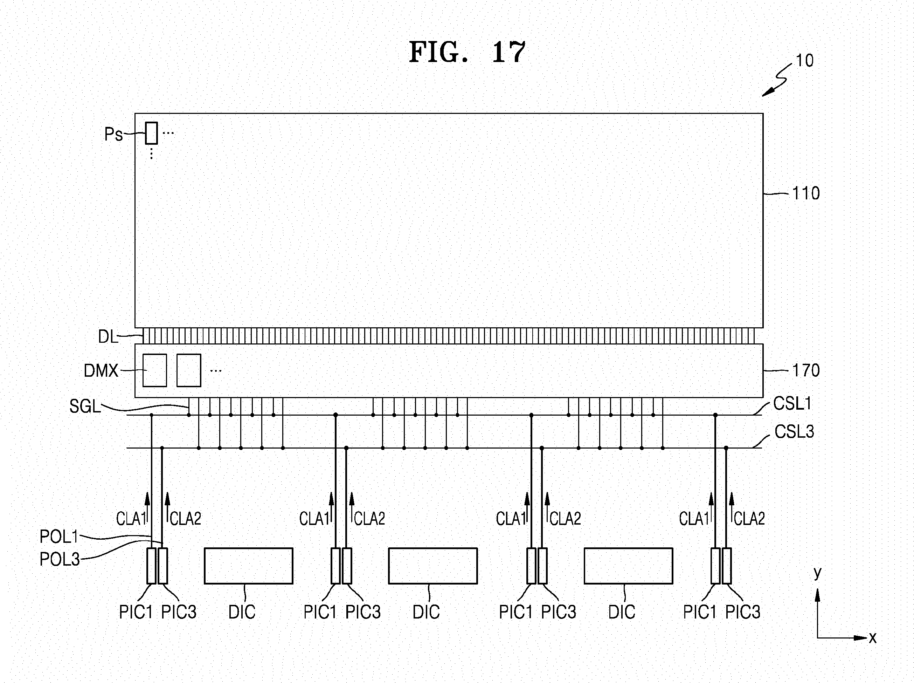

FIG. 17 is a diagram schematically illustrating an embodiment of the display apparatus 10.

Referring to FIG. 17, the display apparatus 10 may include the pixel unit 110, the data distribution unit 170, the data driving circuits DIC, and the power circuits PIC1 and PIC3. The data driving circuit DIC may be included in the data driving unit 150 shown in FIG. 2, and the power circuits PIC1 and PIC3 may be included in the control circuit 180 shown in FIG. 2.

The pixel unit 110 may include the plurality of sub-pixels Ps and the data line DL. Each of the plurality of sub-pixels Ps may be connected to a corresponding data line from among the plurality of data lines DL. The data lines DL may extend in the second direction (e.g., the y-axis direction) from the pixel unit 110 and may be connected to the data distribution unit 170.

The data distribution unit 170 may be connected between the plurality of data output lines and the plurality of data lines DL. For convenience of description, data output lines are omitted in FIG. 17. The data distribution unit 170 may include a plurality of sub-demultiplexers DMX each including one switch. As described with reference to FIG. 14, the sub-demultiplexers DMX may selectively connect one data output line to a pair of data lines according to the first control signal CLA1 or the third control signal CLA2.

The data distribution unit 170 may be connected to the data driving circuits DIC through the plurality of data output lines. The data driving circuits DIC may be arranged spaced apart from each other in the first direction (e.g., the x-axis direction). The plurality of power circuits PIC1 and PIC3 may be arranged at opposite sides of the data driving circuits DIC.

The power circuits PIC1 and PIC3 may include the first power circuits PIC1 which supplies the first control signal CLA1 and the third power circuits PIC3 which supplies the third control signal CLA2. In an embodiment, the power circuits PIC1 and PIC3 may be power management ICs.

The control signal lines CSL1 and CSL3 extending in the first direction (e.g., the x-axis direction) may be arranged between the power circuits PIC1 and PIC3 and the data distribution unit 170. The first control signal line CSL1 may be connected to the first power circuits PIC1 through the first power output lines POL1, and the third control signal line CSL3 may be connected to the third power circuits PIC3 through the third power output lines POL3.

The first control signal CLA1 supplied from the first power circuits PIC1 and the third control signal CLA2 supplied from the third power circuits PIC3 may have the same waveform and the same phase. Each of the control signal lines CSL1 and CSL3 may be connected to the data distribution unit 170 through control gate lines SGL.

By dividing the control signals CLA1 and CLA3 having the same waveform and the same phase into two control signal lines CSL1 and CSL3 and applying same, the capacitance of each line may be reduced by half. Thus, the load of each of the power circuits PIC1 and PIC3 is reduced, the slew rate of the control signals CLA1 and CLA2 may be improved, and the data distribution unit 170 may be driven within an allowable current range of the power circuits PIC1 and PIC3.

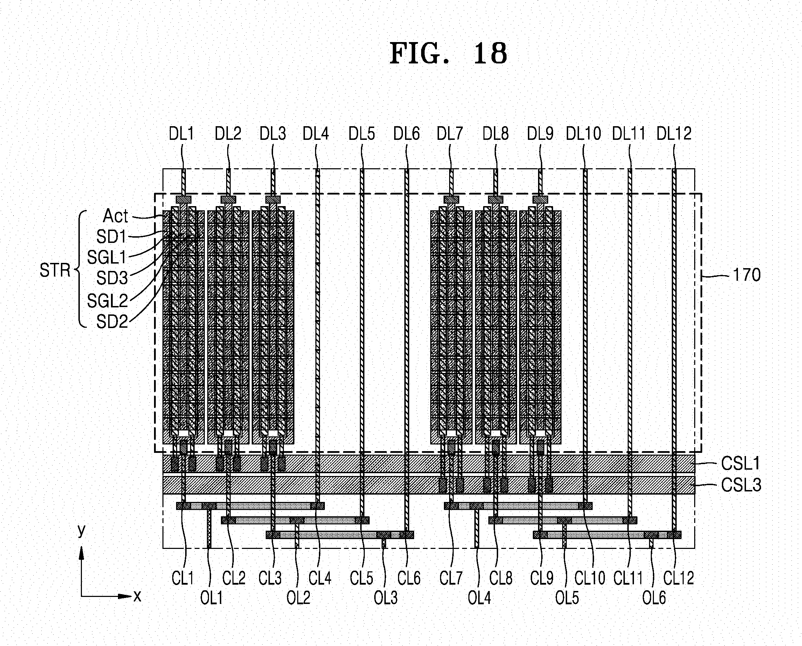

FIG. 18 is a layout diagram schematically illustrating an embodiment of the data distribution unit 170.

Referring to FIG. 18, the data distribution unit 170 may include a plurality of switch transistors STR. Each of the switch transistors STR may be the first switch SW1 or the third switch SW3 shown in FIG. 15.

The first control signal line CSL1 and the third control signal line CSL3, which extend in the first direction (e.g., the x-axis direction), may be arranged between the data distribution unit 170 and the data output lines OL1, OL2, ..., OL6. In other words, in a plan view, the first control signal line CSL1 and the third control signal line CSL3, which extend in the first direction (e.g., the x-axis direction), may be arranged between the data output lines OL1, OL2, ..., OL6 and the first switches SW1 and between the data output lines OL1, OL2, ..., OL6 and the third switches SW3.

The first control signal line CSL1 may be connected to the first power circuit PIC1 (refer to FIG. 17), and the third control signal line CSL3 may be connected to the third power circuit PIC3 (refer to FIG. 17). The first control signal line CSL1 may transfer the first control signal CLA1 (refer to FIG. 17) to the switch transistors STR connected thereto, and the third control signal line CSL3 may transfer the third control signal CLA2 (refer to FIG. 17) to the switch transistors STR connected thereto.

The switch transistors STR may be arranged between the first data output line OL1 and the first data line DL1, between the second data output line OL2 and the second data line DL2, between the third data output line OL3 and the third data line DL3, between the fourth data output lines OL4 and the seventh data line DL7, between the fifth data output line OL5 and the eighth data line DL8, and between the sixth data output line OL6 and the ninth data line DL9.

Each of the switch transistors STR may include a first terminal connected to a corresponding data line from among the data lines DL1, DL2, DL3, DL7, DL8, and DL9, a second terminal connected to a corresponding connection line from among the connection lines CL1, CL2, CL3, CL7, CL8, and CL9, and a gate connected to a corresponding control signal line from among the control signal lines CSL1 and CSL3. In an embodiment, each of the switch transistors STR may include the semiconductor layer Act, the first electrode SD1, the second electrode SD2, a first control gate line SGL1, the second control gate line SGL2, and the third electrode SD3.

The semiconductor layer Act may include an oxide-based semiconductor material. The oxide-based semiconductor material may include an oxide of at least one material of In, Ga, Sn, Zr, V, Hf, Cd, Ge, Cr, Ti, Al, Cs, Ce, and Zn. The oxide-based semiconductor material may be IGZO, ITZO, or IGTZO.

The first electrode SD1 and the second electrode SD2 may be arranged at opposite ends of the semiconductor layer Act, respectively. The first electrode SD1 and the second electrode SD2 may extend in the second direction (e.g., the y-axis direction) and may be arranged to be substantially parallel and spaced apart in the first direction (e.g., the x-axis direction). In an embodiment, the first electrode SD1 and the second electrode SD2 may be connected to each other at one end of the switch transistor STR and may be integrally provided as a single body. The first electrode SD1 and the second electrode SD2 may be connected to a corresponding connection line from among the connection lines CL1, CL2, CL3, CL7, CL8, and CL9 at one end of the switch transistor STR.

The third electrode SD3 may be disposed between the first electrode SD1 and the second electrode SD2. The third electrode SD3 may pass through the center of the semiconductor layer Act and extend in the second direction (e.g., the y-axis direction). The third electrode SD3 may be connected to a corresponding data line from among the data lines DL1, DL2, DL3, DL7, DL8, and DL9 at an opposite end of the switch transistor STR.

The first control gate line SGL1 may be disposed between the first electrode SD1 and the third electrode SD3, and the second control gate line SGL2 may be disposed between the third electrode SD3 and the second electrode SD2. Each of the first control gate line SGL1 and the second control gate line SGL2 may be one of the control gate lines SGL shown in FIG. 8. Each of the first control gate line SGL1 and the second control gate line SGL2 may extend in the second direction (e.g., the y-axis direction) and may be connected to a corresponding control signal line from among the control signal lines CSL1 and CSL3.

Each of the data output lines OL1, OL2, ..., OL6 may be connected to a pair of connection lines. A pair of connection lines connected to one data output line may be spaced apart from each other with two columns interposed therebetween. In an embodiment, the first data output line OL1 may be connected to the first connection line CL1 and the fourth connection line CL4, the second data output line OL2 may be connected to the second connection line CL2 and the fifth connection line CL5, the third data output line OL3 may be connected to the third connection line CL3 and the sixth connection line CL6, the fourth data output lines OL4 may be connected to the seventh connection line CL7 and the tenth connection line CL10, the fifth data output line OL5 may be connected to the eighth connection line CL8 and the eleventh connection line CL11, and the sixth data output line OL6 may be connected to the ninth connection line CL9 and the twelfth connection line CL12, for example. The connection lines CL1, CL2, ..., CL12 may correspond one-to-one with the data lines DL1, DL2, ..., DL12.

The first control gate line SGL1 and the second control gate line SGL2 of each of the switch transistor STR between the first connection line CL1 and the first data line DL1, the switch transistor STR between the second connection line CL2 and the second data line DL2, and the switch transistor STR between the third connection line CL3 and the third data line DL3 may be connected to the first control signal line CSL1. The first control gate line SGL1 and the second control gate line SGL2 of each of the switch transistor STR between the seventh connection line CL7 and the seventh data line DL7, the switch transistor STR between the eighth connection line CL8 and the eighth data line DL8 and the switch transistor STR between the ninth connection line CL9 and the ninth data line DL9 may be connected to the third control signal line CSL3.

In other words, the first control signal line CSL1 may transfer the first control signal CLA1 to the switch transistor STR between the first connection line CL1 and the first data line DL1, the switch transistor STR between the second connection line CL2 and the second data line DL2, and the switch transistor STR between the third connection line CL3 and the third data line DL3, and the third control signal line CSL3 may transfer the third control signal CLA2 to the switch transistor STR between the seventh connection line CL7 and the seventh data line DL7, the switch transistor STR between the eighth connection line CL8 and the eighth data line DL8, and the switch transistor STR between the ninth connection line CL9 and the ninth data line DL9.

The data distribution unit 170 may connect each of the fourth data line DL4, the fifth data line DL5, the sixth data line DL6, the tenth data line DL10, the eleventh data line DL11, and the twelfth data line DL12 to a corresponding data output line from among the data output lines OL1, OL2, ..., OL6. In other words, each of the fourth data line DL4, the fifth data line DL5, the sixth data line DL6, the tenth data line DL10, the eleventh data line DL11, and the twelfth data line DL12 may be connected, without passing through the switch transistor STR, to a corresponding connection line from among the fourth connection line CL4, the fifth connection line CL5, the sixth connection line CL6, the tenth connection line CL10, the eleventh connection line CL11, and the twelfth connection line CL12. In an embodiment, each of the fourth data line DL4, the fifth data line DL5, the sixth data line DL6, the tenth data line DL10, the eleventh data line DL11, and the twelfth data line DL12 may be integrally provided as a single body with the corresponding connection line from among the fourth connection line CL4, the fifth connection line CL5, the sixth connection line CL6, the tenth connection line CL10, the eleventh connection line CL11, and the twelfth connection line CL12.

Because the switch transistor STR is not disposed between the data lines DL4, DL5, DL6, DL10, DL11, and DL12 and the connection lines CL4, CL5, CL6, CL10, CL11, and CL12, other lines, transistors, or the like may be arranged in an empty space, thereby reducing an area of a dead space. In addition, by omitting some of the control signals, line crosstalk of the display apparatus 10 (refer to FIG. 1) may be reduced so that a high-quality image may be displayed and power consumption may be reduced.

By dividing control signals having the same waveform and the same phase into two different control signal lines and applying the control signals, the capacitance of each line may be reduced by half.

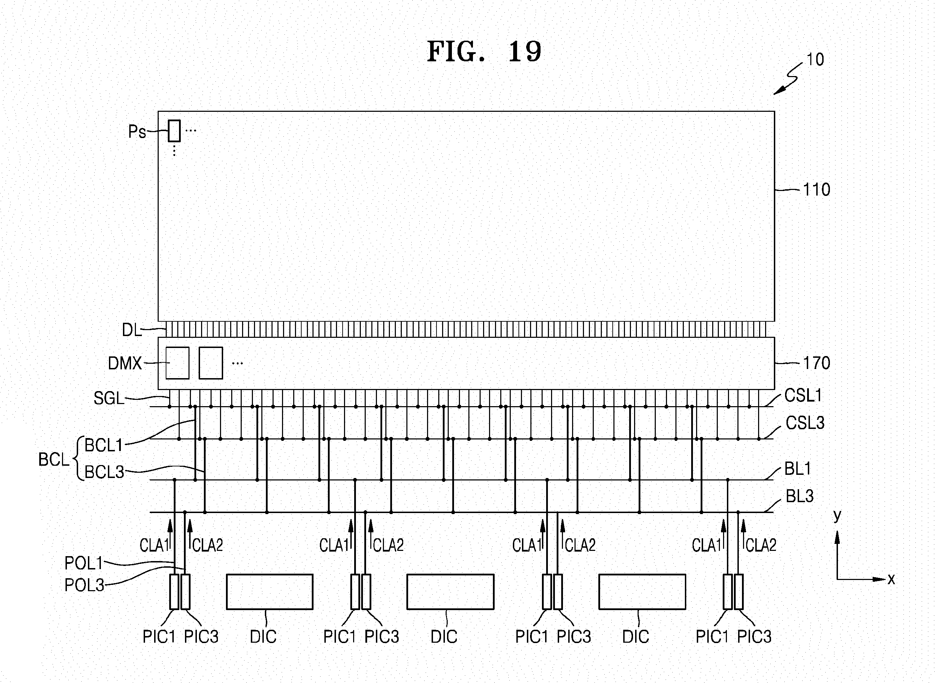

FIG. 19 is a diagram schematically illustrating an embodiment of the display apparatus 10. FIG. 19 is similar to FIG. 17, but differs in that, in the former, the display apparatus 10 further includes bridge lines BL1 and BL3 between the control signal lines CSL1 and CSL3 and the power circuits (or, control circuits) PIC1 and PIC3. Hereinbelow, descriptions of the same or similar configurations are omitted and differences are mainly described.

Referring to FIG. 19, the display apparatus 10 may include the pixel unit 110, the data distribution unit 170, the data driving circuits DIC, and the power circuits PIC1 and PIC4, the pixel unit 110 including the sub-pixels Ps and the data lines DL, and the data distribution unit 170 including the sub-demultiplexers DMX. The data driving circuit DIC may be included in the data driving unit 150 shown in FIG. 2, and the power circuits PIC1 and PIC3 may be included in the control circuit 180 shown in FIG. 2.

The data lines DL may extend in the second direction (e.g., the y-axis direction) from the pixel unit 110 and may be connected to the data distribution unit 170. The data distribution unit 170 may be connected between data output lines (not shown) and the data lines DL. The data distribution unit 170 may be connected to the data driving circuits DIC through the data output lines.

The data driving circuits DIC may be arranged spaced apart from each other in the first direction (e.g., the x-axis direction). The plurality of power circuits PIC1 and PIC3 may be arranged at opposite sides of the data driving circuits DIC.

The power circuits PIC1 and PIC3 may include the first power circuits PIC1 which supplies the first control signal CLA1 and the third power circuits PIC3 which supplies the third control signal CLA2.

In a plan view, the control signal lines CSL1 and CSL3 extending in the first direction (e.g., the x-axis direction) may be arranged between the power circuits PIC1 and PIC3 and the data distribution unit 170, and the bridge lines BL1 and BL3 extending in the first direction (e.g., the x-axis direction) may be arranged between the control signal lines CSL1 and CSL3 and the power circuits PIC1 and PIC3.

The bridge lines BL1 and BL3 may respectively connect the power circuits PIC1 and PIC3 to corresponding control signal lines CSL1 and CSL3. In an embodiment, the first bridge line BL1 may connect the first power circuits PIC1 and the first control signal line CSL1, and the third bridge line BL3 may connect the third power circuits PIC3 to the third control signal line CSL3, for example.

In an embodiment, the first bridge line BL1 may be connected to the first power circuits PIC1 through the first power output lines POL1, and the third bridge line BL3 may be connected to the third power circuits PIC3 through the third power output lines POL3, for example. Each of the bridge lines BL1 and BL3 may be connected to a corresponding control signal line through the bridge connection lines BCL1 and BCL3 extending in the second direction (e.g., the y-axis direction). The first bridge line BL1 may be connected to the first control signal line CSL1 through the first bridge connection lines BCL1, and the third bridge line BL3 may be connected to the third control signal line CSL3 through the third bridge connection lines BCL3.

The number of first bridge connection lines BCL1 may be greater than the number of first power output lines POL1, and the number of third bridge connection lines BCL3 may be greater than the number of third power output lines POL3.

Each of the control signal lines CSL1 and CSL3 may be connected to the data distribution unit 170 through control gate lines SGL.

The first control signal CLA1 supplied from the first power circuits PIC1 and the third control signal CLA2 supplied from the third power circuits PIC3 may have the same waveform and the same phase.

In a comparative example, when power circuits are directly connected to control signal lines, control signals in an area (hereinafter, "edge area") adjacent to an input point to which power output lines are connected have a relatively high slew rate, whereas control signals in an area (hereinafter, "center area") far from the input point to which the power output lines are connected may have a relatively low slew rate.

On other hand, as shown in FIG. 19, when the control signal lines CSL1 and CSL3 are connected to the power circuits PIC1 and PIC3 through the bridge lines BL1 and BL3, because the capacitance of the bridge lines BL1 and BL3 is relatively low, a slew rate of the control signals in the center area may be improved. In addition, because the number of bridge connection lines BCL is greater than the number of power output lines POL, input points of each of the control signals increase, thereby reducing a slew deviation between the control signal in the center area and the control signal in the edge area.

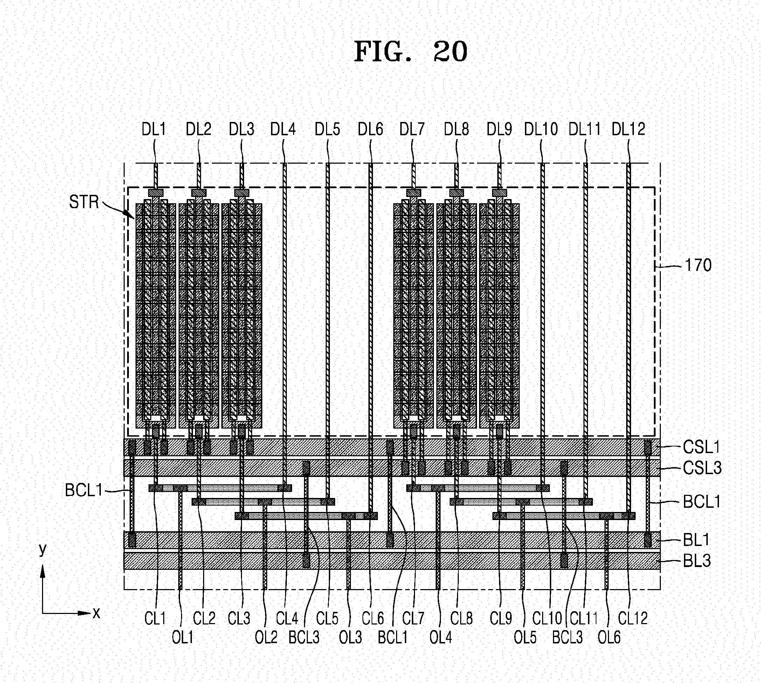

FIG. 20 is a layout diagram schematically illustrating an embodiment of the data distribution unit 170.

FIG. 20 is similar to FIG. 18, but differs in that, in the former, the display apparatus 10 further includes the bridge lines BL1 and BL3 between the control signal lines CSL1 and CSL3 and the power circuits. Hereinbelow, descriptions of the same or similar configurations are omitted and differences are mainly described.

Referring to FIG. 20, the data distribution unit 170 may include a plurality of switch transistors STR. Each of the switch transistors STR may be either one of the first switch SW1 and the third switch SW3 shown in FIG. 15.

The control signal lines CSL1 and CSL3 extending in the first direction (e.g., the x-axis direction) may be arranged between the data distribution unit 170 and the data output lines OL1, OL2, ..., OL12. The bridge lines BL1 and BL3 extending in the first direction (e.g., the x-axis direction) may be arranged between the control signal lines CSL1 and CSL3 and the data output lines OL1, OL2, ..., OL12.

The first bridge line BL1 may be connected to the first power circuit PIC1 (refer to FIG. 19), and the third bridge line BL3 may be connected to the third power circuit PIC3 (refer to FIG. 19). Because the bridge lines BL1 and BL3 are spaced apart from the switch transistors STR, a less load than the control signal lines CSL1 and CSL3 may be applied thereto.

The first bridge line BL1 may be connected to the first control signal line CSL1 through the first bridge connection lines BCL1, and the third bridge line BL3 may be connected to the third control signal line CSL3 through the third bridge connection lines BCL3.

The number and arrangement of the first bridge connection line BCL1 and the third bridge connection line BCL3 may be designed in various ways. When the first bridge connection line BCL1 and the third bridge connection line BCL3 are provided in plural, input points of the control signals in each of the control signal lines CSL1 and CSL3 increase, thereby improving a slew deviation between a control signal in the center area of each of the control signal lines CSL1 and CSL3 and a control signal in the edge area of each of the control signal lines CSL1 and CSL3.

Each of the data output lines OL1, OL2, ..., OL6 may be connected to a pair of connection lines. A pair of connection lines connected to one data output line may be spaced apart from each other with two columns interposed therebetween. The connection lines CL1, CL2, ..., CL12 may correspond one-to-one with the data lines DL1, DL2, ..., DL12.

Each of the switch transistors STR may include a first terminal connected to the corresponding data line from among the data lines DL1, DL2, DL3, DL7, DL8, and DL9, a second terminal connected to a corresponding connection line from among the connection lines CL1, CL2, CL3, CL7, CL8, and CL9, and a gate connected to a corresponding control signal line from among the control signal lines CSL1 and CSL3.

The first control gate line SGL1 and the second control gate line SGL2 of each of the switch transistor STR between the first connection line CL1 and the first data line DL1, the switch transistor STR between the second connection line CL2 and the second data line DL2, and the switch transistor STR between the third connection line CL3 and the third data line DL3 may be connected to the first control signal line CSL1. The first control gate line SGL1 and the second control gate line SGL2 of each of the switch transistor STR between the seventh connection line CL7 and the seventh data line DL7, the switch transistor STR between the eighth connection line CL8 and the eighth data line DL8 and the switch transistor STR between the ninth connection line CL9 and the ninth data line DL9 may be connected to the third control signal line CSL3.

The switch transistors STR connected to the first control signal line CSL1 may connect the data lines DL1, DL2, and DL3 to the corresponding data output lines OL1, OL2, and OL3 in response to the first control signal CLA1. The switch transistors STR connected to the third control signal line CSL3 may connect the data lines DL7, DL8, and DL9 to the corresponding data output lines OL4, OL5, and OL6 in response to the third control signal CLA2.

The data distribution unit 170 may connect each of the fourth data line DL4, the fifth data line DL5, the sixth data line DL6, the tenth data line DL10, the eleventh data line DL11, and the twelfth data line DL12 to the corresponding data output line from among the data output lines OL1, OL2, ..., OL6. In other words, each of the fourth data line DL4, the fifth data line DL5, the sixth data line DL6, the tenth data line DL10, the eleventh data line DL11, and the twelfth data line DL12 may be connected, without passing through the switch transistor STR, to the corresponding connection line from among the fourth connection line CL4, the fifth connection line CL5, the sixth connection line CL6, the tenth connection line CL10, the eleventh connection line CL11, and the twelfth connection line CL12. In an embodiment, each of the fourth data line DL4, the fifth data line DL5, the sixth data line DL6, the tenth data line DL10, the eleventh data line DL11, and the twelfth data line DL12 may be integrally provided as a single body with the corresponding connection line from among the fourth connection line CL4, the fifth connection line CL5, the sixth connection line CL6, the tenth connection line CL10, the eleventh connection line CL11, and the twelfth connection line CL12.

The first bridge line BL1 may transfer the first control signal CLA1 to the first control signal line CSL1 through the first bridge connection lines BCL1, and the third bridge line BL3 may transfer the third control signal CLA2 to the third control signal line CSL3 through the third bridge connection lines BCL3.

Because the switch transistor STR is not disposed between the data lines DL4, DL5, DL6, DL10, DL11, and DL12 and the connection lines CL4, CL5, CL6, CL10, CL11, and CL12, other lines, transistors, or the like may be arranged in an empty space, thereby reducing an area of a dead space. In addition, the number of control signal lines and the number of bridge lines may be reduced so that the area of the dead space in the display apparatus 10 may be reduced.

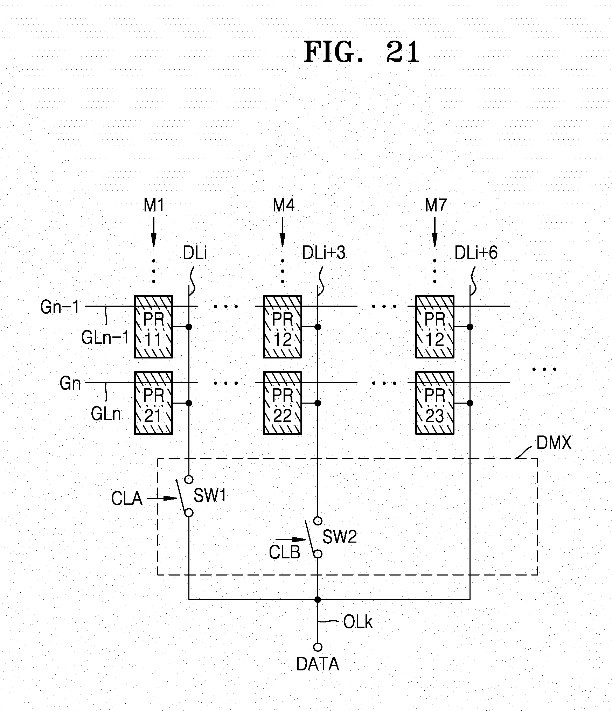

FIG. 21 is a diagram for describing an embodiment of the sub-demultiplexer DMX. FIG. 21 is similar to FIG. 14, but differs in that, in the former, the sub-demultiplexer DMX connects three data lines to one data output line.

Referring to FIG. 21, the sub-demultiplexer DMX may selectively connect the k^{th} data output line OLk to the i^{th} data line DLi, the (i+3)^{th} data line DLi+3, and an (i+6)^{th} data line DLi+6. The sub-demultiplexer DMX may include the first switch SW1 connecting the k^{th} data output line OLk to the i^{th} data line DLi, and the second switch SW2 connecting the k^{th} data output line OLk to the (i+3)^{th} data line DLi+3, and may connect the (i+6)^{th} data line DLi+6 to the k^{th} data output line OLk without going through a switch.

The i^{th} data line DLi, the (i+3)^{th} data line DLi+3, and the (i+6)^{th} data line DLi+6 may be spaced apart from each other with two columns interposed therebetween. In an embodiment, an (i+1)^{th} data line and an (i+2)^{th} data line may be arranged between the i^{th} data line DLi and the (i+3)^{th} data line DLi+3, and an (i+4)^{th} data line and an (i+5)^{th} data line may be arranged between the (i+3)^{th} data line DLi+3 and the (i+6)^{th} data line DLi+6, for example. The ith data line DLi may be connected to sub-pixels in the i^{th} column (annotated by M1, for example), the (i+3)^{th} data line DLi+3 may be connected to sub-pixels in an (i+3)^{th} column (annotated by M4, for example), and the (i+6)^{th} data line DLi+6 may be connected to sub-pixels in an (i+6)^{th} column (annotated by M7, for example).

The first switch SW1 may be provided between the k^{th} data output line OLk and the i^{th} data line DLi. The first switch SW1 may connect the k^{th} data output line OLk to the i^{th} data line DLi by a first control signal CLA and may apply the data signal DATA applied via the k^{th} data output line OLk to the i^{th} data line DLi.

The second switch SW2 may be provided between the kth data output line OLk and the (i+3)^{th} data line DLi+3. The second switch SW2 may connect the kth data output line OLk to the (i+3)th data line DLi+3 by a second control signal CLB and may apply the data signal DATA applied via the kth data output line OLk to the (i+3)th data line DLi+3.

The sub-demultiplexer DMX may connect the k^{th} data output line OLk to the (i+6)^{th} data line DLi+6. In other words, no switch is provided between the k^{th} data output line OLk and the (i+6)^{th} data line DLi+6, and the data signal DATA applied to the k^{th} data output line OLk may be applied to the (i+6)^{th} data line DLi+6, regardless of the control signals CLA and CLB.

In an embodiment, the sub-pixels connected to i^{th} data line DLi, the (i+3)^{th} data line DLi+3, and the (i+6)^{th} data line DLi+6 may emit light of the same color. Regarding this, FIG. 21 shows that sub-pixels connected to the i^{th} data line DLi, the (i+3)^{th} data line DLi+3, and the (i+6)^{th} data line DLi+6 are red sub-pixels PR emitting red light. However, embodiments of the disclosure are not limited thereto. Connections between data lines and sub-pixels may be modified in various ways.

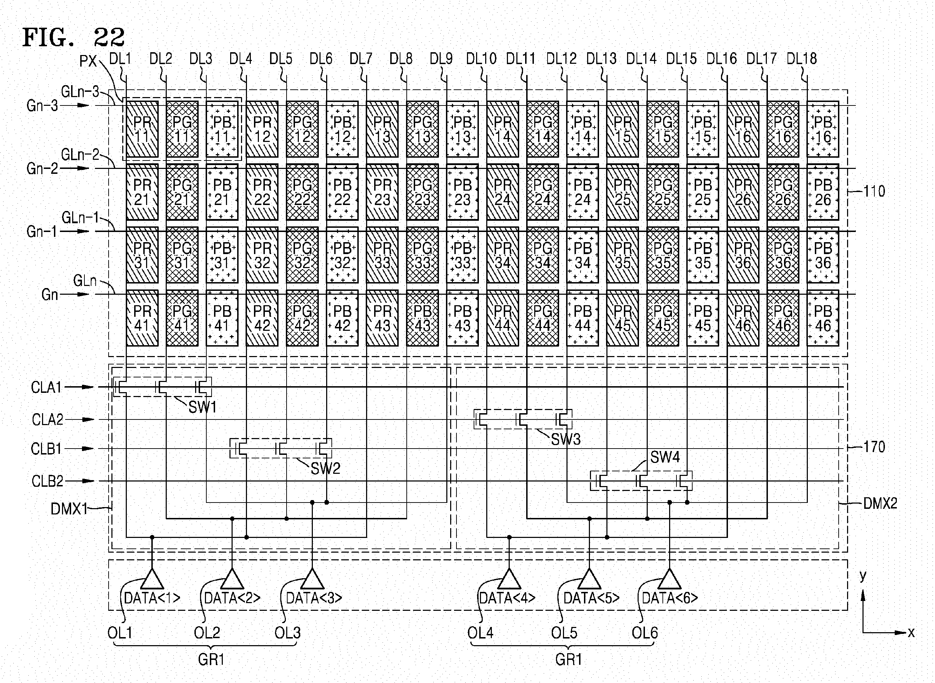

FIG. 22 is a diagram schematically illustrating an embodiment of a display apparatus.

Referring to FIG. 22, the data distribution unit 170 may include the first demultiplexer DMX1 and the second demultiplexer DMX2, and the pixel unit 110 may include the plurality of pixels PX. A pixel PX may include a red sub-pixel PR, a green sub-pixel PG, and a blue sub-pixel PB.

In the pixel unit 110, a column in which the red sub-pixels PR are arranged in the second direction (e.g., a y-axis direction), a column in which the green sub-pixels PG are arranged in the second direction (e.g., the y-axis direction), and a column in which the blue sub-pixels PB are arranged in the second direction (e.g., the y-axis direction) may be alternately repeated in the first direction (e.g., an x-axis direction).

In an embodiment, in a first row, a first pixel, a second pixel, a third pixel, a fourth pixel, a fifth pixel, and a sixth pixel are sequentially arranged in the first direction (e.g., the x-axis direction), for example. The first pixel may include three sub-pixels PR11, PG11, and PB11 in first to third columns, the second pixel may include three sub-pixels PR12, PG12, and PB12 in fourth to sixth columns, the third pixel may include three sub-pixels PR13, PG13, and PB13 in seventh to ninth columns, the fourth pixel may include three sub-pixels PR14, PG14, and PB14 in tenth to twelfth column, the fifth pixel may include three sub-pixels PR15, PG15, and PB15 in 13^{th} to 15^{th} columns, and the sixth pixel may include three-sub-pixels PR16, PG16, and PB16 in 16^{th} to 18^{th} columns.

The plurality of data lines DL1, DL2, ..., DL18 and the plurality of gate lines GLn-3, GLn-2, GLn-1, and GLn may be arranged in the pixel unit 110. The plurality of gate lines GLn-3, GLn-2, GLn-1, and GLn may be the gate line (e.g., GL1, GL2, ..., GLn) shown in FIG. 2 or the first gate line GWL shown in FIGS. 3A and 3B.

One gate line may be connected to sub-pixels arranged in the same row. One data line may be connected to sub-pixels arranged in the same column. The sub-pixels connected to the ith data line DLi and the sub-pixels connected to the (i+3)th data line DLi+3 may be sub-pixels emitting light of the same color. For convenience of description, FIG. 22 shows only 18 data lines DL1, DL2, ..., DL18, four gate lines GLn-3, GLn-2, GLn-1, and GLn, and six data output lines OL1, OL2, ..., OL6. However, the number of data lines, the number of gate lines, and the number of data output lines may be greater.

The first demultiplexer DMX1 may selectively connect the data output lines OL1, OL2, and OL3 belonging to a first group GR1 to the first to ninth data lines DL1, DL2, ..., and DL9, and the second demultiplexer DMX2 may selectively connect data output lines OL4, OL5, and OL6 belonging to a second group GR2 to tenth to 18^{th} data lines DL10, DL11, ..., DL18.

Each of the first demultiplexer DMX1 and the second demultiplexer DMX2 may include the plurality of sub-demultiplexers DMX (refer to FIG. 21). One sub-demultiplexer DMX may selectively connect one data output line to three data lines. The three data lines connected to one sub-demultiplexer DMX may be spaced apart from each other with two columns interposed therebetween.

In an embodiment, the three data lines connected to the first data output line OL1 belonging to the first group GR1 may be the first data line DL1, the fourth data line DL4, and the seventh data line DL7, for example. The first data line DL1 may be connected to the red sub-pixel PR11 of the first pixel, the fourth data line DL4 may be connected to the red sub-pixel PR12 of the second pixel, and the seventh data line DL7 may be connected to the red sub-pixel PR13 of the third pixel.

The three data lines connected to the fourth data output lines OL4 belonging to the second group GR2 may be the tenth data line DL10, the 13^{th} data line DL13, and the 16^{th} data line DL16. The tenth data line DL10 may be connected to the red sub-pixel PR14 of the fourth pixel, the 13th data line DL13 may be connected to the red sub-pixel PR15 of the fifth pixel, and the 16th data line DL16 may be connected to the red sub-pixel PR16 of the sixth pixel.

The first demultiplexer DMX1 may include first switches SW1 and second switches SW2. Each of the first switches SW1 may be provided between the first data output line OL1 and the first data line DL1, between the second data output line OL2 and the second data line DL2, and between the third data output line OL3 and the third data line DL3. The first switches SW1 may be turned on by a first control signal CLA1 and may connect the first data output line OL1 to the first data line DL1, the second data output line OL2 to the second data line DL2, and the third data output line OL3 to the third data line DL3.

Each of the second switches SW2 may be provided between the first data output line OL1 and the fourth data line DL4, between the second data output line OL2 and the fifth data line DL5, and between the third data output line OL3 and the sixth data line DL6. The second switches SW2 may be turned on by a second control signal CLB1 and may connect the first data output line OL1 to the fourth data line DL4, the second data output line OL2 to the fifth data line DL5, and the third data output line OL3 to the sixth data line DL6.

The first demultiplexer DMX1 may connect the first data output line OL1 to the seventh data line DL7, the second data output line OL2 to the eighth data line DL8, and the third data output line OL3 to the ninth data line DL9, regardless of the control signals CLA1, CLA2, CLB1, and CLB2.

A first data signal DATA<1> applied to the first data output line OL1 may include first subdata signals R applied to the red sub-pixel PR, a second data signal DATA<2> applied to the second data output line OL2 may include second subdata signals G applied to the green sub-pixels PG, and a third data signal DATA<3> applied to the third data output line OL3 may include third subdata signals B applied to the blue sub-pixels PB.

The second demultiplexer DMX2 may include the third switches SW3 and the fourth switches SW4. Each of the third switches SW3 may be provided between the fourth data output lines OL4 and the tenth data line DL10, between the fifth data output line OL5 and the eleventh data line DL11, and between the sixth data output line OL6 and the twelfth data line DL12. The third switches SW3 may be turned on according to the third control signal CLA2 and may connect the fourth data output lines OL4 to the tenth data line DL10, the fifth data output line OL5 to the eleventh data line DL11, and the sixth data output line OL6 to the twelfth data line DL12.

Each of the fourth switches SW4 may be provided between the fourth data output lines OL4 and the 13^{th} data line DL13, between the fifth data output line OL5 and the 14^{th} data line DL14, and between the sixth data output line OL6 and the 15^{th} data line DL15. The fourth switches SW4 may be turned on according to the fourth control signal CLB2 and may connect the fourth data output lines OL4 to the 13^{th} data line DL13, the fifth data output line OL5 to the 14^{th} data line DL14, and the sixth data output line OL6 to the 15^{th} data line DL15.

The second demultiplexer DMX2 may connect the fourth data output lines OL4 to the 16^{th} data line DL16, the fifth data output line OL5 to the 17^{th} data line DL17, and the sixth data output line OL6 to the 18^{th} data line DL18, regardless of the control signals CLA1, CLA2, CLB1, and CLB2.

A fourth data signal DATA<4> applied to the fourth data output lines OL4 may include the first subdata signals R applied to the red sub-pixel PR, a fifth data signal DATA<5> applied to the fifth data output line OL5 may include the second subdata signals G applied to the green sub-pixels PG, and a sixth data signal DATA<6> applied to the sixth data output line OL6 may include the third subdata signals B applied to the blue sub-pixels PB.

In FIGS. 21 and 22, the sub-demultiplexer DMX connects one data output line to three data lines. However, embodiments of the disclosure are not limited thereto. In an embodiment, the sub-demultiplexer DMX may connect one data output line to N data lines. In this case, the sub-demultiplexer DMX may include (N-1) switches, and may connect one data line to the data output line without going through a switch.

In an embodiment, the pixel unit 110 may include 2N data lines. Here, N may be a natural number satisfying 2≤N. The data distribution unit 170 may include the first demultiplexer DMX1 and the second demultiplexer DMX2, for example. N data lines from among the 2N data lines may be connected to the first data output line through the first demultiplexer DMX1, and remaining N data lines may be connected to the second data output line through the second demultiplexer DMX2.

The first demultiplexer DMX1 may include (N-1) switches that connect the first data output line to each of the (N-1) data lines. The first demultiplexer DMX1 may connect, without going through a switch, the first data output line to an N^{th} data line from among the N data lines connected to the first data output line. The second demultiplexer DMX2 may include (N-1) switches that connect the second data output line to each of the (N-1) data lines. The second demultiplexer DMX2 may connect, without going through a switch, the second data output line to an N^{th} data line from among the N data lines connected to the second data output line.

The control circuit may output a total of (2N-2) control signals including (N-1) control signals for turning on or turning off the (N-1) switches included in the first demultiplexer DMX1 and (N-1) control signals for turning on or turning off the (N-1) switches included in the second demultiplexer DMX2. In this case, an i^{th} control signal (1 ≤ i ≤ N-1, where i is a natural number) may have the same phase and the same waveform as an (N+i)^{th} control signal. As described above, by dividing control signals having the same waveform and the same phase into two different control signal lines and applying the control signals, the capacitance of each line may be reduced by half.

In addition, by connecting some data lines to a data output line without going through a switch, some of the control signals may be omitted. When some of the control signals are omitted, power consumption of the display apparatus 10 may be reduced, thereby reducing the area of the dead space.

In an embodiment, each display apparatus 10 may further include bridge lines that connect each of control signal lines to the control circuits. Each of the bridge lines may be connected to a corresponding control signal line through bridge connection lines.

As discussed, embodiments may provide a display apparatus comprising: a pixel unit comprising a first data line, a second data line, a third data line, and a fourth data line; a data driving unit arranged to output a data signal through data output lines; a data distribution unit comprising: a first switch arranged to connect a first data output line from among the data output lines to the first data line according to a first control signal; a second switch arranged to connect the first data output line to the second data line according to a second control signal; a third switch arranged to connect a second data output line from among the data output lines to the third data line according to a third control signal; and a fourth switch arranged to connect the second data output line to the fourth data line according to a fourth control signal; and a control circuit comprising: a first power circuit arranged to output the first control signal; a second power circuit arranged to output the second control signal; a third power circuit arranged to output the third control signal; and a fourth power circuit arranged to output the fourth control signal, wherein the first control signal has a same phase as a phase of the third control signal, and the second control signal has a same phase as a phase of the fourth control signal.

In some embodiments, the display apparatus may comprise a first switch transistor, a second switch transistor, a third switch transistor, and a fourth switch transistor, which are respectively connected to the first to fourth data lines, each of the first to fourth switch transistors comprising: a semiconductor layer; a first gate line and a second gate line, which are disposed on the semiconductor layer; a first electrode and a second electrode, which are disposed on the first gate line and the second gate line; and a third electrode disposed between the first electrode and the second electrode; and a first control signal line, a second control signal line, a third control signal line, and a fourth control signal line, which are, in a plan view, arranged between the data output lines and the first to fourth switch transistors and extend in a first direction, wherein the first gate line and the second gate line extend in a second direction crossing the first direction, and the first electrode and the second electrode extend in the second direction, and are respectively connected to opposite ends of the semiconductor layer.

In some embodiments, the display apparatus may comprise a first switch transistor connected between the first data line and the first data output line and a second switch transistor connected between the third data line and the second data output line, each of the first switch transistor and the second switch transistor comprising: a semiconductor layer; a first gate line and a second gate line, which are disposed on the semiconductor layer; a first electrode and a second electrode, which are disposed on the first gate line and the second gate line, and are respectively connected to opposite ends of the semiconductor layer; and a third electrode disposed between the first electrode and the second electrode; and a first control signal line and a second control signal line, which are, in a plan view, arranged between the first data output line and the first switch transistor, and between the second data output line and the second switch transistor, and extend in a first direction, wherein the first gate line and the second gate line extend in a second direction crossing the first direction.

In some embodiments, the data distribution unit connects the first data output line to an nth data line from among the 2n data lines, and connects the second data output line to a (2n)th data line from among the 2n data lines, the data distribution unit comprising: (n-1) switches connecting the first data output line to each of (n-1) data lines; and (n-1) switches connecting the second data output line to each of remaining (n-1) data lines; and a control circuit which outputs (2n-2) control signals for controlling each of the switches, wherein an ith control signal has a same phase as a phase of an (n+i)th control signal where i is a natural number satisfying 1 ≤ i ≤ n-1.

Embodiments may provide a display apparatus comprising: a first data line, a second data line, a third data line, and a fourth data line, which are respectively connected to sub-pixels; data output lines connected to a data driving unit which outputs a data signal; a first switch transistor, a second switch transistor, a third switch transistor, and a fourth switch transistor, which are respectively connected to the first to fourth data lines, each of the first to fourth switch transistors comprising: a semiconductor layer; a first gate line and a second gate line, which are disposed on the semiconductor layer; a first electrode and a second electrode, which are disposed on the first gate line and the second gate line; and a third electrode disposed between the first electrode and the second electrode; and a first control signal line, a second control signal line, a third control signal line, and a fourth control signal line, which are, in a plan view, arranged between the data output lines and the first to fourth switch transistors and extend in a first direction, wherein the first gate line and the second gate line extend in a second direction crossing the first direction, and the first electrode and the second electrode extend in the second direction, and are respectively connected to opposite ends of the semiconductor layer.

Embodiments may provide a display apparatus comprising: a pixel unit comprising a first data line, a second data line, a third data line, and a fourth data line; a data driving unit arranged to output a data signal through data output lines; a data distribution unit arranged to connect a first data output line among the data output lines to the second data line and a second data output line among the data output lines to the fourth data line, the data distribution unit comprising: a first switch arranged to connect the first data output line to the first data line according to a first control signal; and a second switch arranged to connect the second data output line to the third data line according to a second control signal; and a control circuit comprising: a first power circuit arranged to output the first control signal; and a second power circuit arranged to output the second control signal, wherein the first control signal has a same phase as a phase of the second control signal.

Embodiments may provide a display apparatus comprising: a first data line, a second data line, a third data line, and a fourth data line, which are respectively connected to sub-pixels; a first data output line connecting a data driving unit, and the first data line and the second data line; a second data output line connecting the data driving unit, and the third data line and the fourth data line; a first switch transistor connected between the first data line and the first data output line and a second switch transistor connected between the third data line and the second data output line, each of the first switch transistor and the second switch transistor comprising: a semiconductor layer; a first gate line and a second gate line, which are disposed on the semiconductor layer; a first electrode and a second electrode, which are disposed on the first gate line and the second gate line, and are respectively connected to opposite ends of the semiconductor layer; and a third electrode disposed between the first electrode and the second electrode; and a first control signal line and a second control signal line, which are, in a plan view, arranged between the first data output line and the first switch transistor, and between the second data output line and the second switch transistor, and extend in a first direction, wherein the first gate line and the second gate line extend in a second direction crossing the first direction.

Embodiments may provide a display apparatus comprising: a pixel unit comprising 2N data lines, N being a natural number satisfying 2≤N; a data driving unit which outputs a data signal through a first data output line and a second data output line; a data distribution unit which connects the first data output line to an N^{th} data line from among the 2N data lines, and connects the second data output line to a (2N)^{th} data line from among the 2N data lines, the data distribution unit comprising: (N-1) switches connecting the first data output line to each of (N-1) data lines; and (N-1) switches connecting the second data output line to each of remaining (N-1) data lines; and a control circuit which outputs (2N-2) control signals for controlling each of the switches, wherein an i^{th} control signal has a same phase as a phase of an (N+i)^{th} control signal where i is a natural number satisfying 1 ≤ i ≤ n-1.

According to embodiments configured as described above, the number of data output lines in a data driving unit may be reduced, thereby reducing a manufacturing cost of the display apparatus. In addition, according to embodiments, a slew rate of the control signals may be improved, allowing the display apparatus to implement high-quality images. However, the scope of embodiments is not limited by these effects.

It should be understood that embodiments described herein should be considered in a descriptive sense only and not for purposes of limitation. Descriptions of features or advantages within each embodiment should typically be considered as available for other similar features or advantages in other embodiments. While embodiments have been described with reference to the drawing figures, it will be understood by those of ordinary skill in the art that various changes in form and details may be made therein without departing from the scope as defined by the following claims.

## Claims

1. A display apparatus comprising:
a pixel unit comprising a first data line, a second data line, a third data line, and a fourth data line;
a data driving unit arranged to output a data signal through data output lines;
a data distribution unit comprising:
a first switch arranged to connect a first data output line from among the data output lines to the first data line according to a first control signal;
a second switch arranged to connect the first data output line to the second data line according to a second control signal;
a third switch arranged to connect a second data output line from among the data output lines to the third data line according to a third control signal; and
a fourth switch arranged to connect the second data output line to the fourth data line according to a fourth control signal; and
a control circuit comprising:
a first power circuit arranged to output the first control signal;
a second power circuit arranged to output the second control signal;
a third power circuit arranged to output the third control signal; and
a fourth power circuit arranged to output the fourth control signal,
wherein the first control signal has a same phase as a phase of the third control signal, and
the second control signal has a same phase as a phase of the fourth control signal.

2. The display apparatus of claim 1, wherein the second data line and the first data line are spaced apart from each other with two columns interposed therebetween, and the fourth data line and the third data line are spaced apart from each other with two columns interposed therebetween.

3. The display apparatus of claim 1 or 2, further comprising:
a first control signal line connecting the first switch and the first power circuit to each other;
a second control signal line connecting the second switch and the second power circuit to each other;
a third control signal line connecting the third switch and the third power circuit to each other; and
a fourth control signal line connecting the fourth switch and the fourth power circuit to each other;
optionally further comprising: a first power output line connecting the first power circuit and the first control signal line to each other; a second power output line connecting the second power circuit and the second control signal line to each other; a third power output line connecting the third power circuit and the third control signal line to each other; and a fourth power output line connecting the fourth power circuit and the fourth control signal line to each other.

4. The display apparatus of claim 3, further comprising:
a first bridge line connecting the first power circuit and the first control signal line to each other;
a second bridge line connecting the second power circuit and the second control signal line to each other;
a third bridge line connecting the third power circuit and the third control signal line to each other; and
a fourth bridge line connecting the fourth power circuit and the fourth control signal line to each other.

5. The display apparatus of claim 4, further comprising:
a first power output line connecting the first power circuit and the first bridge line to each other;
a second power output line connecting the second power circuit and the second bridge line to each other;
a third power output line connecting the third power circuit and the third bridge line to each other; and
a fourth power output line connecting the fourth power circuit and the fourth bridge line to each other.

6. The display apparatus of claim 5, further comprising:
first bridge connection lines connecting the first bridge line and the first control signal line to each other;
second bridge connection lines connecting the second bridge line and the second control signal line to each other;
third bridge connection lines connecting the third bridge line and the third control signal line to each other; and
fourth bridge connection lines connecting the fourth bridge line and the fourth control signal line;
optionally wherein a number of each of the first to fourth bridge connection lines is greater than a number of each of the first to fourth power output lines;
optionally wherein each of the first to fourth control signal lines and the first to fourth bridge lines extends in a first direction, and each of the first to fourth bridge connection lines extends in a second direction crossing the first direction.

7. The display apparatus of any one of claims 1 to 6, wherein the pixel unit comprises a first pixel, a second pixel, a third pixel, and a fourth pixel, which are arranged in a same row,
the first data line is connected to one of sub-pixels of the first pixel and the second data line is connected to one of sub-pixels of the second pixel, and
the third data line is connected to one of sub-pixels of the third pixel and the fourth data line is connected to one of sub-pixels of the fourth pixel;
optionally wherein the one of the sub-pixels of the first pixel, connected to the first data line, and the one of the sub-pixels of the second pixel, connected to the second data line, emit light of a same color, and the one of the sub-pixels of the third pixel, connected to the third data line, and the one of the sub-pixels of the fourth pixel, connected to the fourth data line, emit light of a same color.

8. The display apparatus of claim 7, wherein the pixel unit further comprises a fifth data line between the first data line and the second data line, a sixth data line between the second data line and the third data line, a seventh data line between the third data line and the fourth data line, and an eighth data line, and
the data distribution unit further comprises a fifth switch, a sixth switch, a seventh switch, and an eighth switch, wherein the fifth switch connects a third data output line from among the data output lines to the fifth data line according to the first control signal, the sixth switch connects the third data output line to the sixth data line according to the second control signal, the seventh switch connects a fourth data output line from among the data output lines to the seventh data line according to the third control signal, and the eighth switch connects the fourth data output line to the eighth data line according to the fourth control signal;
optionally wherein the first switch and the fifth switch are connected to the first power circuit through a first control signal line, the second switch and the sixth switch are connected to the second power circuit through a second control signal line, the third switch and the seventh switch are connected to the third power circuit through a third control signal line, and the fourth switch and the eighth switch are connected to the fourth power circuit through a fourth control signal line.

9. A display apparatus comprising:
a pixel unit comprising a first data line, a second data line, a third data line, and a fourth data line;
a data driving unit arranged to output a data signal through data output lines;
a data distribution unit arranged to connect a first data output line among the data output lines to the second data line and a second data output line among the data output lines to the fourth data line, the data distribution unit comprising:
a first switch arranged to connect the first data output line to the first data line according to a first control signal; and
a second switch arranged to connect the second data output line to the third data line according to a second control signal; and
a control circuit comprising:
a first power circuit arranged to output the first control signal; and
a second power circuit arranged to output the second control signal,
wherein the first control signal has a same phase as a phase of the second control signal.

10. The display apparatus of claim 9, wherein the second data line and the first data line are arranged apart from each other with two columns interposed therebetween, and the fourth data line and the third data line are arranged apart from each other with two columns interposed therebetween.

11. The display apparatus of claim 9 or 10, further comprising:
a first control signal line connecting the first switch and the first power circuit to each other; and
a second control signal line connecting the second switch and the second power circuit to each other;
optionally further comprising: a first power output line connecting the first power circuit and the first control signal line to each other; and a second power output line connecting the second power circuit and the second control signal line to each other.

12. The display apparatus of claim 11, further comprising:
a first bridge line connecting the first power circuit and the first control signal line to each other; and
a second bridge line connecting the second power circuit and the second control signal line to each other.

13. The display apparatus of claim 12, further comprising:
a first power output line connecting the first power circuit and the first bridge line to each other; and
a second power output line connecting the second power circuit and the second bridge line to each other.

14. The display apparatus of claim 13, further comprising:
first bridge connection lines connecting the first bridge line and the first control signal line to each other; and
second bridge connection lines connecting the second bridge line and the second control signal line to each other;
optionally wherein a number of the first bridge connection lines is greater than a number of the first power output line, and a number of the second bridge connection lines is greater than a number of the second power output line;
optionally wherein the first control signal line, the second control signal line, the first bridge line, and the second bridge line extend in a first direction, and the first bridge connection lines and the second bridge connection lines extend in a second direction crossing the first direction.

15. The display apparatus of any one of claims 9 to 14, wherein the pixel unit further comprises a first pixel, a second pixel, a third pixel, and a fourth pixel, which are arranged in a same row,
the first data line is connected to one of sub-pixels of the first pixel and the second data line is connected to one of sub-pixels of the second pixel, and
the third data line is connected to one of sub-pixels of the third pixel and the fourth data line is connected to one of sub-pixels of the fourth pixel;
optionally wherein the one of the sub-pixels of the first pixel, connected to the first data line, and the one of the sub-pixels of the second pixel, connected to the second data line, emit light of a same color, and the one of sub-pixels of the third pixel, connected to the third data line, and the one of the sub-pixels of the fourth pixel, connected to the fourth data line, emit light of a same color.
